# EUROPÄISCHE PATENTSCHRIFT

(11) **EP 1 675 930 B1**
(45) Veröffentlichungstag und Bekanntmachung des Hinweises auf die Patenterteilung: **30.05.2018**
(21) Anmeldenummer: 04790695.3
(22) Anmeldetag: 21.10.2004
(51) Int. Cl.: C09K 11/06, H01L 51/30, C07F 15/00, H05B 33/14, C08G 61/00, C08L 65/00

(54) **NEUE MATERIALIEN FÜR DIE ELEKTROLUMINESZENZ UND DEREN VERWENDUNG**
NEW MATERIALS FOR ELECTROLUMINESCENCE AND THE UTILIZATION THEREOF
NOUVEAUX MATERIAUX POUR L'ELECTROLUMINESCENCE ET LEUR UTILISATION

(30) Priorität: 22.10.2003 DE 10349033; 20.01.2004 DE 102004003008
(43) Veröffentlichungstag der Anmeldung: 05.07.2006
(60) Teilanmeldung: 10015929.2
(73) Patentinhaber: Merck Patent GmbH, 64293 Darmstadt (DE)
(72) Erfinder: HEUN, Susanne, 65812 Bad Soden (DE); SCHEURICH, René, 64846 Gross-Zimmern (DE); BÜSING, Arne, 65929 Frankfurt (DE); LUDERMANN, Aurelie, 60322 Frankfurt (DE); GERHARD, Anja, 97209 Veitshöchheim (DE); STÖSSEL, Philipp, 60487 Frankfurt (DE); VESTWEBER, Horst, 34830 Gilserberg-Winterscheid (DE)
(86) Internationale Anmeldenummer: PCT/EP2004/011888
(87) Internationale Veröffentlichungsnummer: WO 2005/040302

(56) Entgegenhaltungen:
- WO-A1-02/077060
- WO-A2-03/020790
- US-A1- 2002 028 347
- V. CLEAVE ET.AL.: "Harvesting singlet and triplet energy in polymer LEDs" ADV. MATER., Bd. 11, Nr. 4, 1999, Seiten 285-288, XP002316107

## Beschreibung

Die vorliegende Erfindung beschreibt neue Materialien und Materialmischungen für die Verwendung in organischen elektronischen Bauteilen und deren Verwendung in darauf basierenden Displays.

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in WO 90/13148 offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6). Aus theoretischen Überlegungen ist unter Verwendung solcher Triplett-Emitter eine bis zu vierfache Energie- und Leistungseffizienz möglich. Ob sich diese Entwicklung allerdings durchsetzen wird, hängt stark davon ab, ob entsprechende Device-Kompositionen gefunden werden können, die diese Vorteile auch in OLEDs umsetzen können. Als wesentliche Bedingungen für die praktische Anwendbarkeit sind hier insbesondere ein effizienter Energieübertrag auf den Triplett-Emitter (und damit verbunden effiziente Lichtemission), eine hohe operative Lebensdauer und eine niedrige Einsatz- und Betriebsspannung zu nennen. Um dies zu erreichen, sind außer den Eigenschaften des Triplett-Emitters auch die Eigenschaften des Matrixmaterials von herausragender Bedeutung. Während hierfür lange Zeit vor allem Carbazolverbindungen in Betracht gezogen wurden und erste gute Ergebnisse zeigten, wurden vor kurzem mit neuen Matrixmaterialien, basierend auf Keto- und Iminverbindungen (DE 10317556 A1) oder auf Phosphinoxiden, Sulfonen und Sulfoxiden (DE 10330761 A1), hervorragende Ergebnisse sowohl in Bezug auf die Effizienz, wie auch auf die Lebensdauer der Devices erzielt.

In letzter Zeit gibt es zunehmend Bemühungen, sich die oben genannten Vorteile aufdampfbarer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen des Triplett-Emitters in das Polymer entstehen. Andererseits kann der Triplett-Emitter auch kovalent an das Polymer gebunden werden. Beide Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (z. B. mit Hilfe hochauflösender Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie. Auch hier ist ein geeignetes Matrixmaterial notwendig, das einen effizienten Energietransfer auf den Triplett-Emitter ermöglicht und das in Verbindung mit diesem gute Lebensdauern bei niedrigen Betriebsspannungen aufweist.

In der US 2002/0028347 A1 werden photolumineszierende und elektrolumineszierende Zusammensetzungen offenbart, die eine Matrix, welche aromatische Wiederholungseinheiten aufweist, und ein lumineszierendes Metallion oder einen lumineszierenden Metallionen-Komplex enthält.

In WO 04/070772 sind Blends und Copolymere von Triplett-Emittern mit bestimmten Carbazol-haltigen konjugierten Polymeren beschrieben, die in effizienter Emission und reduzierter Betriebsspannung resultieren. Eine weitere Verbesserung wurde durch die Einführung bestimmter überbrückter Carbazol-Einheiten erreicht, wie in DE 10328627 A1 beschrieben.

Trotz der in den o. g. Publikationen und Anmeldeschriften zitierten Fortschritte gibt es jedoch immer noch erhebliches Verbessungspotenzial für entsprechende Materialien auf dem Gebiet der aus Lösung verarbeitbaren Triplett-Emitter. U. a. auf folgenden Feldern ist weiterhin ein deutlicher Verbesserungsbedarf zu sehen:
(1) Die Effizienz der Elektrolumineszenzelemente muss gegenüber dem Stand der Technik weiter deutlich erhöht werden, um sie auf das Niveau der durch Aufdampfen erhaltenen Devices zu bringen.
(2) Die Lebensdauer der Elektrolumineszenzelemente ist gegenüber dem Stand der Technik deutlich zu erhöhen.
(3) Die Löslichkeit der Polymere und Blends mit den oben beschriebenen überbrückten Carbazol-Einheiten, die den nächstliegenden Stand der Technik darstellen, ist noch nicht immer zufriedenstellend. So ist es beispielsweise nicht möglich, einen hohen Anteil der dort beschriebenen überbrückten Carbazol-Einheiten einzupolymerisieren, da dies zu unlöslichen Polymeren führt. Für die Anwendung sind jedoch lösliche Polymere nötig.
(4) Die oben beschriebenen Carbazol-Einheiten zeigen zwar in der Anwendung schon recht gute Ergebnisse. Ein weiterer Nachteil dieser Einheiten, außer der eingeschränkten Löslichkeit, ist jedoch der teilweise sehr aufwändige chemische Zugang zu diesen Verbindungen. Hier wäre es wünschenswert, Verbindungen und Monomere zur Verfügung zu haben, deren Device-Eigenschaften vergleichbar oder besser sind, die aber leichter synthetisch zugänglich sind.
(5) Die Polymere und Mischungen gemäß dem Stand der Technik zeigen eine hohe Sauerstoffempfindlichkeit. So lassen sie sich nur unter sorgfältigem Ausschluss von Sauerstoff verarbeiten. Hier wären weniger empfindliche Substanzen deutlich von Vorteil.

Es ist also offensichtlich, dass hier weiterhin großer Verbesserungsbedarf besteht.

Überraschend wurde gefunden, dass Polymere und Mischungen, die bestimmte Struktureinheiten enthalten, in Kombination mit Triplett-Emittern hier deutliche Verbesserungen im Vergleich zu Mischungen oder Polymeren gemäß dem Stand der Technik ergeben. Diese Polymere und Mischungen sind durch Standardreaktionen leicht chemisch zugänglich oder teilweise sogar kommerziell erhältlich und führen im Allgemeinen zu gut löslichen Polymeren. Außerdem zeigen sie eine geringere Sauerstoffempfindlichkeit, was ihre Herstellung und Verarbeitung deutlich erleichtert. Sie sind daher Gegenstand der vorliegenden Anmeldung.

In WO 03/099901 gibt es eine zufällige Offenbarung eines an sich erfindungsgemäßen Copolymers aus einem Polymergrundgerüst, das Estergruppen (oder auch Carbonyl-, Sulfon-, Sulfoxid- oder Phosphinoxidgruppen) enthält, und einpolymerisierten Iridium- und Platin-Komplexen. Die Kombination solcher Polymergrundgerüste mit Triplett-Emittern sind demzufolge von der Erfindung ausgenommen.

In US 03/022908 und US 03/224208 gibt es eine zufällige Offenbarungen eines an sich erfindungsgemäßen Blends aus einem Polymer, das kovalent gebundene Triplett-Emitter enthält, und einem Ladungstransportpolymer, wobei zwei der aufgezeigten Ladungstransportpolymere (auf Basis von Triarylaminen) zusätzlich Keto- bzw. Sulfongruppen tragen. Besondere Vorteile dieser Kombination sind nicht aufgeführt. Diese Blends sind von der Erfindung ausgenommen.

Gegenstand der Erfindung sind organische Halbleiter, enthaltend
(A) mindestens ein konjugiertes, teilkonjugiertes oder gekreuzt-konjugiertes Polymer,
(B) mindestens eine Struktureinheit L=X, wobei für die verwendeten Symbole gilt:
   - L: ist bei jedem Auftreten gleich oder verschieden (R¹)(R²)C, (R¹)P, (R¹)As, (R¹)Sb, (R¹)Bi, (R¹)(R²)(R³)P, (R¹)(R²)(R³)As, (R¹)(R²)(R³)Sb, (R¹)(R²)(R³)Bi, (R¹)(R²)S, (R¹)(R²)Se, (R¹)(R²)Te, (R¹)(R²)S(=O), (R¹)(R²)Se(=O) oder (R¹)(R²)Te(=O);
   - X: ist bei jedem Auftreten gleich oder verschieden O, S, Se oder N-R⁴, mit der Maßgabe, dass X nicht S oder Se ist, wenn L für S, Se oder Te steht;
   - R¹, R², R³: ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁵ substituiert oder auch unsubstituiert sein kann, wobei eine oder mehrere nicht benachbarte CH₂-Gruppen durch -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- oder -CONR⁶- ersetzt sein können und wobei ein oder mehrere H-Atome durch F, Cl, Br, I, CN oder NO₂ ersetzt sein können, oder ein aromatisches oder heteroaromatisches Ringsystem mit 1 bis 40 C-Atomen, das durch einen oder mehrere Reste R⁵ substituiert sein kann, wobei zwei oder mehrere Substituenten R¹, R² und/oder R³ auch miteinander ein mono- oder polycyclisches, aliphatisches oder aromatisches Ringsystem bilden können; dabei dürfen nicht alle Substituenten R¹ bis R³ an einer Struktureinheit H oder F sein; die Gruppen R¹ bis R³ können weiterhin gegebenenfalls Bindungen zum Polymer aufweisen;
   - R⁴: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -R⁶C=CR⁶-, -C≡C-, Si(R⁶)₂, Ge(R⁶)₂, Sn(R⁶)₂, -NR⁶-, -O-, -S-, -CO-O-, -O-CO-O- ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R⁶ substituiert sein kann, oder OH oder N(R⁵)₂;
   - R⁵: ist bei jedem Auftreten gleich oder verschieden R⁴ oder CN, B(R⁶)₂ oder Si(R⁶)₃.
   - R⁶: ist bei jedem Auftreten gleich oder verschieden H oder ein aliphatischer oder aromatischer Kohlenwasserstoffrest mit 1 bis 20 C-Atomen;
   und
(C) mindestens einen Triplett-Emitter, der ein Ir-Metall enthält;
   mit der Maßgabe, dass Mischungen aus zwei Polymeren ausgenommen sind, in denen das eine Polymer kovalent gebundene Triplett-Emitter enthält und das andere ein Copolymer aus Tetraphenyldiaminobiphenyl-Einheiten und Diphenylsulfonether- bzw. Diphenylketonether-Einheiten ist; und weiterhin mit der Maßgabe, dass Polymere, die einerseits kovalent gebundene Triplett-Emitter und andererseits Einheiten gemäß Formel (a) enthalten, von der Erfindung ausgenommen sind: 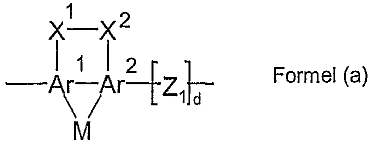
   worin Ar¹ und Ar² jeweils unabhängig eine tetravalente aromatische Kohlenwasserstoffgruppe oder eine tetravalente heterocyclische Gruppe bedeuten; eine der Einheiten X¹ und X² bedeutet C(=O) oder C(R¹)(R²) und die andere bedeutet O, S, C(=O), S(=O), SO₂, Si(R³)(R⁴), N(R⁵), B(R⁶), P(R⁷) oder P(=O)(R⁸); wobei in der Formel (a) die Reste R¹, R², R³, R⁴, R⁵, R⁶, R⁷ und R⁸ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silyigruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten,
   M bedeutet eine Gruppe, die durch Formel (b), Formel (c) oder Formel (d) dargestellt wird.

   -Y¹-Y²- Formel (b)

   worin Y¹ und Y² jeweils unabhängig O, S, C(=O), S(=O), SO₂, C(R⁹)(R¹⁰), Si(R¹¹)(R¹²), N(R¹³), B(R¹⁴), P(R¹⁵) oder P(=O)(R¹⁶) bedeuten,
   wobei in der Formel (b) die Reste R⁹, R¹⁰, R¹¹, R¹², R¹³, R¹⁴, R¹⁵ und R¹⁶ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten,
   wobei Y¹ und Y² nicht identisch sind, wenn Y¹ nicht C(R⁹)(R¹⁰) oder Si(R¹¹)(R¹²) ist.]

   -Y³=Y⁴- Formel (c)

   worin Y³ und Y⁴ jeweils unabhängig N, B, P, C(R¹⁷) oder Si(R¹⁸) bedeuten;
   in der Formel (c) die Reste R¹⁷ und R¹⁸ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten;

   -Y⁵- Formel (d)

   worin Y⁵ O, S, C(=O), S(=O), SO₂, C(R¹⁹)(R²⁰), Si(R²¹)(R²²), N(R²³), B(R²⁴), P(R²⁵) oder P(=O)(R²⁶) bedeutet;
   wobei in de Formel (d) die Reste R¹⁹, R²⁰, R²¹, R²², R²³, R²⁴, R²⁵ und R²⁶ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten;
   Z₁ bedeutet -CR³⁶=CR³⁷- oder -C=C-; R³⁶ und R³⁷ bedeuten jeweils unabhängig ein Wasserstoffatom, eine Alkylgruppe, eine Arylgruppe, eine monovalente heterocyclische Gruppe oder eine Cyanogruppe; d bedeutet 0 oder 1.

Das oben und im Folgenden verwendete Symbol "=" steht für eine Doppelbindung im Sinne der Lewis-Schreibweise.

Bevorzugte Struktureinheiten L=X, wie sie oben beschrieben sind, sind also ausgewählt aus den Formeln (1) bis (5), 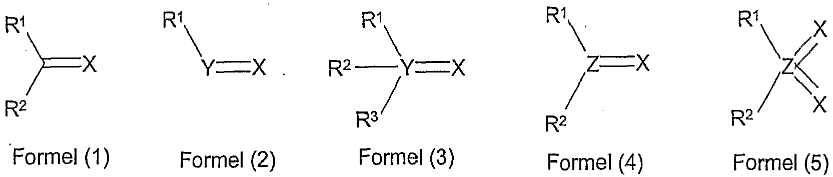 wobei die verwendeten Symbole folgende Bedeutung haben:
- X: ist bei jedem Auftreten gleich oder verschieden O, S, Se oder N-R⁴, mit der Maßgabe, dass X für Formel (4) und (5) nicht S oder Se sein darf;
- Y: ist bei jedem Auftreten gleich oder verschieden P, As, Sb oder Bi;
- Z: ist bei jedem Auftreten gleich oder verschieden S, Se oder Te;
- R¹ bis R⁶: haben dieselbe Bedeutung, wie oben beschrieben.

Die erfindungsgemäßen organischen Halbleiter liegen vorzugsweise als amorphe Verbindungen bzw. amorphe Mischungen vor.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (< 10 % der von H verschiedenen Atome, bevorzugt < 5 % der von H verschiedenen Atome), wie z. B. ein sp³-hybridisiertes C-, N- oder O-Atom, unterbrochen sein können. So sollen also beispielsweise auch Systeme wie 9,9'-Spirobifluoren, 9,9-Diarylfluoren, Triarylamin, etc. als aromatische Ringsysteme im Sinne dieser Anmeldung verstanden werden.

Organische Halbleiter im Sinne dieser Anmeldung sind niedermolekulare, oligomere, dendritische oder polymere, organische oder metallorganische Verbindungen, die als Feststoff bzw. als Schicht halbleitende Eigenschaften aufweisen, d. h. bei denen die Energielücke zwischen Leitungs- und Valenzband zwischen 1.0 und 3.5 eV liegt. Als organischer Halbleiter wird hier entweder eine Reinkomponente oder eine Mischung von zwei oder mehreren Komponenten, von denen mindestens eine halbleitende Eigenschaften aufweisen muss, bezeichnet. Bei der Verwendung von Mischungen ist es jedoch nicht notwendig, dass jede der Komponenten halbleitende Eigenschaften aufweist. So können beispielsweise auch elektronisch inerte Verbindungen, wie z. B. Polystyrol, zusammen mit halbleitenden Verbindungen verwendet werden.

In einer bevorzugten Ausführungsform der Erfindung liegt der organische Halbleiter als eine Mischung vor. In einer weiteren bevorzugten Ausführungsform der Erfindung liegt der organische Halbleiter als ein Copolymer vor.

Unter einem Triplett-Emitter im Sinne der Erfindung soll eine Verbindung verstanden werden, die ein Ir-Metall enthält, die aus dem Triplett-Zustand Licht emittiert, also in der Elektrolumineszenz Phosphoreszenz statt Fluoreszenz zeigt. Diese Verbindung kann prinzipiell niedermolekular, oligomer, dendritisch oder polymer sein.

Bei den erfindungsgemäßen organischen Halbleitern gibt es verschiedene Ausführungsformen, bei denen die Einheiten L=X, bzw. Einheiten gemäß Formel (1) bis (5) und/oder der Triplett-Emitter entweder eingemischt oder kovalent an das Polymer gebunden sind.

Eine Ausführungsform der Erfindung sind Mischungen BLEND1, enthaltend
(A) 5 - 99.9 Gew.% mindestens eines konjugierten, teilkonjugierten oder gekreuzt-konjugierten Polymers POLY1; POLY1 enthält 1 - 100 mol%, bevorzugt 5 - 80 mol%, besonders bevorzugt 10 - 50 mol% einer oder mehrerer Wiederholeinheiten MONO1, wobei MONO1 mindestens eine Struktureinheit L=X, bzw. eine Struktureinheit gemäß Formel (1) bis (5), enthält,
   und außerdem
(B) 0.1 - 95 Gew.%, bevorzugt 0.5 - 80 Gew.%, besonders bevorzugt 1 - 50 Gew.%, insbesondere 2 - 25 Gew.% eines oder mehrerer Triplett-Emitter (TRIP1), der ein Ir-Metall enthält.

Auch wenn dies aus der Beschreibung hervorgeht, sei hier ausdrücklich darauf hingewiesen, dass die Wiederholeinheit MONO1, die Struktureinheiten L=X, bzw. die Struktureinheiten gemäß Formel (1) bis (5) enthält, auch mehr als eine solche Einheit enthalten kann.

In der Ausführungsform BLEND1 ist der Triplett-Emitter (TRIP1) nicht-kovalent zu dem Polymer POLY1 gemischt. Die Wiederholeinheiten MONO1, enthaltend Strukturelemente L=X, bzw. Einheiten gemäß Formel (1) bis (5), sind kovalent an das Polymer gebunden. Dabei kann die Bindung prinzipiell an jeder beliebigen Position stattfinden, d. h. diese Einheiten können über eine oder mehrere Positionen an R¹ bis R³ bzw. gegebenenfalls über R⁴, R⁵ und/oder R⁶ in Formel (1) bis (5) eingebaut werden. Je nach Verknüpfung sind diese Struktureinheiten dann in die Haupt- oder Seitenkette des Polymers eingebaut.

Eine weitere Ausführungsform der Erfindung sind Mischungen BLEND2, enthaltend
(A) 0.5 - 99 Gew.% mindestens eines konjugierten, teilkonjugierten oder gekreuzt-konjugierten Polymers POLY2; POLY2 enthält 0.5 - 100 mol% eines oder mehrerer Triplett-Emitter (TRIP2), der ein Ir-Metall enthält, kovalent gebunden,
   und außerdem
(B) 1 - 99.5 Gew.% mindestens einer Verbindung VERB1, die mindestens eine Struktureinheit L=X, bzw. mindestens eine Struktureinheit gemäß Formel (1) bis (5) enthält und die in der Lage ist, bei Raumtemperatur glasartige Schichten zu bilden, bevorzugt mit einer Glasübergangstemperatur größer 70 °C.

Auch wenn das aus der Beschreibung für BLEND2 hervorgeht, sei hier ausdrücklich darauf hingewiesen, dass die Verbindung VERB1, die Struktureinheiten L=X, bzw. Struktureinheiten gemäß Formel (1) bis (5) enthält, auch mehr als eine dieser Einheiten enthalten kann.

Der Triplett-Emitter TRIP2 kann dabei in die Haupt- und/oder in die Seitenkette des Polymers POLY2 eingebaut werden.

Ein weiterer Aspekt dieser Erfindung sind Mischungen BLEND3, enthaltend
(A) 0.5 - 98.9 Gew.% mindestens eines konjugierten, teilkonjugierten oder gekreuzt-konjugierten Polymers POLY3;
(B) 1 - 99 Gew.% mindestens einer Verbindung VERB1, die mindestens eine Struktureinheit L=X, bzw. mindestens eine Struktureinheit der Formel (1) bis (5) enthält und in der Lage ist, bei Raumtemperatur glasartige Schichten zu bilden, bevorzugt mit einer Glasübergangstemperatur größer 70 °C;
   und außerdem
(C) 0.1 - 95 Gew.%, bevorzugt 0.5 - 80 Gew.%, besonders bevorzugt 1 - 50 Gew.%, insbesondere 2 - 25 Gew.% eines oder mehrerer Triplett-Emitter (TRIP1), der ein Ir-Metall enthält.

Ein weiterer Aspekt dieser Erfindung sind Mischungen BLEND4, enthaltend
(A) 0.5 - 99 Gew.% mindestens eines konjugierten, teilkonjugierten oder gekreuzt-konjugierten Polymers POLY3;
   und außerdem
(B) 1 - 99.5 Gew.% einer Verbindung TRIP3; TRIP3 enthält mindestens eine Struktureinheit L=X, bzw. Einheiten der Formel (1) bis (5) kovalent an einen oder mehrere Triplett-Emitter, der ein Ir-Metall enthält, gebunden enthält, wobei mindestens eine Gruppe X frei, d. h. nicht an ein Metallatom koordiniert, vorliegt; dies schließt nicht aus, dass weitere Struktureinheiten L=X, bzw. Struktureinheiten der Formel (1) bis (5) vorhanden sein können, deren Atom X an ein Metallatom koordiniert ist (beispielsweise Acetylacetonat-Liganden, etc.).

Ein weiterer Gegenstand der Erfindung sind konjugierte, teilkonjugierte oder gekreuzt-konjugierte Polymere POLY4, enthaltend
(A) 1 - 99.9 mol%, bevorzugt 5 - 80 mol%, besonders bevorzugt 10 - 50 mol% einer oder mehrerer Wiederholeinheiten MONO1 mit mindestens einer Struktureinheit L=X, wobei die Symbole L, X, R¹, R², R³, R⁴, R⁵ und R⁶ dieselbe Bedeutung besitzen, wie oben beschrieben;
   und
(B) 0.1 - 95 mol%, bevorzugt 0.5 - 50 mol%, besonders bevorzugt 1 - 25 mol% eines oder mehrerer Triplett-Emitter TRIP2, der ein Ir-Metall enthält.

Der Anteil der Triplett-Emitter in BLEND1 bis BLEND4 und POLY4 kann auch deutlich geringer sein als oben angegeben. Ein geringerer Anteil der Triplett-Emitter kann insbesondere zur Erzeugung weißer Emission bevorzugt sein, wie in der nicht offen gelegten Anmeldung DE 10343606.5 beschrieben.

Die Polymere POLY1 bis POLY4 können konjugiert, teilkonjugiert oder gekreuztkonjugiert sein.

Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können und deren Einheiten miteinander in Konjugation stehen. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Einheiten gemäß TRIP2 (Konjugation über das Metallatom), befinden. Teilkonjugierte Polymere im Sinne dieser Erfindung sind Polymere, die entweder in der Hauptkette längere konjugierte Abschnitte enthalten, die durch nicht-konjugierte Abschnitte unterbrochen werden, oder die in den Seitenketten eines in der Hauptkette nicht-konjugierten Polymers längere konjugierte Abschnitte enthalten. Gekreuzt-konjugierte Polymere im Sinne dieser Erfindung sind Polymere, in denen zwei konjugierte Abschnitte nicht miteinander in Konjugation treten, jeder einzelne dieser Abschnitte aber mit einer dritten Einheit konjugiert ist. Dies ist beispielsweise der Fall, wenn zwei konjugierte Abschnitte direkt über eine Ketogruppe, eine Sulfoxidgruppe, eine Sulfongruppe oder eine Phosphinoxidgruppe verknüpft sind, aber beispielsweise auch bei geminaler Verknüpfung zweier konjugierter Abschnitte über eine substituierte oder unsubstituierte Alkengruppe oder bei Verknüpfung zweier konjugierter Abschnitte über beispielsweise eine meta-Phenylengruppe. Hingegen würden Einheiten, wie beispielsweise einfache Alkylenketten, (Thio)Etherbrücken, Ester-, Amid- oder Imidverknüpfungen eindeutig als nicht-konjugierte Segmente definiert.

Die Polymere POLY1 bis POLY4 können außer den Einheiten MON01 (in POLY1 und POLY4) und dem Triplett-Emitter TRIP2 (in POLY2 und POLY4) verschiedene weitere Strukturelemente enthalten. Diese können beispielsweise Struktureinheiten sein, die das Polymergrundgerüst bilden können, oder Struktureinheiten, die die Ladungsinjektions- bzw. Ladungstransporteigenschaften beeinflussen.
Solche Einheiten sind beispielsweise in WO 03/020790 und in DE 10337346 A1 ausführlich beschrieben.

Eine geeignete Verbindungsklasse für gekreuzt-konjugierte Polymere POLY1 bzw. POLY4 sind aromatische Polyketone und aromatische Polysulfone, die jeweils zur besseren Löslichkeit substituiert sein können. Einen Überblick über diese Verbindungsklassen geben P. A. Staniland in "Comprehensive Polymer Science", Ed. G. Allen, Volume 5, Kapitel 29, 483-497 und F. Parodi, ibid., Kapitel 33, 561-591. Ebenso kommen aromatische Polyphosphinoxide in Frage.

Die Polymere POLY1, POLY2 und POLY3 können Homopolymere sein, d. h. sie enthalten dann nur eine einzelne Monomerstruktur, sind aber im Allgemeinen Copolymere. Das Polymer POLY4 ist immer ein Copolymer. Die Copolymere können statistische, alternierende oder auch blockartige Strukturen aufweisen oder auch mehrere dieser Strukturen abwechselnd besitzen. Ebenso können die Polymere linear oder dendritisch aufgebaut sein. Durch das Verwenden mehrerer verschiedener Strukturelemente können Eigenschaften, wie z. B. Löslichkeit, Festphasenmorphologie, etc., eingestellt werden.

Die Polymere POLY1 bis POLY4 werden durch Polymerisation von einem oder mehreren Monomeren hergestellt. Insbesondere für die Synthese konjugierter oder gekreuzt-konjugierter Polymere haben sich hier einige Typen bewährt, die zu C-C-Verknüpfungen (SUZUKI-Kupplung, YAMAMOTO-Kupplung, STILLE-Kupplung) oder zu C-N-Verknüpfungen (HARTWIG-BUCHWALD-Kupplung) führen. Wie die Polymerisation nach diesen Methoden durchgeführt werden kann und wie die Polymere vom Reaktionsmedium abgetrennt und gereinigt werden können, ist beispielsweise in WO 03/048225 und WO 04/022626 beschrieben.
Nach diesen Methoden kann auch die Synthese teilkonjugierter Polymere durchgeführt werden, indem entsprechende Monomere verwendet werden, die nicht durchgängig konjugiert sind. Für teilkonjugierte Polymere kommen aber auch andere Synthesemethoden in Frage, wie sie allgemein aus der Polymerchemie geläufig sind, wie beispielsweise Polykondensationen, die z. B. zu Ester- oder Amidverknüpfungen führen, oder kationische, anionische oder radikalische Polymerisationen, die beispielsweise über
die Reaktion von Alkenen ablaufen und zu Polyethylen-Derivaten im weitesten Sinne führen, die die Chromophore in den Seitenketten gebunden enthalten.

Für bevorzugte Struktureinheiten gemäß Formel (1) bis (5) gilt Folgendes:
- X: steht für O, S oder N-R⁴;
- Y: steht für P oder As;
- Z: steht für S oder Se;
- R¹ bis R⁶: sind wie oben definiert, wobei an jeder Struktureinheit gemäß Formel (1) bis (5) mindestens einer der Substituenten R¹ bis R³ ein aromatisches oder heteroaromatisches Ringsystem mit 1 bis 40 C-Atomen darstellt, das mit einem oder mehreren Substituenten R⁴ substituiert oder unsubstituiert sein kann.

Für besonders bevorzugte Strukturen gemäß Formel (1) bis (5) gilt Folgendes:
- X: steht für O oder N-R⁴; ganz besonders bevorzugt steht X für O;
- Y: steht für P;
- Z: steht für S;
- R¹ bis R⁶: sind wie oben definiert, wobei an jeder Struktureinheit gemäß Formel (1) bis (5) alle Substituenten R¹ bis R³ ein aromatisches oder heteroaromatisches Ringsystem mit 1 bis 40 C-Atomen darstellen, die mit einem oder mehreren Substituenten R⁴ substituiert oder unsubstituiert sein können.

Ganz besonders bevorzugt enthalten die Substituenten R¹ bis R³ aromatische oder heteroaromatische Ringsysteme, bei denen mindestens eine Biphenyl-artige Struktur direkt an die Einheiten gemäß Formel (1) bis (5) gebunden ist, wobei als solche Strukturen auch beispielsweise Fluorene oder Spirobifluorene zählen sollen.

Als bevorzugte Struktureinheiten gemäß Formel (1) bis (5) haben sich solche erwiesen, deren Reste R¹ bis R³ nicht planar aufgebaut sind. Dies ist insbesondere dann der Fall, wenn mindestens einer der Substituenten R¹ bis R³ ein sp³-hybridisiertes Kohlenstoffatom (oder entsprechend auch Silicium, Germanium, Stickstoff, etc.) enthält, das dadurch näherungsweise tetraedrische (oder im Fall von Stickstoff pyramidale) Geometrie aufweist.
Bevorzugte Struktureinheiten sind daher Einheiten gemäß Formel (1) bis Formel (5), in denen mindestens einer der Substituenten R¹ bis R³ mindestens ein sp³-hybridisiertes Kohlenstoffatom enthält.
Um eine deutlichere Abweichung von der Planarität zu erreichen, ist es bevorzugt, wenn dieses sp³-hybridisierte Kohlenstoffatom ein sekundäres, tertiäres oder quartäres Kohlenstoffatom ist, besonders bevorzugt ist ein tertiäres oder quartäres Kohlenstoffatom, ganz besonders bevorzugt ist ein quartäres Kohlenstoffatom. Unter einem sekundären, tertiären oder quartären Kohlenstoffatom wird ein Kohlenstoffatom mit zwei, drei bzw. vier Substituenten ungleich Wasserstoff verstanden.

Besonders bevorzugt sind Struktureinheiten gemäß Formel (1) bis Formel (5), die in mindestens einem der Reste R¹ bis R³ ein 9,9'-Spirobifluorenderivat, ein 9,9-disubstituiertes Fluorenderivat, ein 6,6- und/oder 12,12-di- oder tetrasubstituiertes Indenofluorenderivat, ein Triptycenderivat (bevorzugt verknüpft über die Position 9 und/oder 10) oder ein Tetraarylmethanderivat enthalten. Ganz besonders bevorzugt sind Struktureinheiten gemäß Formel (1) bis (5), die in mindestens einem der Reste R¹ bis R³ ein 9,9'-Spirobifluorenderivat enthalten.

Polymere enthaltend 9,9'-Spirobifluorenderivate und gleichzeitig Struktureinheiten gemäß einer oder mehreren der Formel (1) bis (5) sind neu und daher ebenfalls ein Gegenstand der vorliegenden Erfindung.

Beispiele für besonders bevorzugte Wiederholeinheiten MONO1 bzw. Verbindungen VERB1, die Struktureinheiten gemäß den Formeln (1) bis (5) enthalten, sind substituierte oder unsubstituierte Strukturen gemäß den abgebildeten Formeln (6) bis (148), wobei die gestrichelten Einfachbindungen eine mögliche Verknüpfung im Polymer (MONO1) oder Verknüpfungen zur Molekülverlängerung (VERB1) bedeuten; Ph steht für eine substituierte oder unsubstituierte Phenylgruppe und Alkyl für eine geradkettige, verzweigte oder cyclische Alkylkette, die substituiert oder unsubstituiert sein kann und in der ein oder mehrere H-Atome durch Fluor ersetzt sein können. Diese Strukturelemente gemäß den Formeln (6) bis (148) sind auch bevorzugt Bestandteil der Verbindungen TRIP3, die eine Kombination aus Triplett-Emitter und Einheiten gemäß Formel (1) bis (5) darstellen. Potenzielle Substituenten R⁴ sind wegen der besseren Übersichtlichkeit in der Regel nicht abgebildet:

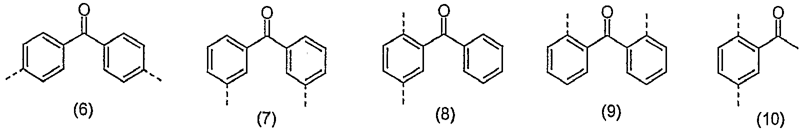

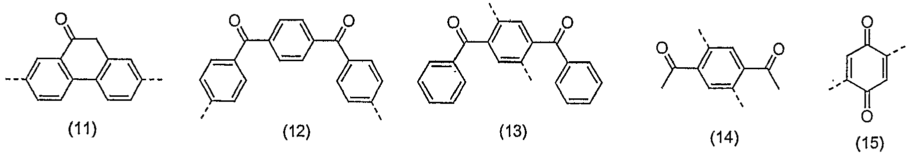

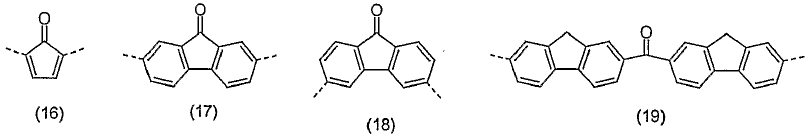

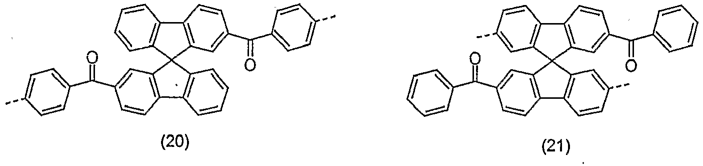

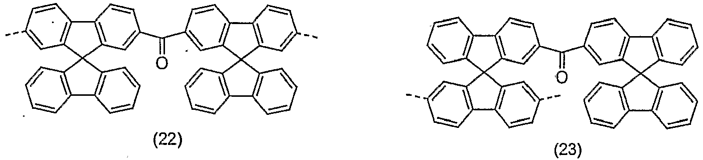

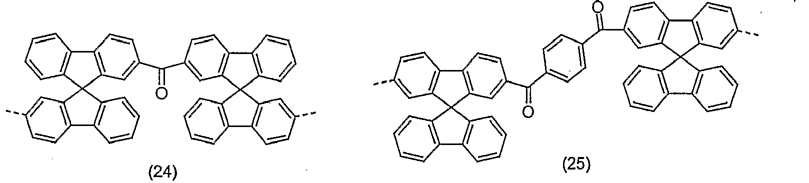

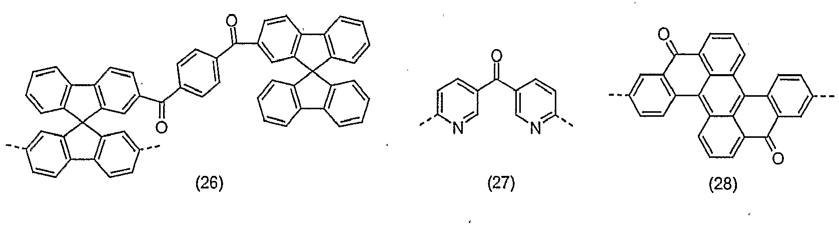

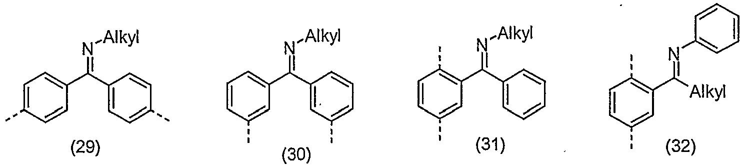

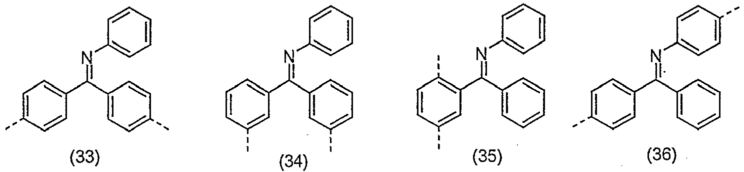

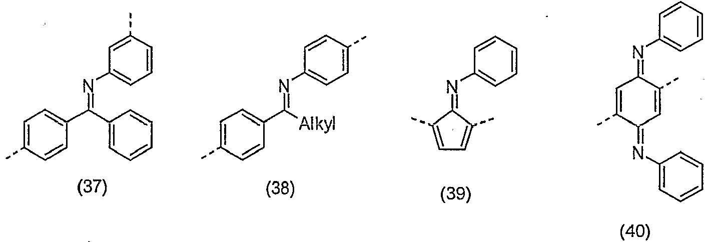

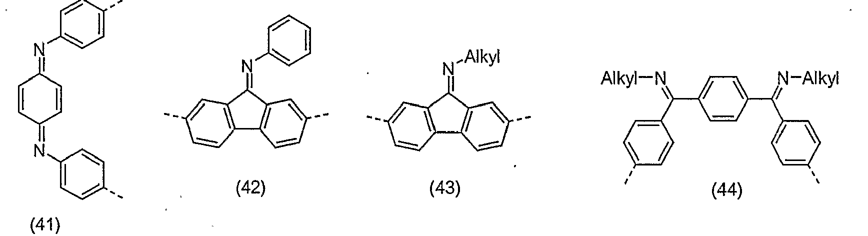

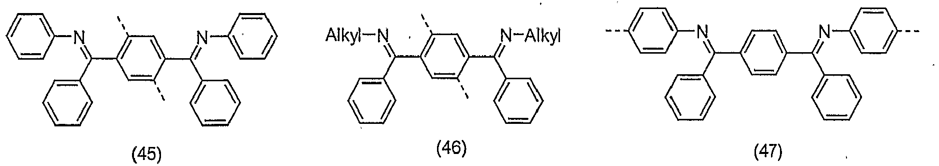

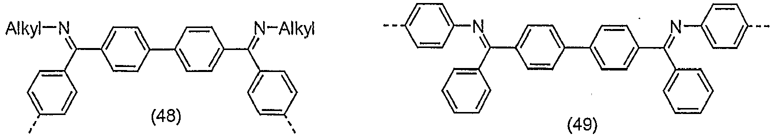

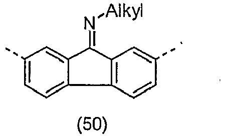

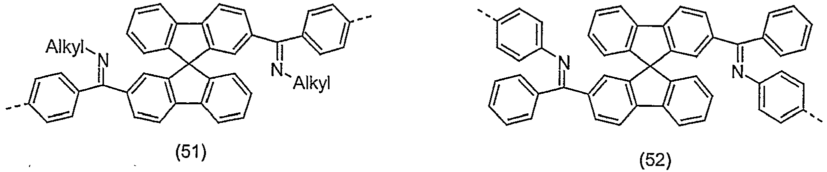

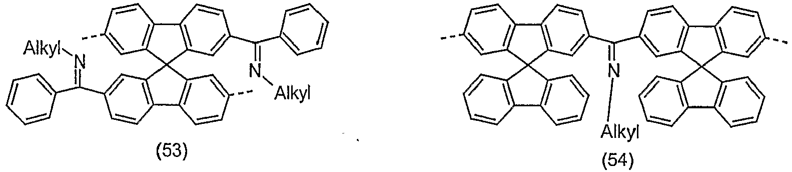

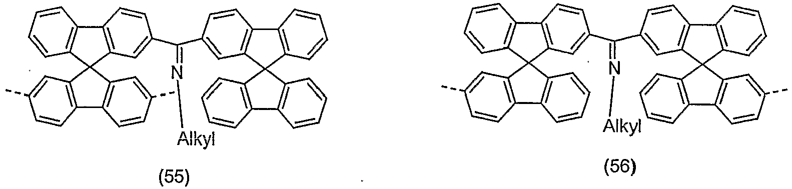

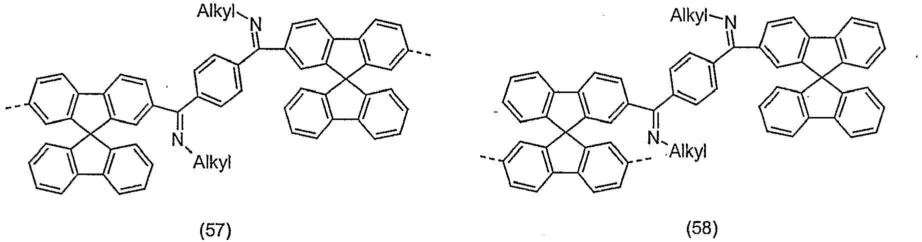

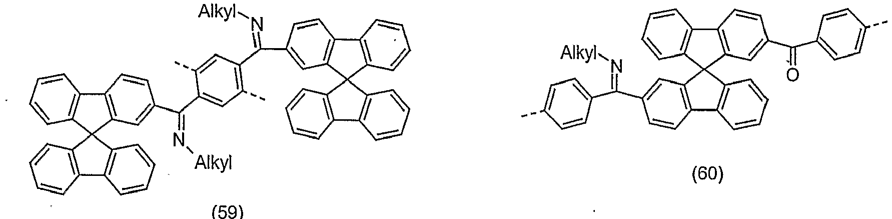

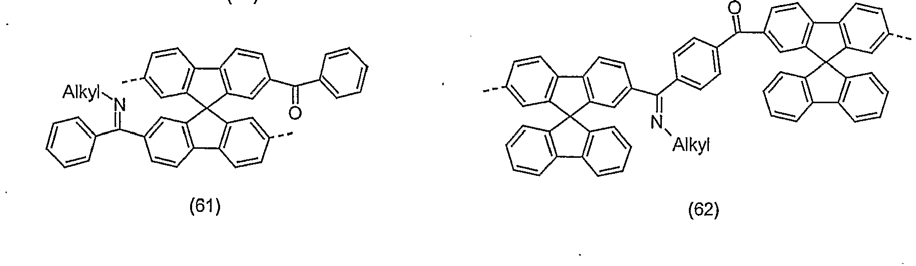

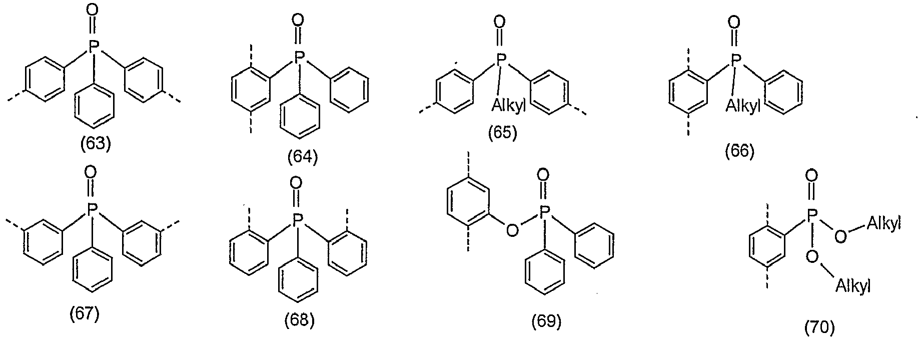

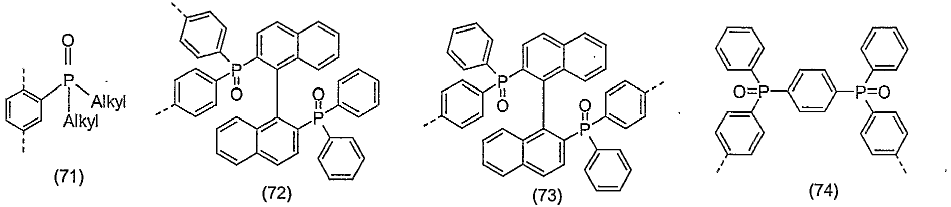

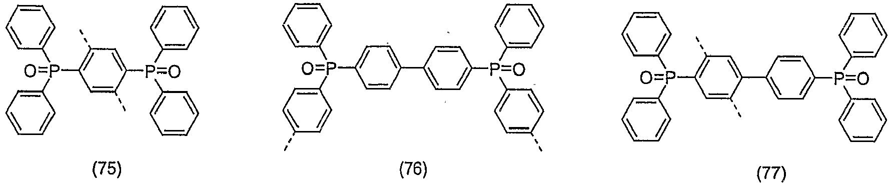

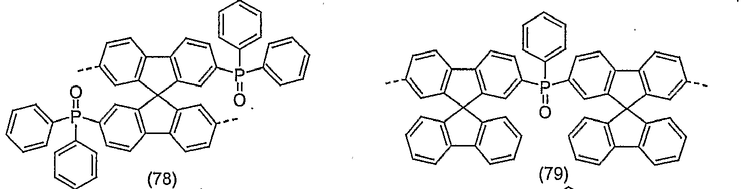

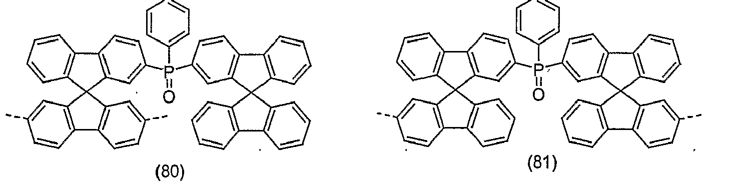

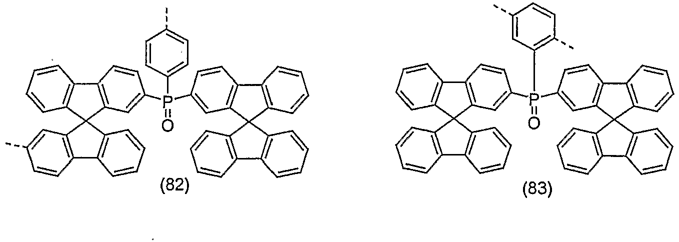

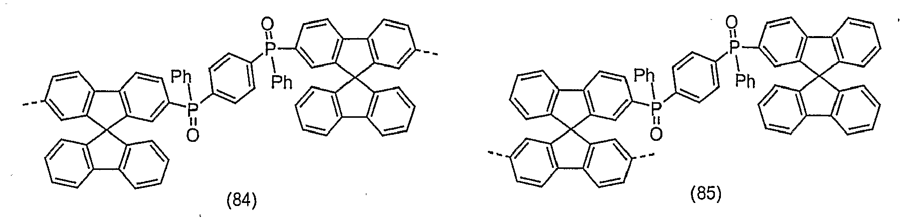

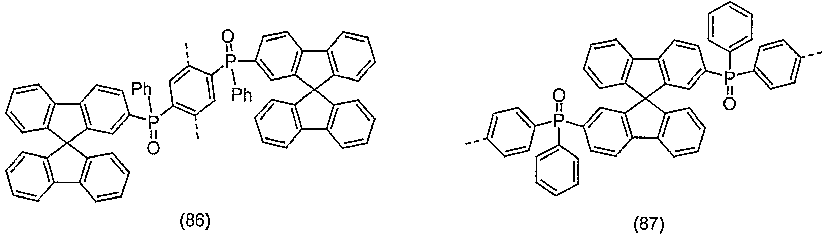

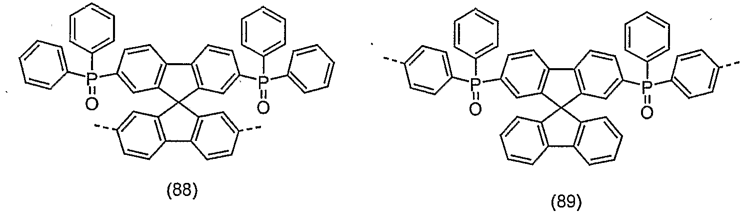

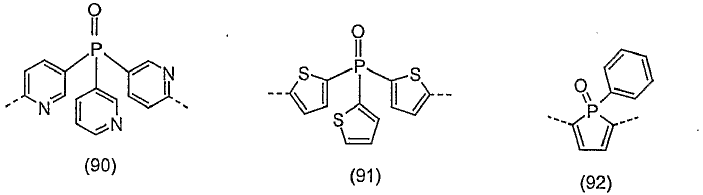

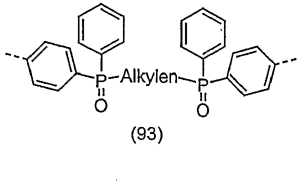

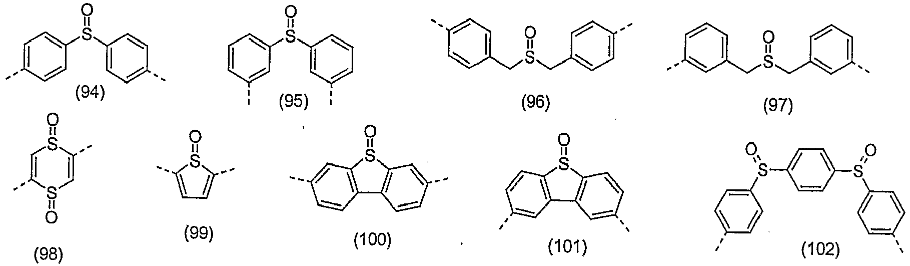

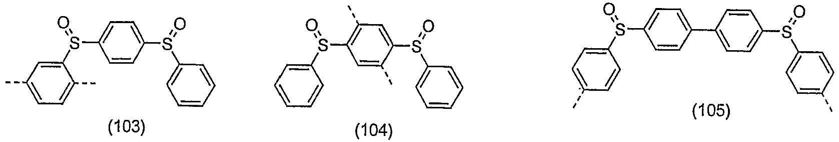

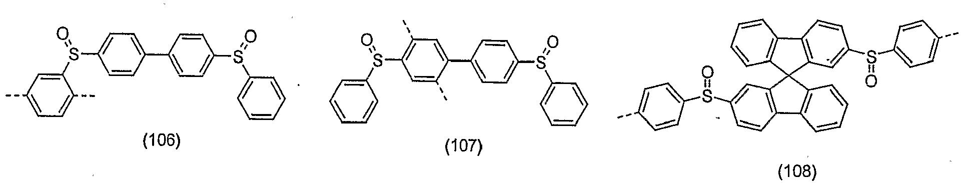

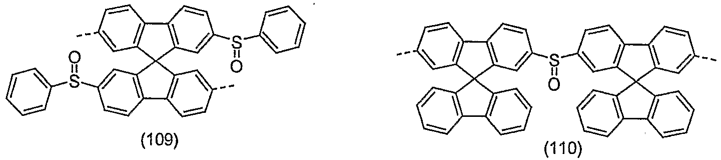

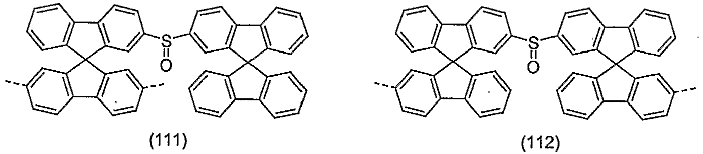

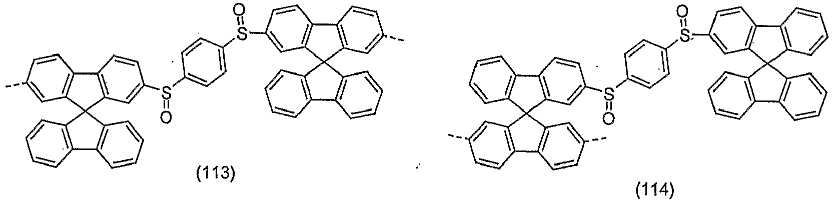

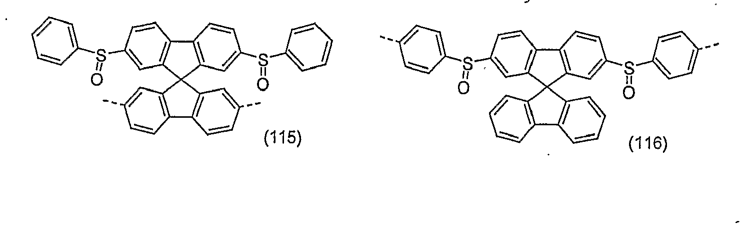

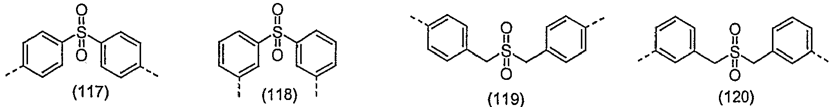

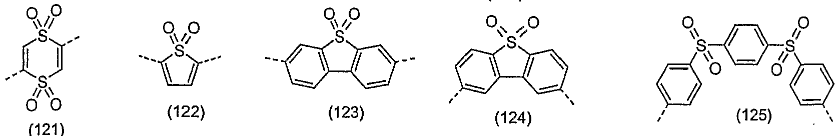

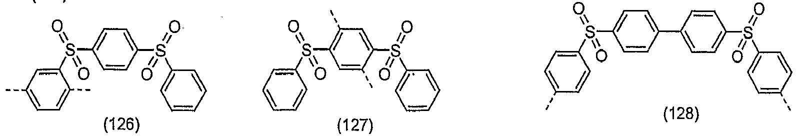

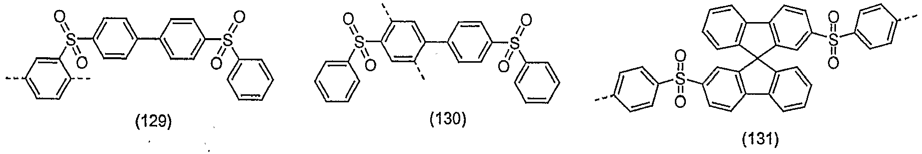

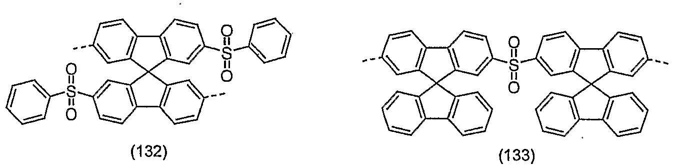

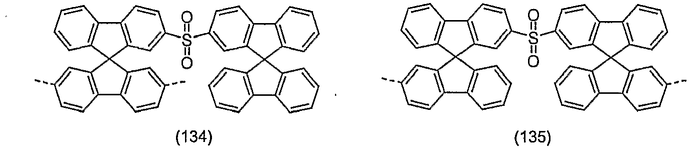

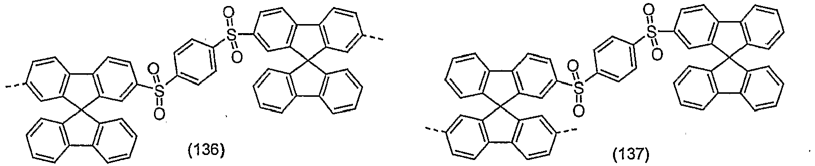

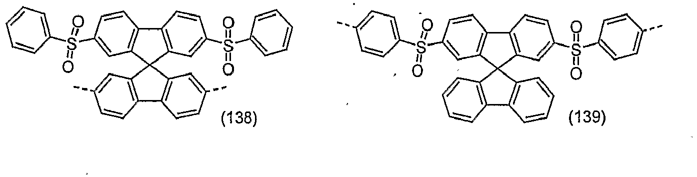

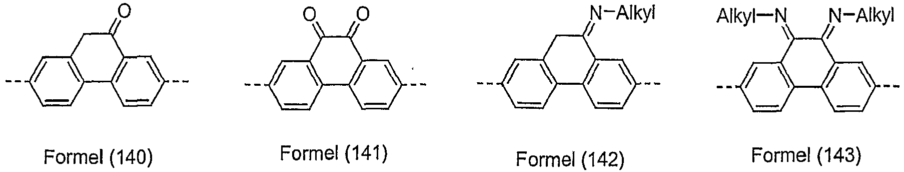

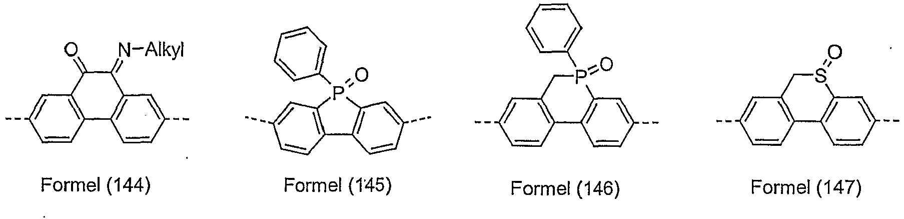

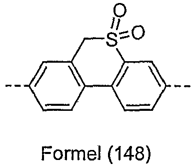

Auch wenn dies aus der Beschreibung hervorgeht, sei hier nochmals explizit darauf verwiesen, dass die Struktureinheiten gemäß den Formeln (6) bis (148) auch unsymmetrisch substituiert sein können, d. h. dass an einer Einheit unterschiedliche Substituenten R⁴ vorhanden sein können, bzw. diese auch an unterschiedliche Positionen gebunden sein können.

Die Wiederholeinheiten MONO1 sind kovalenter-Bestandteil von POLY1 und POLY4. Es hat sich gezeigt, dass ein Anteil im Bereich von 5 - 100 mol% dieser Wiederholeinheiten (bezogen auf alle Wiederholeinheiten im Polymer) hier gute Ergebnisse erzielt. Bevorzugt ist für POLY1 ein Anteil von 5 - 100 mol% Wiederholeinheiten MONO1 Besonders bevorzugt ist ein Anteil von 10 - 80 mol% Wiederholeinheiten MONO1, ganz besonders bevorzugt ist ein Anteil von 10 - 50 mol% Wiederholeinheiten MONO1.

Verbindungen VERB1 sind Mischungs-Bestandteil von BLEND2 und BLEND3. Es hat sich gezeigt, dass ein Anteil im Bereich von 5 - 99 Gew.% dieser Verbindungen in der Mischung hier gute Ergebnisse erzielt. Bevorzugt ist für BLEND2 und BLEND3 also ein Anteil von 5 - 99 Gew.% Verbindungen VERB1. Besonders bevorzugt ist ein Anteil von 10 - 80 Gew.% VERB1, ganz besonders bevorzugt ist ein Anteil von 10 - 50 Gew.% VERB1.

Eine weitere bevorzugte Ausführungsform ist die Mischung BLEND5, die durch Einmischen von Verbindungen VERB1 in BLEND1 entsteht, so dass hier Struktureinheiten L=X, bzw. Einheiten gemäß Formel (1) bis (5) sowohl kovalent an das Polymer gebunden als auch eingemischt vorliegen. Hier hat sich gezeigt, dass ein Gesamtanteil von 5 - 99 mol% Struktureinheiten gemäß diesen Formeln gute Ergebnisse erzielt, unabhängig davon, ob diese Einheiten kovalent an das Polymer gebunden sind oder eingemischt sind. Bevorzugt ist hier also ein Gesamtanteil von 5 - 99 mol% Struktureinheiten L=X, bzw. Einheiten gemäß Formeln (1) bis (5). Besonders bevorzugt ist ein Gesamtanteil von 10 - 80 mol% Struktureinheiten L=X, bzw. Einheiten gemäß Formeln (1) bis (5), ganz besonders bevorzugt ist ein Gesamtanteil von 10 - 50 mol% Struktureinheiten gemäß Formeln (1) bis (5).

Eine weitere bevorzugte Ausführungsform ist die Mischung BLEND6, die durch Einmischen von Verbindungen VERB1 in BLEND4 entsteht, so dass hier Struktureinheiten L=X, bzw. Einheiten gemäß Formel (1) bis (5) sowohl kovalent an den Triplett-Emitter gebunden wie auch eingemischt vorliegen. Auch hier hat sich gezeigt, dass ein Gesamtanteil von 5 - 99 mol% dieser Struktureinheiten gute Ergebnisse erzielt, unabhängig davon, ob diese Einheiten kovalent an den Triplett-Emitter gebunden sind oder eingemischt sind. Bevorzugt ist hier also ein Gesamtanteil von 5 - 99 mol% Struktureinheiten L=X, bzw. Einheiten gemäß Formeln (1) bis (5). Besonders bevorzugt ist ein Gesamtanteil von 10 - 80 mol% Struktureinheiten L=X, bzw. Einheiten gemäß Formeln (1) bis (5), ganz besonders bevorzugt ist ein Gesamtanteil von 10 - 50 mol% Struktureinheiten L=X, bzw. Einheiten gemäß Formeln (1) bis (5).

Eine weitere bevorzugte Ausführungsform ist die Mischung BLEND7, die durch Einmischen von Verbindungen VERB1 und/oder Triplett-Emittern TRIP1 in POLY4 entsteht.

Die in BLEND1 und BLEND3 eingemischten Triplett-Emitter TRIP1, bzw. die in POLY2 (= BLEND2) einpolymerisierten Triplett-Emitter TRIP2, bzw. die in BLEND4 eingemischten Triplett-Emitter TRIP3 können aus beliebigen Triplett-Emittern, die ein Ir-Metall enthalten, ausgewählt werden, die bei Raumtemperatur aus dem Triplett-Zustand Licht emittieren können, also Phosphoreszenz statt Fluoreszenz zeigen. Bevorzugt sind Triplett-Emitter auf Basis tris-ortho-metallierter Ir-Metallkomplexe.

Die Triplett-Emitter TRIP1 bzw. TRIP3 können niedermolekulare, oligomere, dendritische oder polymere Verbindungen sein. Da diese teilweise als Mischungsbestandteil (BLEND1, BLEND3 bzw. BLEND4) verarbeitet werden, muss eine ausreichende Löslichkeit in geeigneten Lösungsmitteln (z. B. Toluol, Xylol, Anisol, THF, Methylanisol, Methylnaphthalin oder Mischungen dieser Lösemittel) gegeben sein, damit die Verarbeitung aus Lösung möglich ist. Als niedermolekulare Struktureinheiten kommen hier verschiedene Komplexe in Frage, welche beispielsweise in den Anmeldeschriften WO 02/068435, WO 02/081488,
EP 1239526 und WO 04/026886 beschrieben sind. Insbesondere die in WO 02/068435 beschriebenen halogenierten Komplexe eignen sich auch als Ausgangsverbindung für TRIP3, da die Halogenfunktionalität eine leichte Derivatisierung der Komplexe mit Struktureinheiten gemäß Formel (1) bis (5) erlaubt. Als Dendrimer-Strukturen kommen für TRIP1 bzw. TRIP3 Komplexe in Frage, wie beispielsweise in WO 99/21935, WO 01/059030 und WO 02/066552 beschrieben.

Der Triplett-Emitter TRIP2 wird kovalent in die Polymerkette von POLY2 (BLEND2) eingebaut. Um den Einbau von TRIP2 in POLY2 zu ermöglichen, müssen an TRIP2 funktionelle polymerisierbare Gruppen vorhanden sein. Beispiele für entsprechende bromierte Komplexe, die als Monomere in Polymerisationsreaktionen, beispielsweise gemäß Suzuki oder gemäß Yamamoto, eingesetzt werden können, werden in WO 02/068435 und in DE 10350606 A1 beschrieben.

Die erfindungsgemäße Mischung BLEND1 wird erhalten, indem dem Polymer POLY1 ein Triplett-Emitter TRIP1 zugemischt werden.
Die erfindungsgemäße Mischung BLEND2 wird erhalten, indem dem Polymer POLY2 Verbindung VERB1, enthaltend Struktureinheiten L=X, bzw. Struktureinheiten gemäß Formel (1) bis (5), zugemischt wird.
Die erfindungsgemäße Mischung BLEND3 wird erhalten, indem dem Polymer POLY3 Verbindung VERB1, enthaltend Struktureinheiten L=X, bzw. Struktureinheiten gemäß Formel (1) bis (5), sowie ein Triplett-Emitter TRIP1 zugemischt werden.
Die erfindungsgemäße Mischung BLEND4 wird erhalten, indem dem Polymer POLY3 Einheiten TRIP3 zugemischt werden.

Es kann außerdem bevorzugt sein, in BLEND1 bis BLEND7 noch weitere konjugierte, teilkonjugierte oder gekreuzt-konjugierte Polymere, Oligomere, Dendrimere oder weitere niedermolekulare Verbindungen einzumischen. Die Zugabe weiterer Komponenten kann sich für manche Anwendungen als sinnvoll erweisen: So kann beispielsweise durch Zugabe einer elektronisch aktiven Substanz die Loch- bzw. Elektroneninjektion, der Loch- bzw. Elektronentransport oder das Ladungsgleichgewicht im entsprechenden Blend reguliert werden. Die Zusatzkomponente kann auch den Singulett-Triplett-Transfer erleichtern. Jedoch auch die Zugabe elektronisch inerter Verbindungen kann hilfreich sein, um beispielsweise die Viskosität einer Lösung oder die Morphologie des gebildeten Films zu kontrollieren. Die so erhaltenen Blends sind ebenfalls Gegenstand der Erfindung.

Die Darstellung von BLEND1 bis BLEND7 erfolgt folgendermaßen: Die Einzelbestandteile des Blends werden in einem geeigneten Mischungsverhältnis zusammengegeben und in einem geeigneten Lösemittel gelöst. Geeignete Lösemittel sind beispielsweise Toluol, Anisol, Xylole, Methylanisol, Methylnaphthalin, Chlorbenzol, cyclische Ether (z. B. Dioxan, THF, Methyldioxan), Amide (z. B. NMP, DMF) oder Mischungen dieser Lösemittel. Alternativ können die Bestandteile des Blends auch einzeln gelöst werden. Die Lösung des Blends erhält man in diesem Fall durch Zusammenfügen der Einzellösungen im geeigneten Mischungsverhältnis. Dabei findet der Lösevorgang bevorzugt in einer inerten Atmosphäre und gegebenenfalls bei erhöhter Temperatur statt. Der Blend wird üblicherweise nicht als Feststoff (durch nochmaliges Ausfällen) isoliert, sondern direkt aus Lösung weiter verarbeitet; jedoch sind auch Blends, die noch einmal ausgefällt wurden, Gegenstand der Erfindung.
Ein geeignetes Verhältnis der einzelnen Komponenten ist beispielsweise eine Mischung, die insgesamt 1 - 99.5 mol%, bevorzugt 5 - 99 mol%, besonders bevorzugt 10 - 80 mol%, insbesondere 10 - 50 mol% Einheiten L=X, bzw. Einheiten gemäß Formel (1) bis (5) (MONO1 in POLY1 bzw. VERB1) enthält und 0.1 - 95 mol%, bevorzugt 0.5 - 80 mol%, besonders bevorzugt 1 - 50 mol%, insbesondere 2 - 25 mol% TRIP1, TRIP2 und TRIP3 enthält, wobei sich die Angaben auf die gesamt vorhandenen Einheiten (Blendbestandteile bzw. Wiederholeinheiten im Polymer) beziehen. Dies ist unabhängig davon, ob die Komponenten kovalent an ein Polymer gebunden sind oder eingemischt sind.

Die erfindungsgemäßen organischen Halbleiter, also die erfindungsgemäßen Mischungen BLEND1 bis BLEND7 und Polymere POLY4, weisen gegenüber dem o. g. Stand der Technik u. a. folgende überraschenden Vorteile auf:
- Die Löslichkeit in organischen Lösemitteln ist im Allgemeinen besser als die Löslichkeit der Polymere und Mischungen gemäß Stand der Technik. Die bessere Löslichkeit bietet einen Vorteil beispielsweise gegenüber überbrückten Carbazol-Einheiten, die als nächstliegender Stand der Technik angeführt werden, da dort häufig der maximale Carbazolanteil durch die schlechte Löslichkeit festgelegt wird, jedoch in manchen Fällen ein höherer Carbazolanteil für die weitere Verbesserung der Device-Eigenschaften wünschenswert wäre.
- Die chemische Zugänglichkeit der Einheiten gemäß Formel (1) bis (5), sowohl als Blendbestandteil wie auch als Monomer, ist unproblematisch. Teilweise sind diese Blendbestandteile und Monomere auch kommerziell erhältlich. Dies ist ein entscheidender Vorteil gegenüber beispielsweise den überbrückten Carbazol-Einheiten (DE 10328627 A1), deren Synthese und Aufreinigung deutlich aufwändiger ist.
- Die erfindungsgemäßen Mischungen und Polymere zeigen eine höhere Sauerstoffstabilität als Mischungen und Polymere gemäß Stand der Technik. Dadurch vereinfacht sich die Herstellung dieser Verbindungen und Mischungen und auch deren Verarbeitung, was einen erheblichen praktischen Vorteil darstellt.
- Die Effizienz der Lichtemission des Triplett-Emitters ist in den erfindungsgemäßen organischen Halbleitern besser im Vergleich zu Polymeren und Mischungen gemäß dem Stand der Technik.
- Die Lebensdauer der erfindungsgemäßen Vorrichtungen ist besser als in Vorrichtungen gemäß dem Stand der Technik.

Die erfindungsgemäßen organischen Halbleiter, also die Mischungen BLEND1 bis BLEND7 bzw. die Polymere POLY4, können in PLEDs verwendet werden, insbesondere als Elektrolumineszenzmaterialien (emittierende Materialien). Für den Bau von PLEDs wird in der Regel ein allgemeines Verfahren verwendet, das entsprechend für den Einzelfall anzupassen ist. Ein solches Verfahren wurde beispielsweise in WO 04/037887 ausführlich beschrieben.

Gegenstand der Erfindung ist daher auch die Verwendung eines erfindungsgemäßen organischen Halbleiters, also einer erfindungsgemäßen Mischung BLEND1 bis BLEND7 bzw. eines erfindungsgemäßen Polymers POLY4, in einer PLED als Elektrolumineszenzmaterial.

Gegenstand der Erfindung ist somit ebenfalls eine PLED mit einer oder mehreren Schichten, wobei mindestens eine dieser Schichten einen oder mehrere erfindungsgemäße organische Halbleiter, also eine oder mehrere erfindungsgemäße Mischungen BLEND1 bis BLEND7 bzw. erfindungsgemäße Polymere POLY4, enthält.

Im vorliegenden Anmeldetext und in den folgenden Beispielen wird auf die Verwendung erfindungsgemäßer organischer Halbleiter, also Mischungen BLEND1 bis BLEND7 bzw. erfindungsgemäßer Polymere POLY4, in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere oder Blends auch für weitere Verwendungen in anderen elektronischen Devices (Vorrichtungen) zu benutzen, z. B. für organische Solarzellen (O-SCs), nicht-lineare Optik oder auch organische Laserdioden (O-Laser), um nur einige Anwendungen zu nennen. Auch diese sind Gegenstand der vorliegenden Erfindung.

Die Erfindung wird durch die nachfolgenden Beispiele näher erläutert, ohne sie dadurch einschränken zu wollen.

### Beispiele

### Beispiel 1: Synthese der Co-Monomere für die Polymere

Die Synthese der Co-Monomere, die für konjugierte Polymere verwendet wurden, ist in WO 02/077060 und der darin zitierten Literatur, sowie in DE 10337346 A1 ausführlich beschrieben. Die im Folgenden verwendeten Monomere **M1** bis **M5** und **M8** seien hier der Übersichtlichkeit halber nochmals abgebildet:

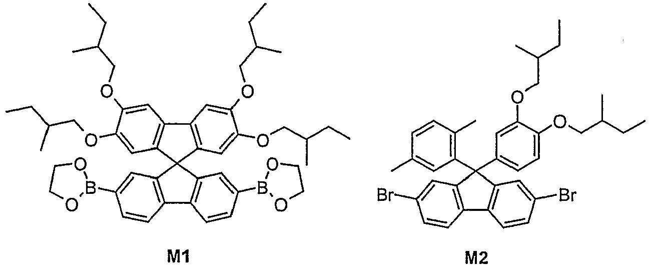

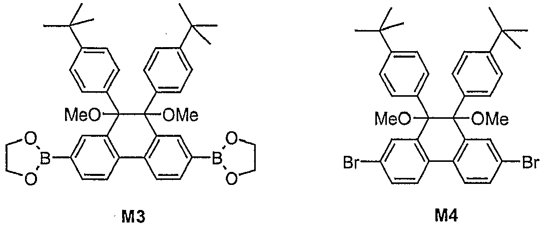

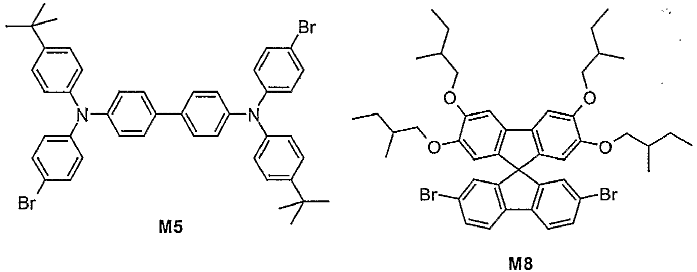

### Beispiel 2: 4,4'-Dibrombenzophenon (Monomer M6 gemäß Formel (1))

4,4'-Dibrombenzophenon wurde von Fluka in einer Reinheit von 98 % erhalten und durch weitere Umkristallisation aus Ethanol bis zu einer Reinheit von 99.7 % (gemäß HPLC) aufgereinigt.

### Beispiel 3: Synthese von Bis(4-bromphenyl)-phenylphosphanoxid (Monomer M7 gemäß Formel (3))

### a) Synthese von Bis(4-bromphenyl)-phenylphosphan

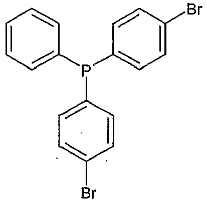

In einem trockenen 1000 mL Vierhalskolben mit Innenthermometer, Rührkern, Argon-Überlagerung und 2 Tropftrichtern wurden 33.9 g (144 mmol) Dibrombenzol in 300 mL trockenem THF gelöst und auf -70 °C gekühlt. Innerhalb 30 min. wurden 90 mL (144 mmol) *n*-Butyllithium (1.6 M in Hexan) zugetropft und 1 h bei dieser Temperatur nachgerührt. Dann wurden bei dieser Temperatur 12.9 g (9.75 ml, 72 mmol) Dichlorphenylphosphan in 60 mL trockenem THF zugetropft. Über Nacht ließ man auf Raumtemperatur kommen. Es wurden 20 mL Methanol zugegeben, und der Ansatz wurde zur Trockene eingedampft. Der Rückstand wurde in Dichlormethan aufgenommen, filtriert und das Lösemittel im Vakuum entfernt. Die Verbindung wurde ohne weitere Aufreinigung für die folgende Umsetzung eingesetzt.

### b) Synthese von Bis(4-bromphenyl)-phenylphosphanoxid (Monomer M7)

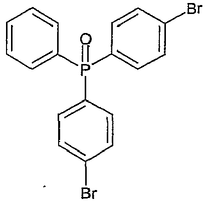

In einem 500 mL Vierhalskolben mit Innenthermometer, mechanischem Rührer, Rückflusskühler und Tropftrichter wurden 10.05 g (24 mmol) Bis(4-bromphenyl)-phenylphosphan in 200 mL Ethylacetat gelöst und auf 5 °C Innentemperatur abgekühlt. Dazu wurde innerhalb 30 min. eine Lösung von 2.25 mL (26.4 mmol) H₂O₂ (35 %ig) in 17.5 mL Wasser getropft und weitere 12 h bei Raumtemperatur gerührt. Anschließend wurden 25 mL gesättigte Natriumsulfit-Lösung zugegeben, die organische Phase abgetrennt, zweimal mit gesättigter Natriumsulfit-Lösung gewaschen und über Natriumsulfat getrocknet. Das Lösungsmittel wurde im Vakuum entfernt. Die Aufreinigung erfolgte zunächst durch Säulenchromatographie auf Silica mit einem Lösemittelgemisch von anfangs Hexan:Ethylacetat 2:1 zu Hexan:Ethylacetat 1:1. Weitere Reinigung erfolgte durch Umkristallisation aus Heptan/Toluol. Es wurden 6.5 g Produkt in einer Reinheit von 99.7 % (gemäß HPLC) erhalten. ¹H-NMR (500 MHz, CDCl₃): [ppm] 7.46 - 7.66 (m). ³¹P-NMR (CDCl₃): [ppm] 28.40.

### Beispiel 4: Synthese von 2,7-Dibrom-9-keto-10-(2-ethylhexyl)-10-methoxy-dihydrophenanthren (Monomer M9 gemäß Formel (1))

### a) Synthese von 2,7-Dibrom-9-keto-10-(2-ethylhexyl)-10-hydroxy-dihydrophenanthren

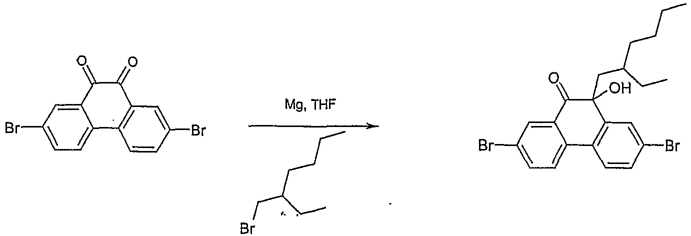

In einem 500 mL-Vierhalskolben mit Rückflusskühler, mechanischem Rührer, Innenthermometer, Argonüberlagerung und Tropftrichter wurden 4.6 g (185 mmol) Magnesium vorgelegt. Die Apparatur wurde ausgeheizt, es wurde ein Körnchen lod zugegeben, dann wurden 37.6 mL (185 mmol) Ethylhexylbromid in 175 mL absolutem THF zugetropft. Es wurde unter Rückfluss erhitzt, bis alles Magnesium verbraucht war. Nach Abkühlen auf Raumtemperatur wurde die Grignardlösung in einen Tropftrichter überführt. In einem 1000 mL-Vierhalskolben mit mechanischem Rührer, Innenthermometer, Rückflusskühler, Tropftrichter und Argonüberlagerung wurden 45 g (123 mmol) Dibromphenanthrenchinon bei 0 °C in 300 mL THF suspendiert. Hierzu wurde die Grignardlösung so zugetropft, dass die Innentemperatur 25 °C nicht überstieg. Anschließend wurde über Nacht bei Raumtemperatur gerührt. Zum Ansatz wurden 200 mL gesättigte NH₄Cl-Lsg. zugegeben. Es wurde Ethylacetat zugegeben, zweimal mit gesättigter NaCl-Lsg. extrahiert, über Na₂SO₄ getrocknet und das Lösemittel entfernt. Der Rückstand wurde in 250 mL Hexan aufgekocht, von grünem Feststoff abfiltriert und auskristallisiert. Die Ausbeute betrug 39.3 g (67 % d. Th.). ¹H-NMR (CDCl₃): [ppm] = 8.03 (m, 1H), 7.91 (m, 1H), 7.78 (m, 2H), 7.62 (m, 1H), 7.52 (m, 1H), 3.91 (s, mit D₂O austauschbar, 1H), 1.72 (m, 2H), 1.33 (m, 1H), 1.10 (m, 8H), 0.81 (m, 3H), 0.65 (m, 3H).

### b) Synthese von 2,7-Dibrom-9-keto-10-(2-ethylhexyl)-10-methoxy-dihydrophenanthren (Monomer M9)

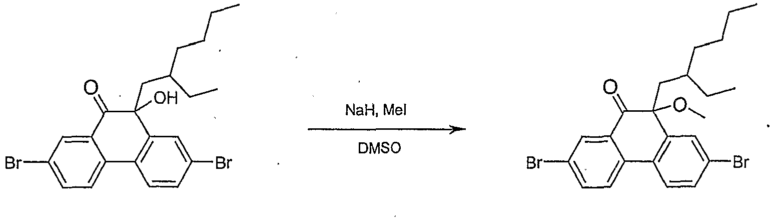

In einem ausgeheizten 500 mL-Vierhalskolben mit mechanischem Rührer, Kühler, Thermometer und Tropftrichter wurden 3.3 g (81.5 mmol) NaH (60 %ige Dispersion in Mineralöl) in 30 mL DMSO vorgelegt. Hierzu wurden 21.6 g (54.3 mmol) 2,7-Dibrom-9-keto-10-(2-ethylhexyl)-10-hydroxy-dihydrophenanthren in 60 mL DMSO langsam zugetropft, und es wurde 30 min. bei Raumtemperatur gerührt. Dann wurden unter Eiskühlung 5.1 mL (81.5 mmol) Methyliodid über 1 h zugetropft. Es wurde 2 Tage bei Raumtemperatur gerührt, dann wurde auf 5 °C abgekühlt, 90 mL halbkonz. NH₄OH zugetropft, 100 mL MeOH zugetropft, 30 min im Eisbad gerührt, abgesaugt, mit MeOH gewaschen und im Vakuumtrockenschrank bei 60 °C getrocknet. Das Rohprodukt wurde aus Methanol mehrfach umkristallisiert. Die Gesamtausbeute betrug 17.3 g (65 % d. Th.) bei einer Reinheit von > 99.8 %. ¹H-NMR (CDCl₃): [ppm] = 8.16 (d, ⁴J_{HH} = 2.3 Hz, 1H), 7.78 (m, 4H), 7.56 (dd, ³J_{HH} = 8.7 Hz, ⁴J_{HH} = 2.3 Hz, 2H), 3.17 (s, 3H), 1.71 (m, 2H), 1.26 (m, 1H), 1.06 (m, 8H), 0.77 (m, 3H), 0.59 (m, 3H).

### Beispiel 5: Synthese von 2,7-Dibrom-9-keto-10,10-bis(4-tert-butylphenyl)-dihydrophenanthren (Monomer M10 gemäß Formel (1))

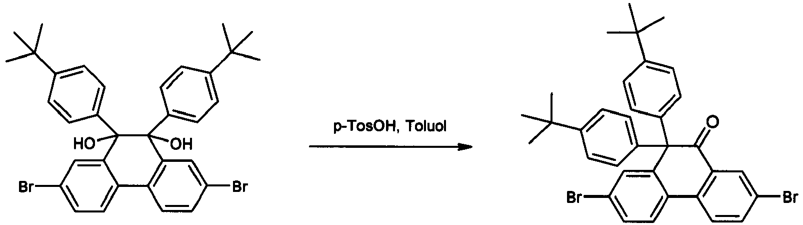

In einem 250 mL-Rundkolben mit Magnetrührer und Wasserabscheider mit Kühler wurden 200 mg para-Toluolsulfonsäure und 10 g (15.8 mmol) 2,7-Dibrom-9,10-bis(4-tert-butylphenyl)-9,10-dihydroxy-dihydrophenanthren in 80 mL Toluol suspendiert und 3 h am Wasserabscheider gekocht. Der Niederschlag wurde abgesaugt, mit Methanol gewaschen, zweimal aus Toluol umkristallisiert und unter Vakuum getrocknet. Die Ausbeute betrug 6.3 g (65 % d. Th.) bei einer Reinheit von > 99.9 %. ¹H-NMR (CDCl₃): [ppm] = 8.06 (d, ⁴J_{HH} = 2.0 Hz, 1H), 7.80 (d, ³J_{HH} = 8.7 Hz, 1H), 7.73 (d, ³J_{HH} = 8.7 Hz, 1H), 7.68 (dd, ³J_{HH} = 8.4 Hz, ⁴J_{HH} = 2.0 Hz, 1H), 7.55 (dd, ³J_{HH} = 8.3 Hz, ⁴J_{HH} = 2.0 Hz, 1H), 7.26 (m, 4H), 6.91 (d, ⁴J_{HH} = 2.0 Hz, 1H), 6.83 (m, 4H), 1.26 (s, 18H).

### Beispiel 6: Blendbestandteile V1 und V2 (VERB1 gemäß Formel (1))

Als Blendbestandteil **V1** wurde beispielhaft das folgende Keton verwendet, dessen Synthese bereits in DE 10317556 A1 beschrieben ist:

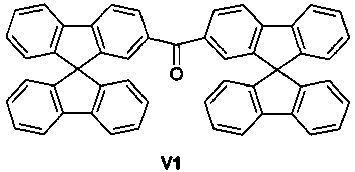

Als Blendbestandteil **V2** wurde beispielhaft das folgende Phosphinoxid verwendet, dessen Synthese in DE 10330761 A1 beschrieben ist:

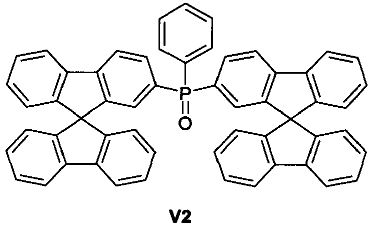

### Beispiel 7: Struktureinheiten TRIP1 zur Verwendung in Blends

Bei den hier beispielhaft verwendeten Verbindungen **TRIP1** handelt es sich um Derivate von tris-(Phenylpyridyl)iridium(III). Die Synthese dieser Verbindungen ist bereits in WO 02/081488 und WO 04/026886 beschrieben. Zur Übersicht sind die hier verwendeten Iridium-Komplexe im Folgenden nochmals abgebildet:

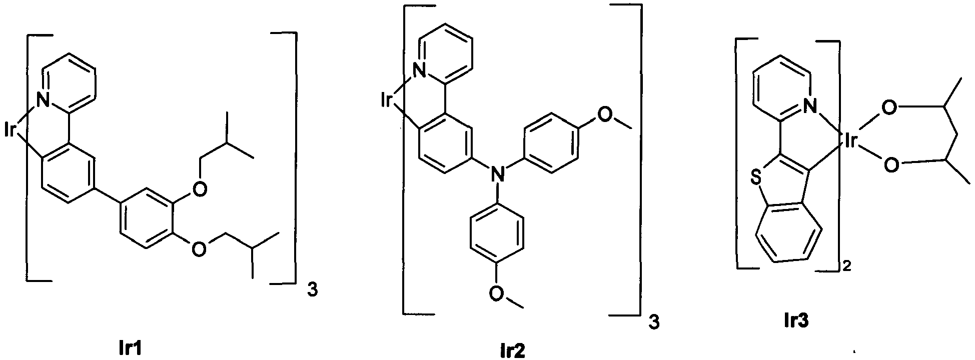

### Beispiel 8: Weitere Blendbestandteile

Als weitere Blendbestandteile wurden das Spiro-Triarylaminderivat **Amin1** und das Spiro-Oxadiazolderivat **Ox1** verwendet, deren Strukturen im Folgenden aufgezeigt sind:

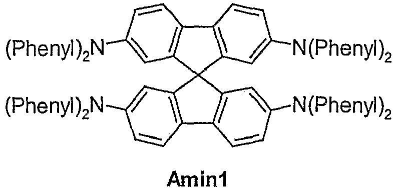

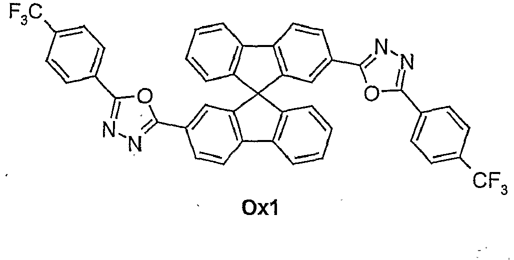

### Beispiel 9: Synthese konjugierter Polymere POLY3

Die Synthese konjugierter Polymere POLY3, die keine Einheiten gemäß Formel (1) bis (5) und keine Verbindungen TRIP2 enthalten, ist bereits beispielsweise in den Anmeldeschriften WO 02/077060, WO 03/020790 und WO 04/070772 beschrieben.

### Beispiel 10: Synthese von Polymer P1

Die Synthese erfolgte gemäß dem in WO 03/048224 beschriebenen Verfahren. Es wurden eingesetzt: 1.6013 g (2 mmol) Monomer **M1,** 0.8118 g (1.2 mmol) Monomer **M2,** 0.3035 g (0.4 mmol) Monomer **M5,** 0.1744 g (0.4 mmol) Monomer **M7** und 2.03 g (2.2 Äquivalente) Kaliumphosphat Hydrat in 19 mL Dioxan, 6 mL Toluol und 12 mL H₂O. Als Katalysator wurden verwendet: 0.45 mg Pd(OAc)₂ und 3.65 mg P(o-tolyl)₃. Nach Aufarbeitung wurden 1.57 g Polymer erhalten, das ein Molekulargewicht Mₙ 58000 g/mol und M_{w} 185000 g/mol aufwies (GPC in THF mit Polystyrol-Standard).

### Beispiel 11: Synthese von Polymer P2

Die Synthese erfolgte gemäß dem in WO 03/048224 beschriebenen Verfahren. Es wurden eingesetzt: 1.2889 g (2 mmol) Monomer **M3,** 0.7951 g (1.2 mmol) Monomer **M4,** 0.3035 g (0.4 mmol) Monomer **M5,** 0.1360 g (0.4 mmol) Monomer **M6** und 2.03 g (2.2 Äquivalente) Kaliumphosphat Hydrat in 19 mL Dioxan, 6 mL Toluol und 12 mL H₂O. Als Katalysator wurden verwendet: 0.45 mg Pd(OAc)₂ und 3.65 mg P(O-tolyl)₃. Nach Aufarbeitung wurden 1.72 g Polymer erhalten, das ein Molekulargewicht Mₙ 87000 g/mol und M_{w} 219000 g/mol aufwies (GPC in THF mit Polystyrol-Standard).

### Beispiel 12: Nicht-konjugierte Polymere (POLY1) P6 und P7

Polystryrol **P6** mit dem Schmelzindex 7.5 wurde kommerziell von Aldrich bezogen. Die Synthese von Poly(vinylbenzophenon) **P7** erfolgte gemäß Helv. Chim. Acta 1999, 82, 338-346.

### Beispiel 13: Herstellung der Blends

Die Herstellung der Mischungen erfolgte durch Lösen der Blendbestandteile im gewünschten Verhältnis und in der gewünschten Konzentration in Toluol. Dabei wurde der Lösevorgang in einer inerten Atmosphäre bei 60 °C durchgeführt. Die Lösung wurde ohne Isolierung der Mischung (nochmaliges Ausfällen der Feststoffanteile) direkt verarbeitet.

### Beispiel 14: Herstellung der polymeren Leuchtdioden (PLEDs)

Wie PLEDs dargestellt werden können, ist beispielsweise in WO 04/037887 und der darin zitierten Literatur ausführlich beschrieben. Dabei hat sich gezeigt, dass die erfindungsgemäßen Polymere und Blends homogenere Filme bilden als die Polymere und Blends gemäß Stand der Technik. Ohne an eine bestimmte Theorie gebunden sein zu wollen, vermuten wir, dass dies durch die bessere Löslichkeit dieser Verbindungen begründet ist.

### Beispiel 15: Übersicht über die synthetisierten und verwendeten Polymere

Tabelle 1 gibt eine Übersicht über die Zusammensetzung einiger der synthetisierten und in den Devices verwendeten Polymere.

**Tabelle 1: Ubersicht über die Zusammensetzung einiger Polymere**

| Polymer | Monomere | | | |
|---|---|---|---|---|
| **P1** | 50% **M1** | 30% **M2** | 10% **M5** | 10% **M7** |
| **P2** | 50% **M1** | 30% **M8** | 10% **M5** | 10% **M7** |
| **P3** | 50% **M1** | 30% **M2** | 10% **M5** | 10% **M6** |
| **P4** | 50% **M1** | 30% **M2** | 10% **M5** | 10% **M9** |
| **P5** | 50% **M1** | 50% **M6** | | |
| **P6** | 50% **M1** | 50% M**7** | | |
| **P7** | Polystyrol | | | |

### Beispiel 16: Device-Beispiele

Tabelle 2 gibt eine Übersicht über verschiedene Blends aus Polymeren und Triplettemittern, gegebenenfalls mit weiteren Komponenten.

**Tabelle 2: Einige Deviceergebnisse mit erfindungsgemäßen Blends**

| Blend | Polymer^{a} | Triplettemitter^{b} | Weitere Bestandteile^{a} | Max. Eff. | U @ 100 cd/m² | CIE x/y^{c} | Lebensdauer^{d} |
|---|---|---|---|---|---|---|---|
| Blend 1 a) | **P1** | 20% Ir2 | | 13.55 cd/A | 5.0 V | 0.62 / 0.38 | 1000 h |
| Blend 1 b) | **P1** | 8% Ir3 | | 3.69 cd/A | 5.0 V | 0.68 / 0.32 | 710 h |
| Blend 2 a) | **P2** | 20% Ir2 | | 10.56 cd/A | 4.4 V | 0.62 / 0.38 | 5900 h |
| Blend 2 b) | **P2** | 8% Ir3 | | 4.13 cd/A | 4.5 V | 0.68 / 0.32 | 1140 h |
| Blend 3 | **P3** | 8% Ir2 | | 8.79 cd/A | 5.8 V | 0.68 / 0.32 | 830 h |
| Blend 4 | **P4** | 20% Ir2 | | 5.89 cd/A | 6.5 V | 0.62 / 0.38 | 2500 h |
| Blend 5 | **P5** | 8% Ir3 | | 3.08 cd/A | 5.7 V | 0.68 / 0.32 | 480 h |
| Blend 6 a) | **P6** | 8% Ir1 | | 7.49 cd/A | 6.0 V | 0.42 / 0.56 | 420 h |
| Blend 6 b) | **P6** | 20 % Ir1 | | 20.0 cd/A | 4.5 V | 0.40 / 0.58 | 2000 h |
| Blend 6 c) | **P6** | 20% Ir2 | | 6.51 cd/A | 5.7 V | 0.62 / 0.38 | > 10000 h |
| Blend 7 a) | 30% **P7** | 8% Ir1 | 30% **V1** | 26.78 cd/A | 4.7 V | 0.41 / 0.57 | 2800 h |
| | | | 20% **V2** | | | | |
| | | | 20% **Amin1** | | | | |
| Blend 7 b) | 30% **P7** | 8% Ir1 | 30% **V1** | 27.40 cd/A | 4.1 V | 0.38 / 0.59 | n.a. |
| | | | 20% **Amin1** | | | | |
| | | | 20% **Ox1** | | | | |

| | | | | | | | |
|---|---|---|---|---|---|---|---|
| ^{a} Der Anteil des Polymers bzw. der weiteren Blendbestandteile bezieht sich auf die Gesamtzusammensetzung aller Bestandteile außer dem Triplettemitter. ^{b} Der Anteil des Triplettemitters ist bezogen auf die Matrix, d. h. das Polymer bzw. die Mischung des Polymers mit den anderen Bestandteilen. ^{c} CIE-Koordinaten: Chromatizitäts-Koordinaten der Commission Internationale de l'Eclairage von 1931. ^{d} Die angegebene Lebensdauer bezieht sich auf den so genannten LT50-Wert, d. h. die Zeit, die verstreicht, bis die entsprechende PLED nur noch 50 % der Anfangshelligkeit aufweist; die Werte wurden bestimmt mit einer Anfangshelligkeit von 100 cd/m². | | | | | | | |

## Patentansprüche

1. Organische Halbleiter, enthaltend
(A) mindestens ein konjugiertes, teilkonjugiertes oder gekreuzt-konjugiertes Polymer,
(B) mindestens eine Struktureinheit L=X, wobei für die verwendeten Symbole gilt:
L ist bei jedem Auftreten gleich oder verschieden (R¹)(R²)C, (R¹)P, (R¹)As, (R¹)Sb, (R¹)Bi, (R¹)(R²)(R³)P, (R¹)(R²)(R³)As, (R¹)(R²)(R³)Sb, (R¹)(R²)(R³)Bi, (R¹)(R²)S, (R¹)(R²)Se, (R¹)(R²)Te, (R¹)(R²)S(=O), (R¹)(R²)Se(=O) oder (R¹)(R²)Te(=O);
X ist bei jedem Auftreten gleich oder verschieden O, S, Se oder N-R⁴, mit der Maßgabe, dass X nicht S oder Se ist, wenn L für S, Se oder Te steht;
R¹, R², R³ ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁵ substituiert oder auch unsubstituiert sein kann, wobei eine oder mehrere nicht benachbarte CH₂-Gruppen durch -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- oder -CONR⁶- ersetzt sein können und wobei ein oder mehrere H-Atome durch F, Cl, Br, I, CN oder NO₂ ersetzt sein können, oder ein aromatisches oder heteroaromatisches Ringsystem mit 1 bis 40 C-Atomen, das durch einen oder mehrere Reste R⁵ substituiert sein kann, wobei zwei oder mehrere Substituenten R¹, R² und/oder R³ auch miteinander ein mono- oder polycyclisches, aliphatisches oder aromatisches Ringsystem bilden können; dabei dürfen nicht alle Substituenten R¹ bis R³ an einer Struktureinheit H oder F sein; die Gruppen R¹ bis R³ können weiterhin gegebenenfalls Bindungen zu dem Polymer aufweisen;
R⁴ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -R⁶C=CR⁶-, -C≡C-, Si(R⁶)₂, Ge(R⁶)₂, Sn(R⁶)₂, -NR⁶-, -O-, -S-, -CO-O-, -O-CO-O- ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R⁶ substituiert sein kann, oder OH oder N(R⁵)₂;
R⁵ ist bei jedem Auftreten gleich oder verschieden R⁴ oder CN, B(R⁶)₂ oder Si(R⁶)₃.
R⁶ ist bei jedem Auftreten gleich oder verschieden H oder ein aliphatischer oder aromatischer Kohlenwasserstoffrest mit 1 bis 20 C-Atomen;
und
(C) mindestens einen Triplett-Emitter, der ein Ir-Metall enthält;
mit der Maßgabe, dass Mischungen aus zwei Polymeren ausgenommen sind, in denen das eine Polymer kovalent gebundene Triplett-Emitter enthält und das andere ein Copolymer aus TPD-Einheiten und Diphenylsulfonether- bzw. Diphenylketonether-Einheiten ist; und weiterhin mit der Maßgabe, dass Polymere, die einerseits kovalent gebundene Triplett-Emitter und andererseits Einheiten gemäß Formel (a) enthalten, von der Erfindung ausgenommen sind: 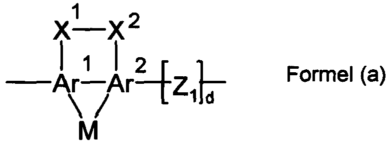
worin Ar¹ und Ar² jeweils unabhängig eine tetravalente aromatische Kohlenwasserstoffgruppe oder eine tetravalente heterocyclische Gruppe bedeuten;
eine der Einheiten X¹ und X² bedeutet C(=O) oder C(R¹)(R²) und die andere bedeutet O, S, C(=O), S(=O), SO₂, Si(R³)(R⁴), N(R⁵), B(R⁶), P(R⁷) oder P(=O)(R⁸);
wobei in der Formel (a) die Reste R¹, R², R³, R⁴, R⁵, R⁶, R⁷ und R⁸ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten,
M bedeutet eine Gruppe, die durch Formel (b), Formel (c) oder Formel (d) dargestellt wird;
-Y¹-Y²- Formel (b)
worin Y¹ und Y² jeweils unabhängig O, S, C(=O), S(=O), SO₂, C(R⁹)(R¹⁰), Si(R¹¹)(R¹²), N(R¹³), B(R¹⁴), P(R¹⁵) oder P(=O)(R¹⁶) bedeuten,
wobei in der Formel (b) die Reste R⁹, R¹⁰, R¹¹, R¹², R¹³, R¹⁴, R¹⁵ und R¹⁶ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten, wobei Y¹ und Y² nicht identisch sind, wenn Y¹ nicht C(R⁹)(R¹⁰) oder Si(R¹¹)(R¹²) ist;
-Y³=Y⁴- Formel (c)
worin Y³ und Y⁴ jeweils unabhängig N, B, P, C(R¹⁷) oder Si(R¹⁸) bedeuten;
in der Formel (c) die Reste R¹⁷ und R¹⁸ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten;
-Y⁵- Formel (d)
worin Y⁵ O, S, C(=O), S(=O), S02, C(R¹⁹)(R²⁰), Si(R²¹)(R²²), N(R²³), B(R²⁴), P(R²⁵) oder P(=O)(R²⁶) bedeutet;
wobei in de Formel (d) die Reste R¹⁹, R²⁰, R²¹, R²², R²³, R²⁴, R²⁵ und R²⁶ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten;
Z₁ bedeutet -CR³⁶=CR³⁷- oder -C=C-; R³⁶ und R³⁷ bedeuten jeweils unabhängig ein Wasserstoffatom, eine Alkylgruppe, eine Arylgruppe, eine monovalente heterocyclische Gruppe oder eine Cyanogruppe;
d bedeutet 0 oder 1.

2. Organische Halbleiter gemäß Anspruch 1, **dadurch gekennzeichnet, dass** die Struktureinheiten L=X ausgewählt sind aus den Formeln (1) bis (5), 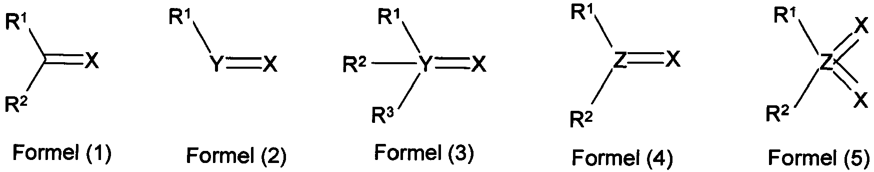 wobei die verwendeten Symbole folgende Bedeutung haben:
X ist bei jedem Auftreten gleich oder verschieden O, S, Se oder N-R⁴, mit der Maßgabe, dass X für Formel (4) und (5) nicht S oder Se sein darf;
Y ist bei jedem Auftreten gleich oder verschieden P, As, Sb oder Bi;
Z ist bei jedem Auftreten gleich oder verschieden S, Se oder Te;
R¹ bis R⁶ haben dieselbe Bedeutung, wie unter Anspruch 1 beschrieben.

3. Organische Halbleiter gemäß Anspruch 1 und/oder Anspruch 2, **dadurch gekennzeichnet, dass** diese mindestens 0.5 Gew.% mindestens eines konjugierten, teilkonjugierten oder gekreuzt-konjugierten Polymeren, mindestens 1 Gew.% mindestens einer Struktureinheit L=X, bzw. einer Struktureinheit gemäß den Formeln (1) bis (5) und mindestens 0.1 Gew.% mindestens eines Triplett-Emitters, der ein Ir-Metall enthält, enthalten.

4. Mischungen (BLEND1) gemäß einem oder mehreren der Ansprüche 1 bis 3, enthaltend
(A) 5 - 99.9 Gew.% mindestens eines konjugierten, teilkonjugierten oder gekreuzt-konjugierten Polymers (POLY1), das 1 - 100 mol% einer oder mehrerer Wiederholeinheiten (MON01), enthaltend mindestens eine Struktureinheit L=X, bzw. mindestens eine Struktureinheit gemäß Formel (1) bis (5), enthält,
und
(B) 0.1 - 95 Gew.% eines oder mehrerer Triplett-Emitter, der ein Ir-Metall enthält (TRIP1).

5. Mischungen (BLEND2) gemäß einem oder mehreren der Ansprüche 1 bis 3, enthaltend
(A) 0.5 - 99 Gew.% mindestens eines konjugierten, teilkonjugierten oder gekreuzt-konjugierten Polymers (POLY2), das 0.5 - 99.5 mol% eines oder mehrerer Triplett-Emitter, der ein Ir-Metall enthält, (TRIP2) kovalent gebunden enthält,
und
(B) 1 - 99.5 Gew.% mindestens einer Verbindung (VERB1), die mindestens eine Struktureinheit L=X, bzw. mindestens eine Struktureinheit gemäß Formel (1) bis (5) enthält und in der Lage ist, bei Raumtemperatur glasartige Schichten zu bilden.

6. Mischungen (BLEND3) gemäß einem oder mehreren der Ansprüche 1 bis 3, enthaltend
(A) 0.5 - 98.9 Gew.% eines konjugierten, teilkonjugierten oder gekreuzt-konjugierten Polymers (POLY3),
und
(B) 1 - 99 Gew.% mindestens einer Verbindung (VERB1), die mindestens eine Struktureinheit L=X, bzw. mindestens eine Struktureinheit gemäß Formel (1) bis (5) enthält und in der Lage ist, bei Raumtemperatur glasartige Schichten zu bilden,
und
(C) 0.1 - 95 Gew.% eines oder mehrerer Triplett-Emitter, der ein Ir-Metall enthält (TRIP1).

7. Mischungen (BLEND4) gemäß einem oder mehreren der Ansprüche 1 bis 3, enthaltend
(A) 0.5 - 99 Gew.% mindestens eines konjugierten, teilkonjugierten oder gekreuzt-konjugierten Polymers (POLY3);
und
(B) 1 - 99.5 Gew.% einer Verbindung (TRIP3), die mindestens eine Struktureinheit L=X, bzw. mindestens eine Struktureinheit der Formel (1) bis (5) kovalent an einen oder mehrere Triplett-Emitter, der ein Ir-Metall enthält, gebunden enthält, wobei die Bindung zwischen dem Triplett-Emitter und der Struktureinheit L=X an beliebigen Positionen der beiden Einheiten erfolgen kann mit der Einschränkung, dass in (TRIP3) mindestens eine Gruppe X frei und nicht an ein Metallatom koordiniert vorliegen muss.

8. Konjugierte, teilkonjugierte oder gekreuzt-konjugierte Polymere POLY4, enthaltend
(A) 1 - 99.9 mol% einer oder mehrerer Wiederholeinheiten MONO1 mit mindestens einer Struktureinheit L=X, wobei für Symbole L, X, R¹, R², R³, R⁴, R⁵ und R⁶ dieselbe Bedeutung besitzen, wie unter Anspruch 1 beschrieben;
(B) 0.1 - 95 mol% eines oder mehrerer Triplett-Emitter, der ein Ir-Metall enthält, TRIP2.

9. Organische Halbleiter gemäß einem oder mehreren der Ansprüche 1 bis 8, **dadurch gekennzeichnet, dass** die Polymere POLY1 bis POLY4 weitere Strukturelemente enthalten.

10. Organische Halbleiter gemäß einem oder mehreren der Ansprüche 1 bis 9, **dadurch gekennzeichnet, dass** für die Symbole der Formeln (1) bis (5) Folgendes gilt:
X steht für O, S oder N-R⁴;
Y steht für P oder As;
Z steht für S oder Se;
R¹ - R⁶ sind gemäß Anspruch 1 und 2 definiert, wobei an jeder Struktureinheit gemäß Formel (1) bis (5) mindestens einer der Substituenten R¹ bis R³ ein aromatisches oder heteroaromatisches Ringsystem mit 1 bis 40 C-Atomen darstellt, das mit einem oder mehreren Substituenten R⁴ substituiert oder unsubstituiert sein kann.

11. Organische Halbleiter gemäß Anspruch 10, **dadurch gekennzeichnet, dass** für die Symbole der Formeln (1) bis (5) Folgendes gilt:
X steht für O oder N-R⁴;
Y steht für P;
Z steht für S;
R¹ - R⁶ sind gemäß Anspruch 1 und 2 definiert, wobei an jeder Struktureinheit gemäß Formel (1) bis (5) alle Substituenten R¹ bis R³ ein aromatisches oder heteroaromatisches Ringsystem mit 1 bis 40 C-Atomen darstellen, die mit einem oder mehreren Substituenten R⁴ substituiert oder unsubstituiert sein können.

12. Organische Halbleiter gemäß einem oder mehreren der Ansprüche 1 bis 11, **dadurch gekennzeichnet, dass** mindestens einer der Reste R¹ bis R³ ein 9,9'-Spirobifluoren enthält.

13. Organische Halbleiter gemäß einem oder mehreren der Ansprüche 1 bis 12, **dadurch gekennzeichnet, dass** die Wiederholeinheiten (MONO1), die Strukturelemente L=X, bzw. Strukturelemente gemäß Formel (1) bis (5) enthalten, aus den Formeln (6) bis (148) ausgewählt werden, 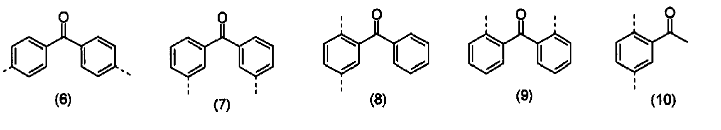 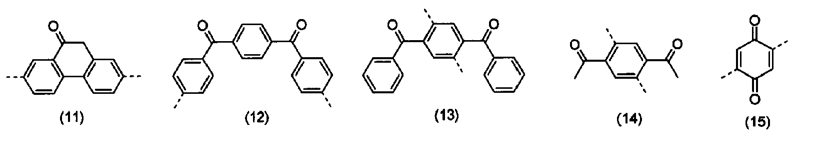 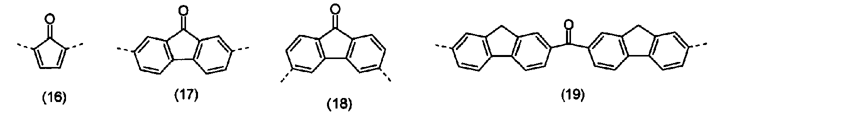 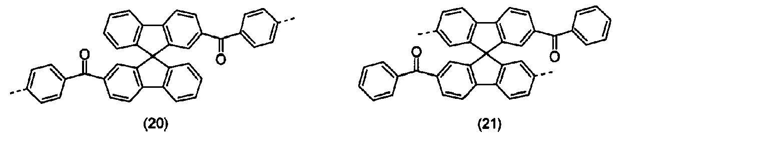 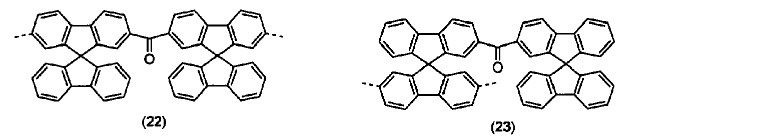 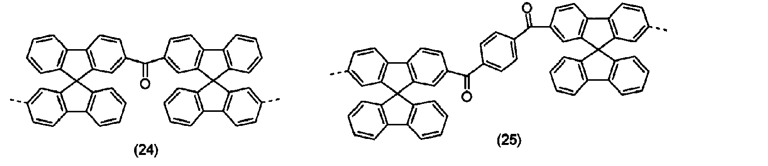 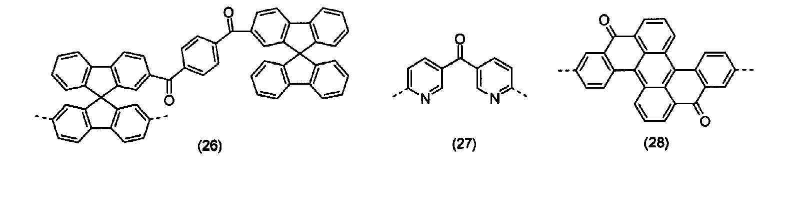 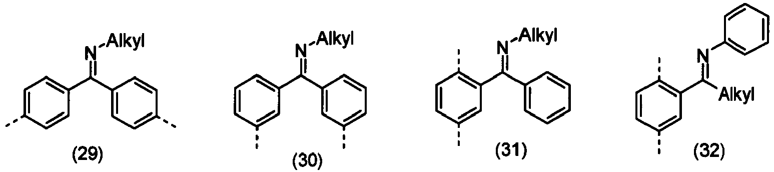 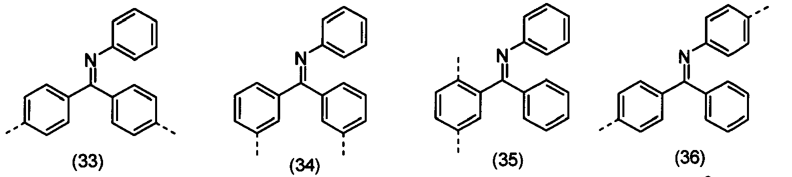 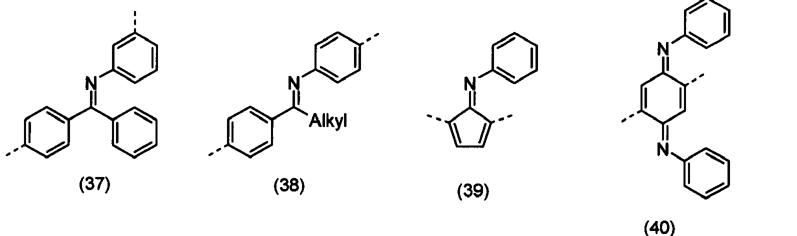 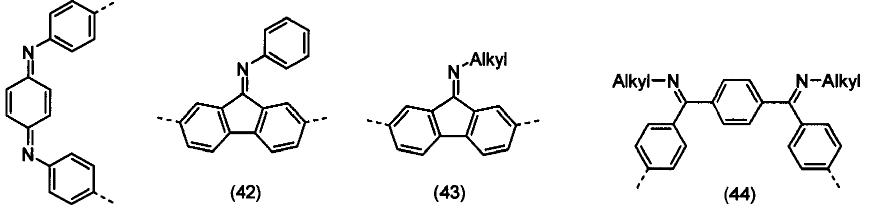 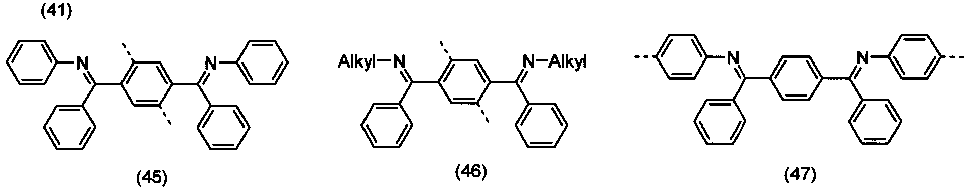 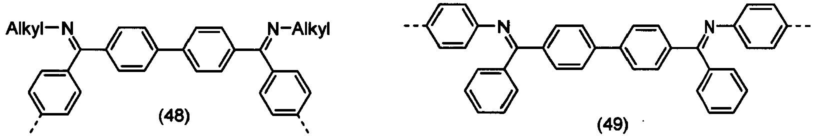 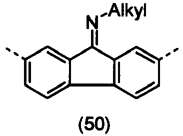 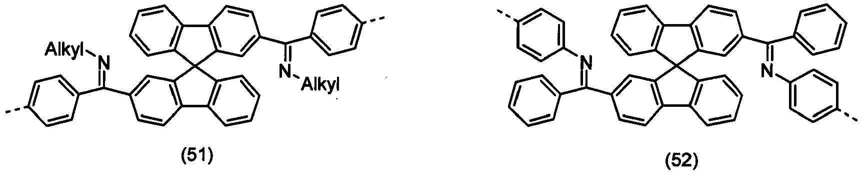 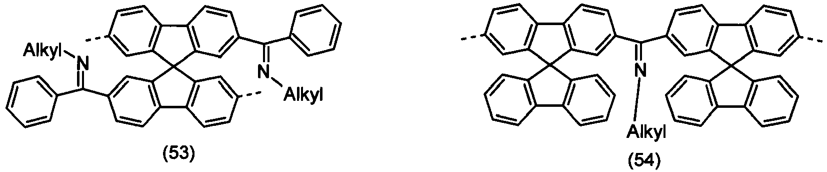 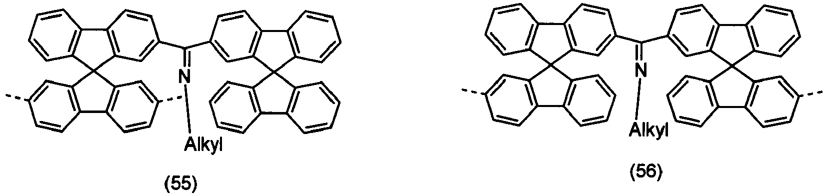 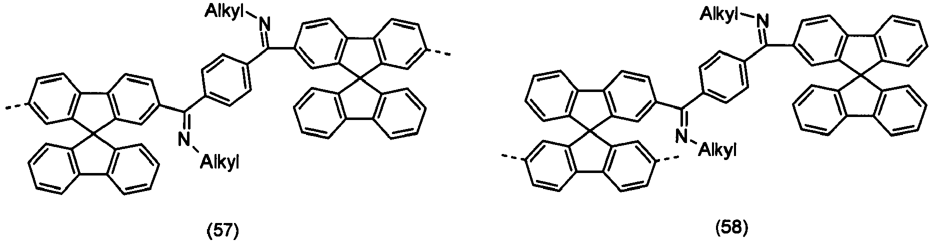 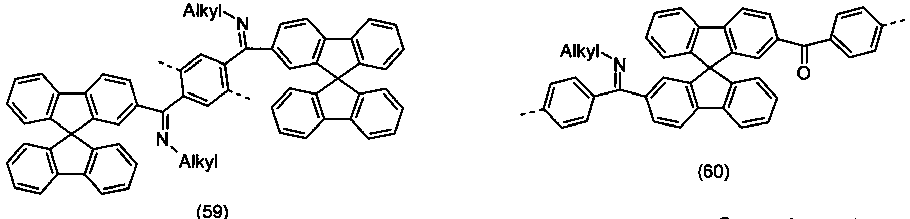 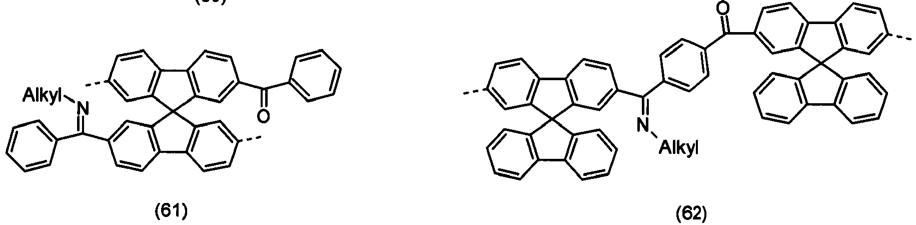 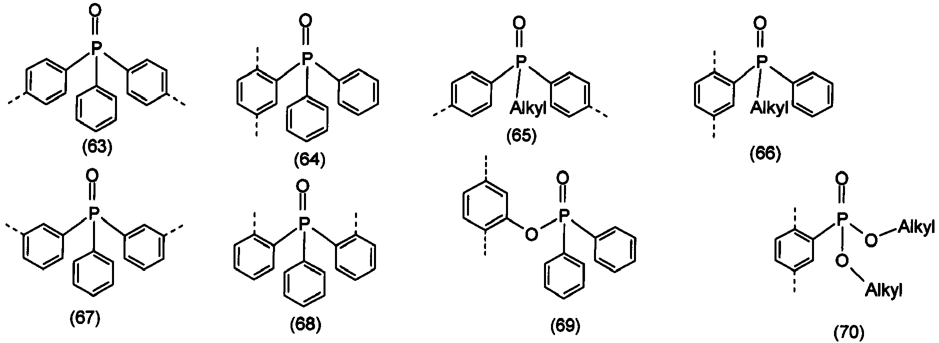 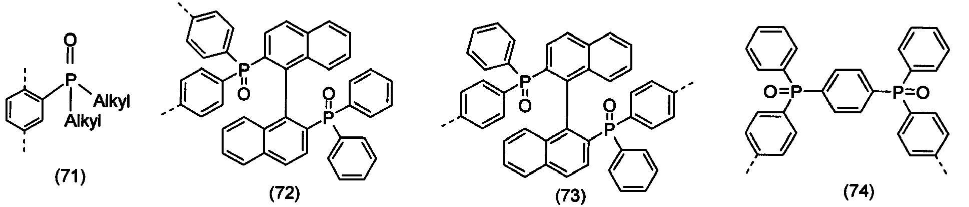 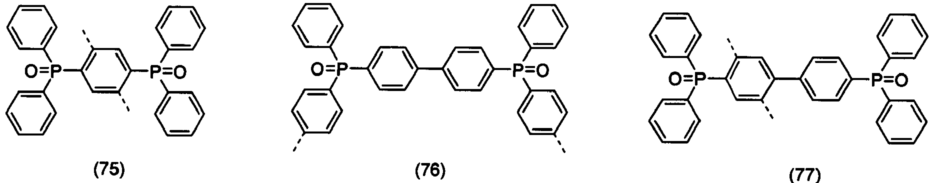 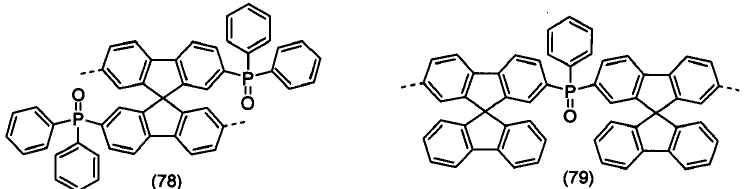 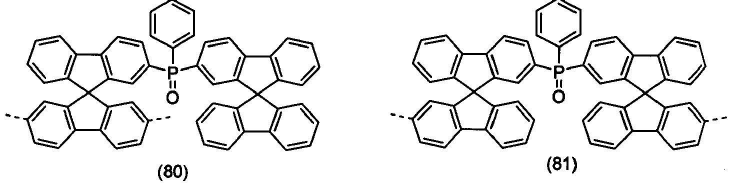 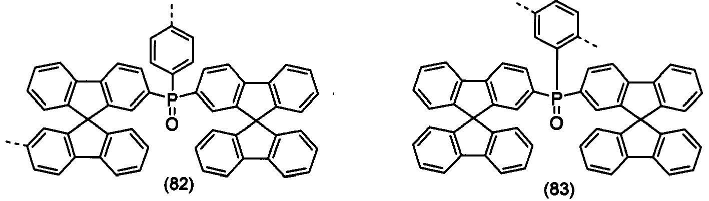 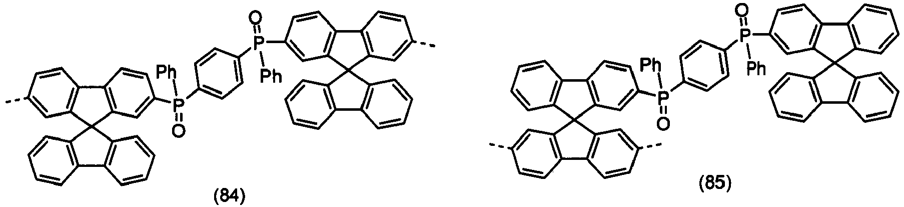 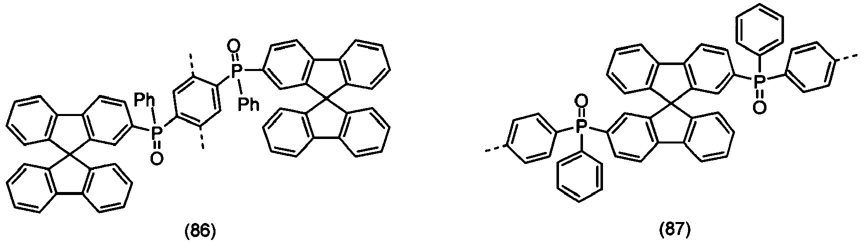 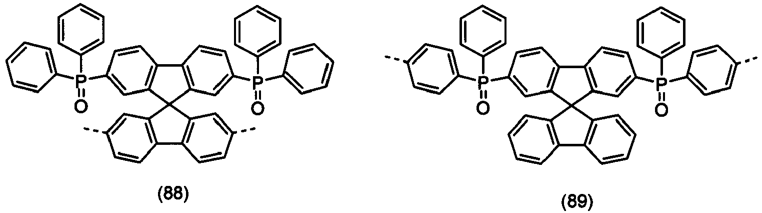 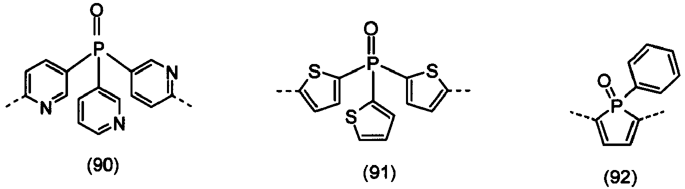 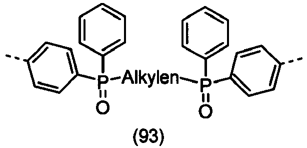 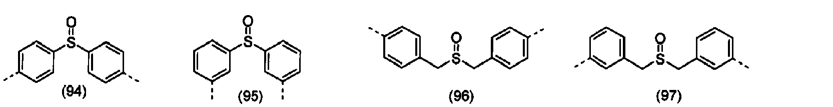 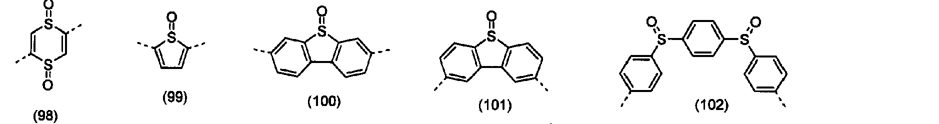 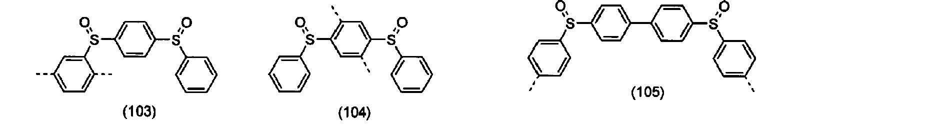 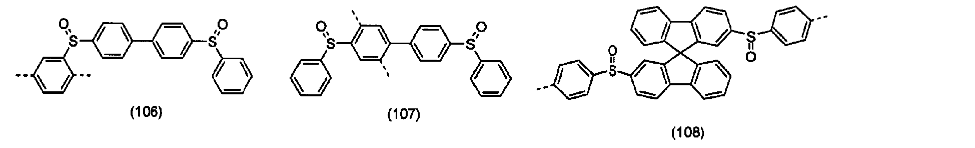 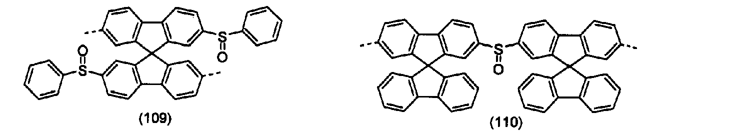 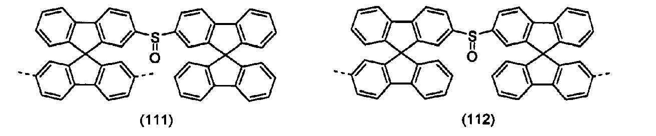 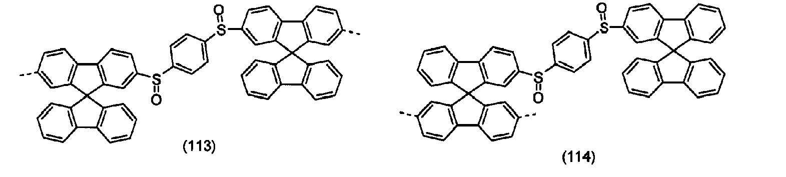 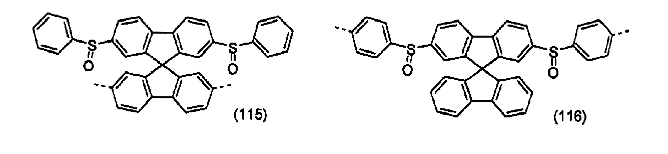 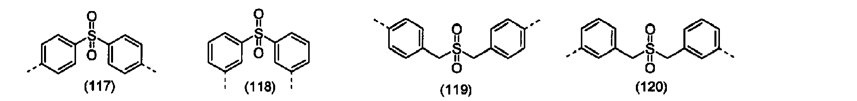 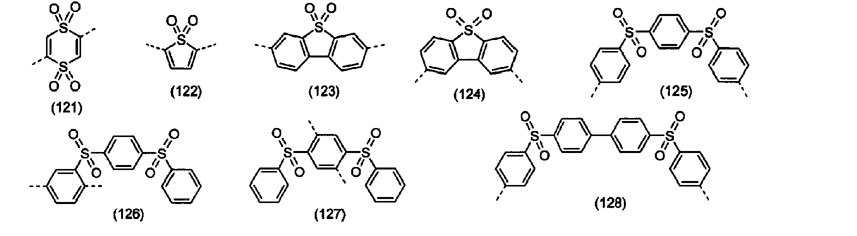 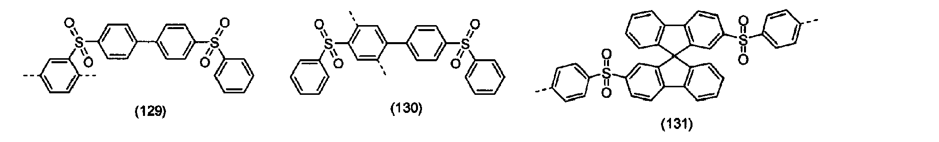 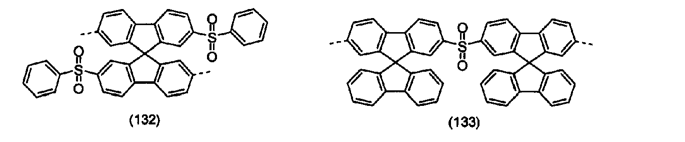 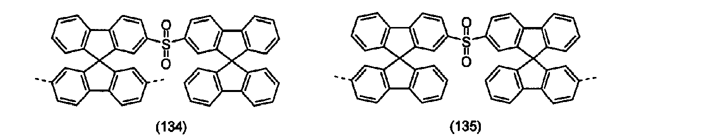 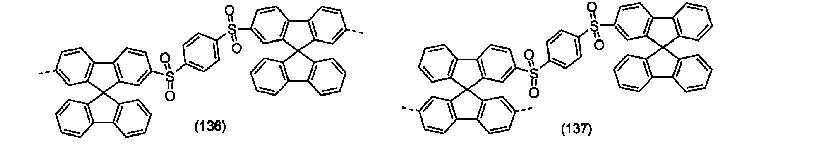 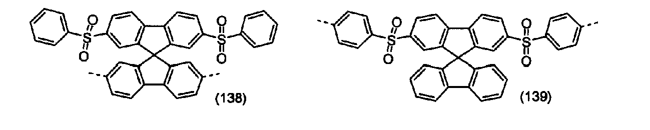 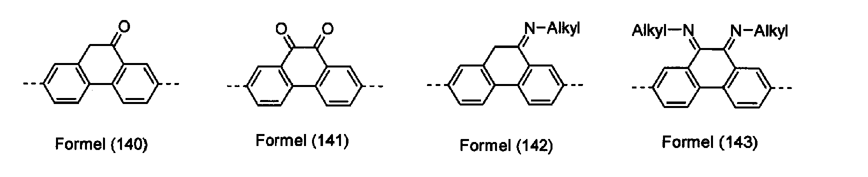 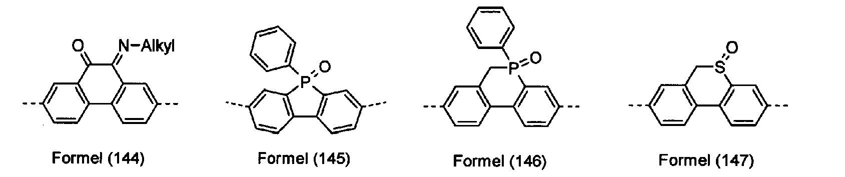 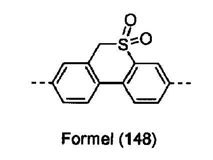 die substituiert oder unsubstituiert sein können.

14. Organische Halbleiter gemäß einem oder mehreren der Ansprüche 1 bis 13, **dadurch gekennzeichnet, dass** die Polymere ausgewählt sind aus den Klassen der aromatischen Polyketone, aromatische Polyphosphinoxide oder aromatischen Polysulfone, die jeweils zur besseren Löslichkeit noch substituiert sein können, der Polycarbonsäurederivate, Hauptketten-Polyester, Seitenketten-Polyester, Poly(glycolsäuren), Poly(milchsäuren), Poly(ε-caprolactone), Polyacrylate, Poly(hydroxybenzoesäuren), Poly(alkylenterephthalate), Polycarbonsäureanhydride, Polyamide, Poly(ε-caprolactame), Polypeptide, Polyaramide, Polybenzamide, Polyimide, Poly(amid-imide), Poly(esterimide), Poly(etherimide), Polycarbonate, Poly(ester-co-carbonate), Poly(isocyanurate), Polyurethane, Polyesterpolyurethane, Poly(terephthalate), Poly(acrylate), Poly(phenylacrylate), Poly(cyanoacrylate), Poly(vinylester), Poly(vinylacetate), Seitenketten-Polyphosphinoxide, Polyetherketone (PEK), Polyethersulfone, Polysulfonamide, Polysulfonimide, Poly(vinylketone), aromatische Polyvinylketone, substituierte oder unsubstituierte Poly(vinylbenzophenone), Polystyrol-analoge Ketone, Polycarbazene, Poly-Nitrile, Poly-Isonitrile, Polystyrol, PVK (Polyvinylcarbazol) oder Derivate davon.

15. Organische Halbleiter gemäß einem oder mehreren der Ansprüche 1 bis 12, **dadurch gekennzeichnet, dass** die Verbindung (VERB1), die Strukturelemente L=X, bzw. Strukturelemente gemäß Formeln (1) bis (5) enthält, aus den Formeln (6) bis (148) ausgewählt werden, 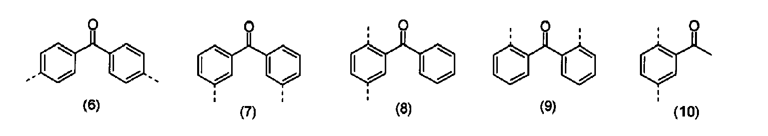 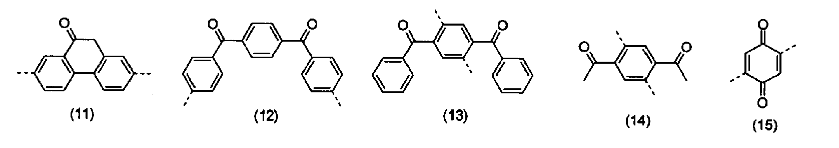 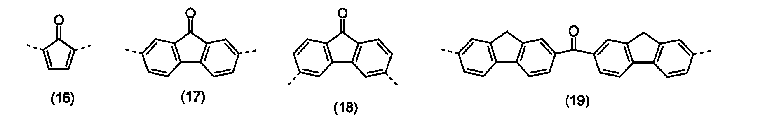 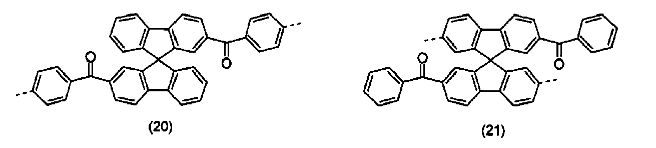 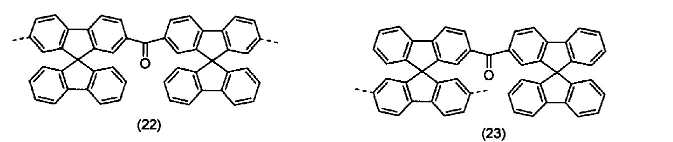 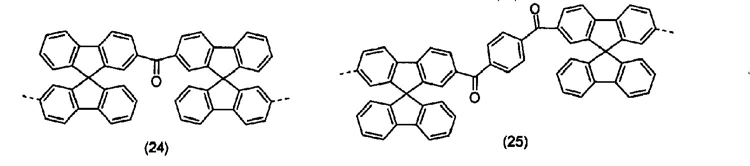 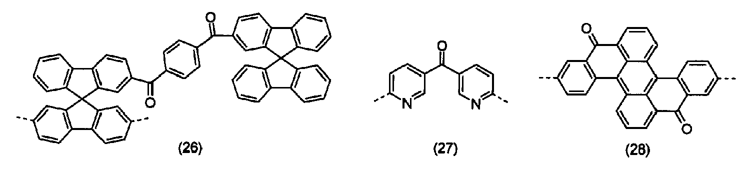 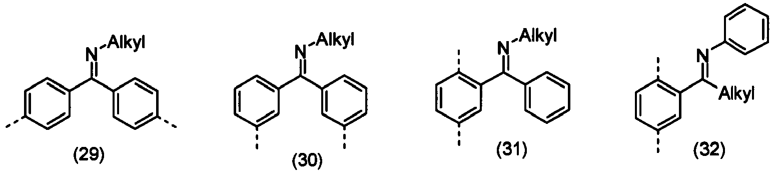 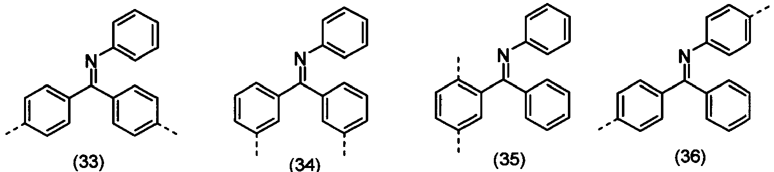 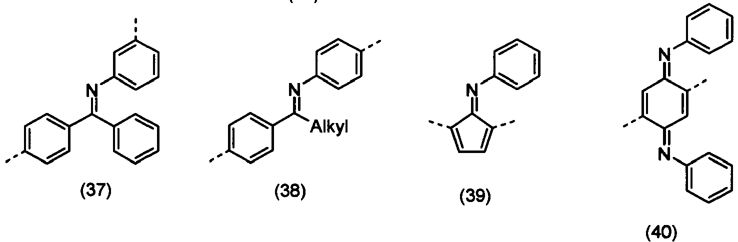 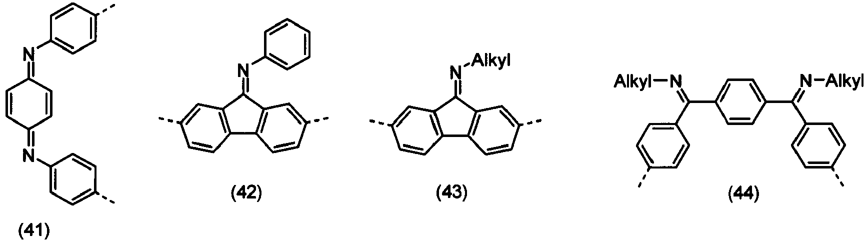 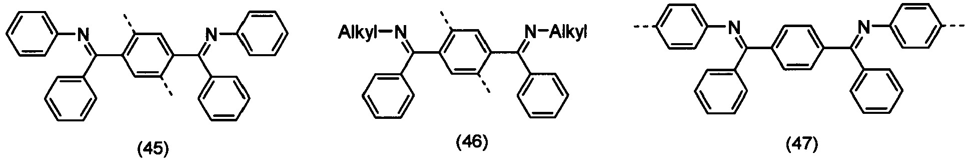 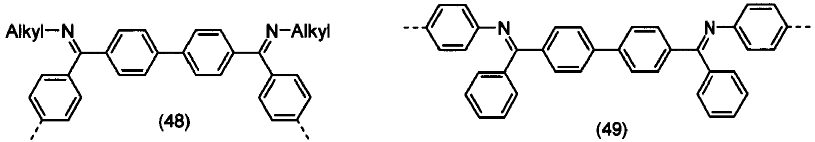 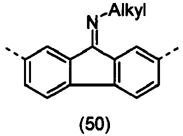 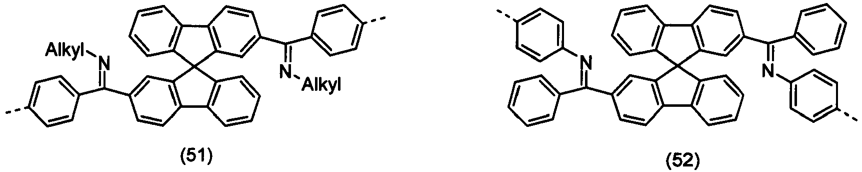 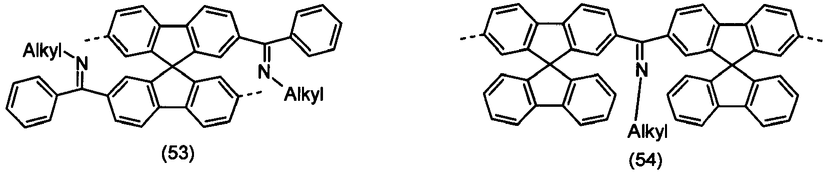 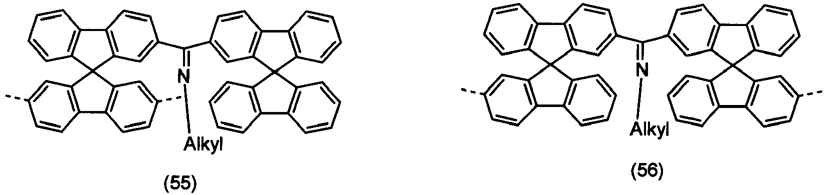 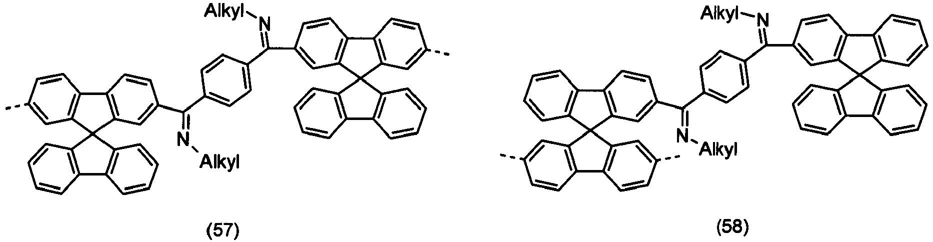 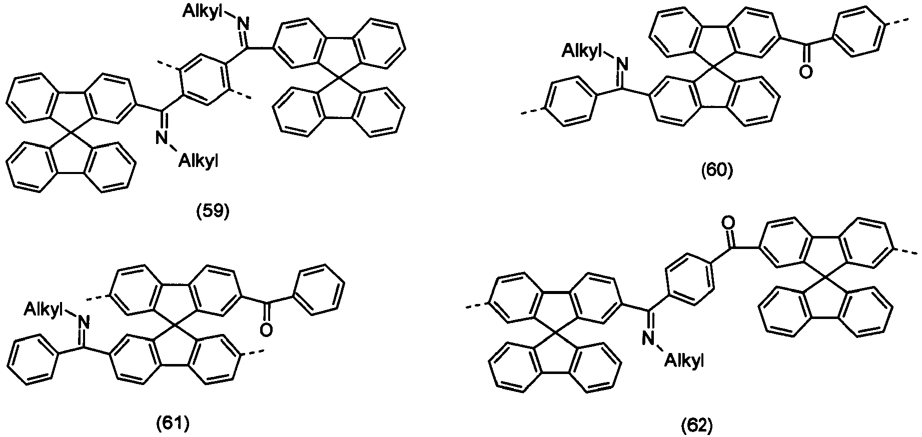 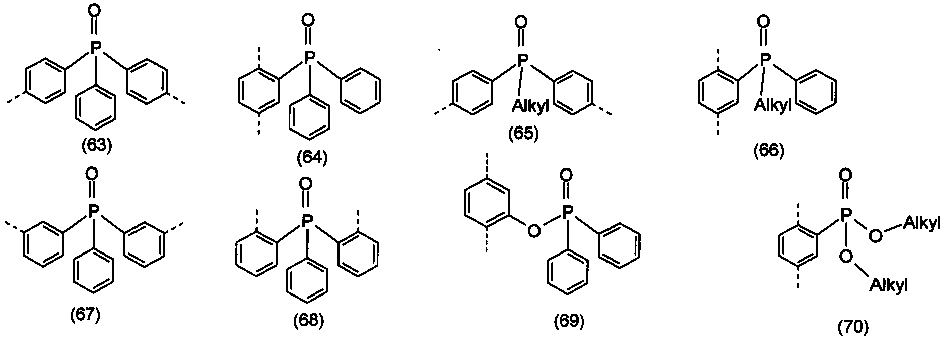 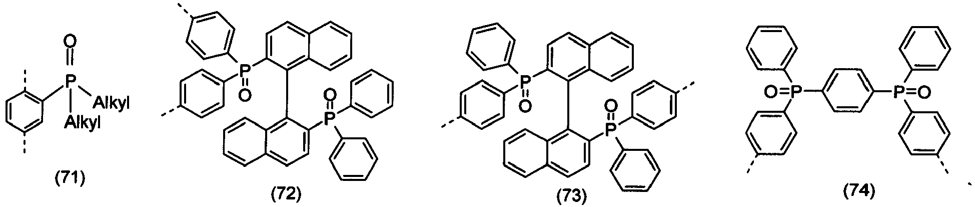 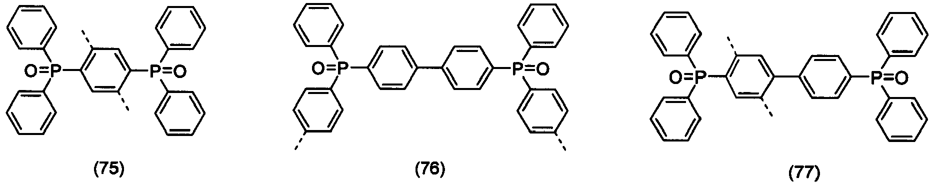 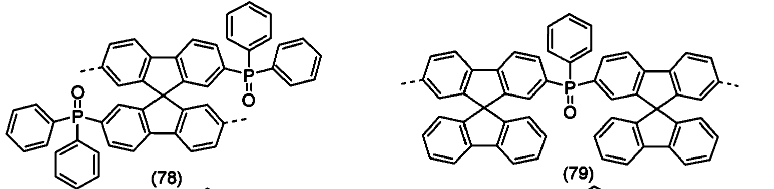 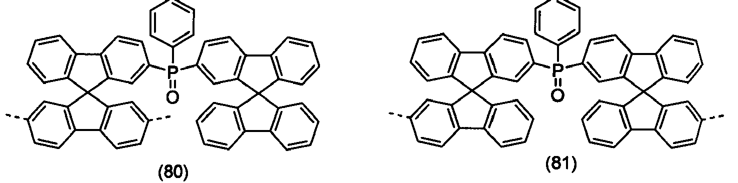 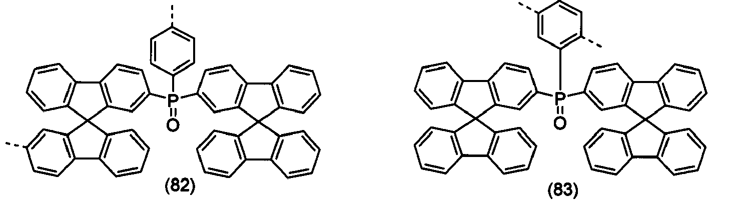 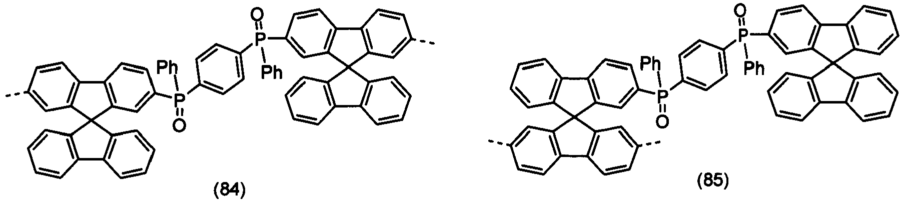 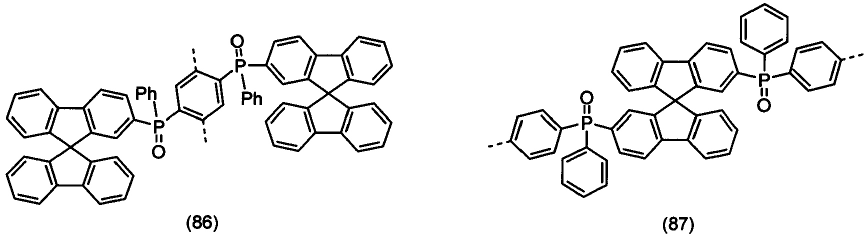 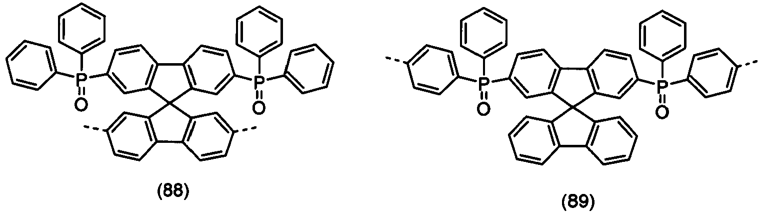 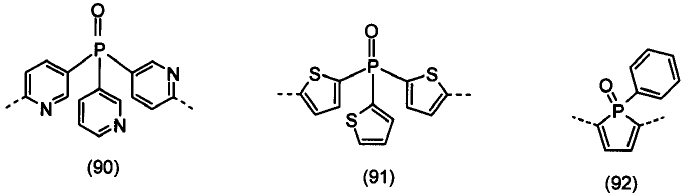 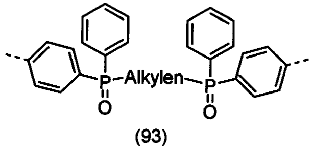 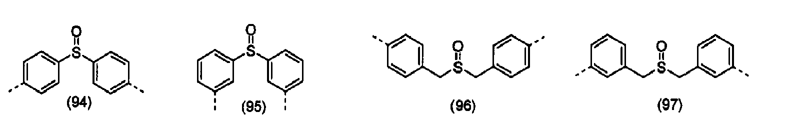 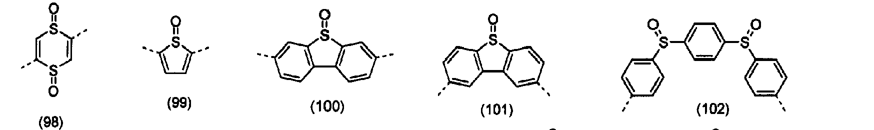 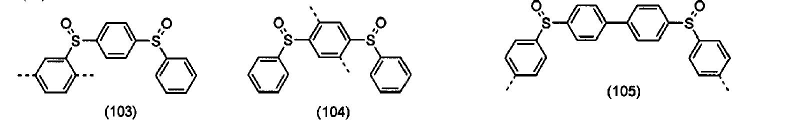 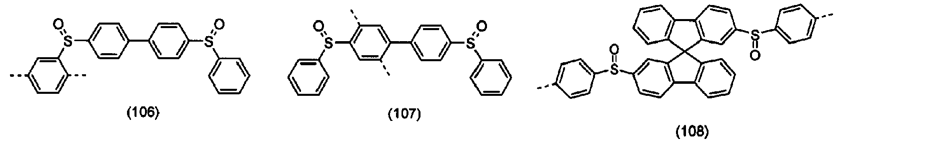 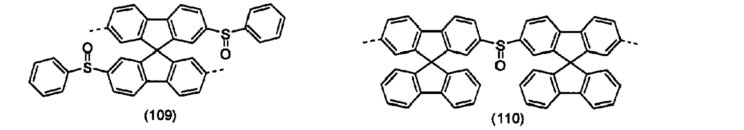 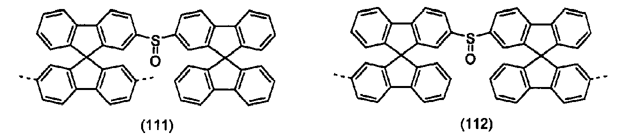 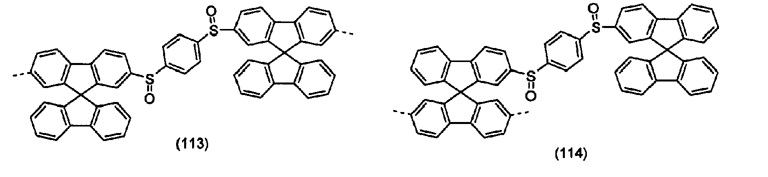 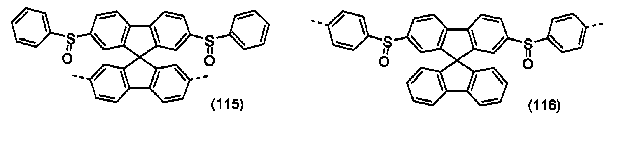 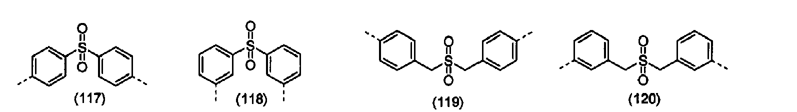 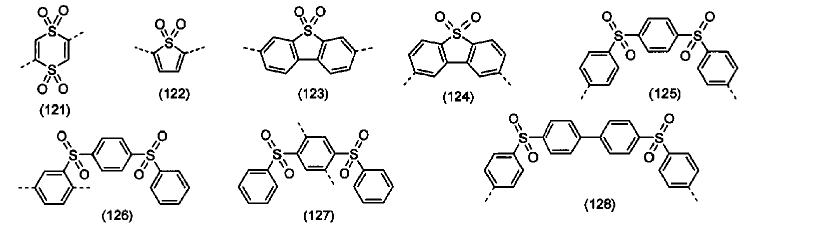 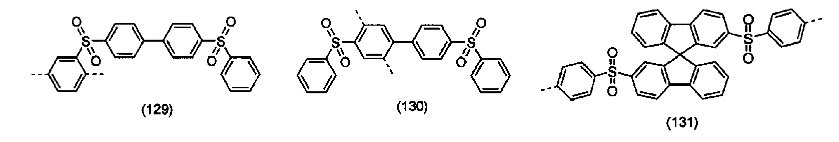 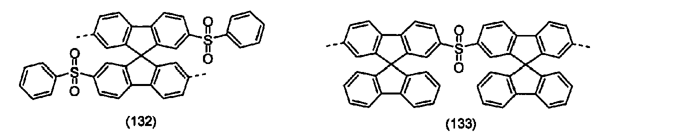 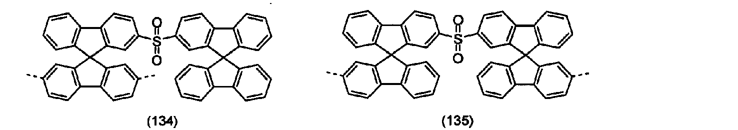 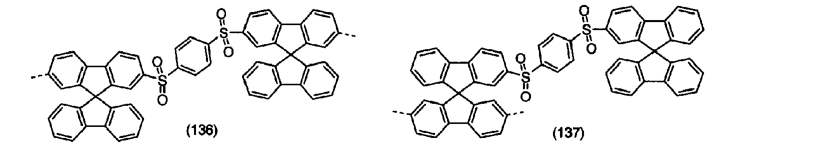 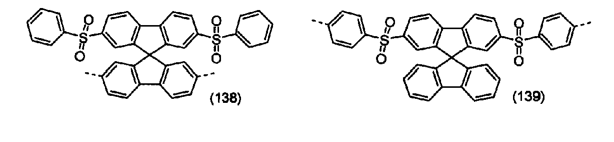 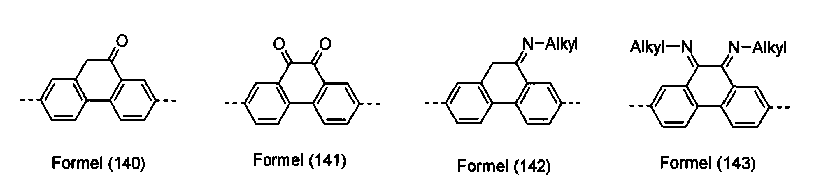 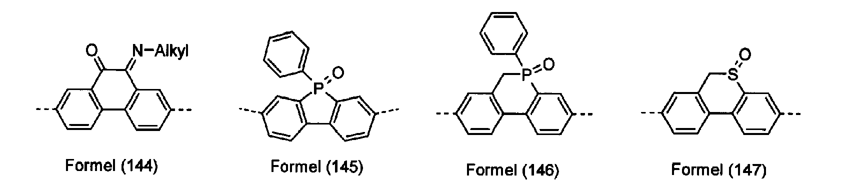 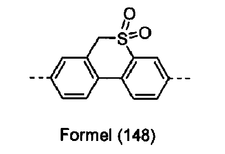 die substituiert oder unsubstituiert sein können.

16. Organische Halbleiter gemäß einem oder mehreren der Ansprüche 1 bis 12, **dadurch gekennzeichnet, dass** die Verbindung (TRIP3) Strukturelemente enthält, die aus den Formeln (6) bis (148) ausgewählt werden, 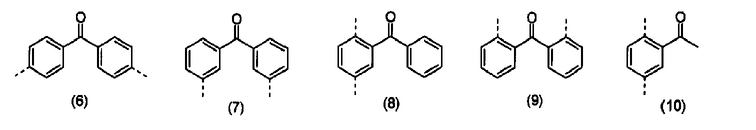 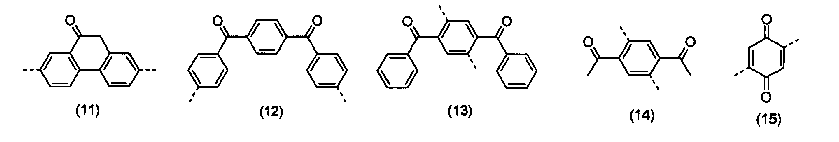 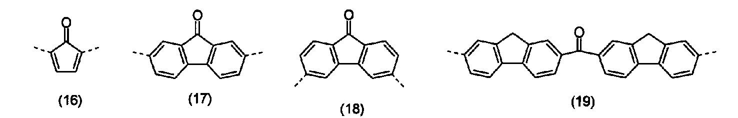 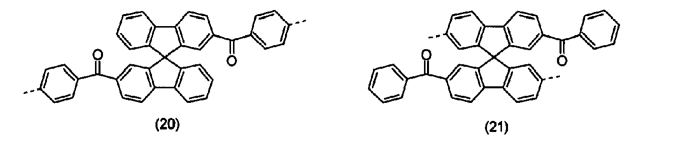 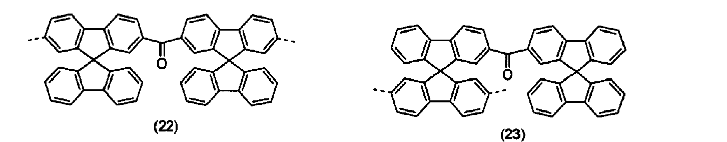 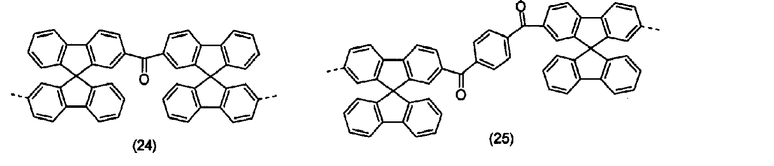 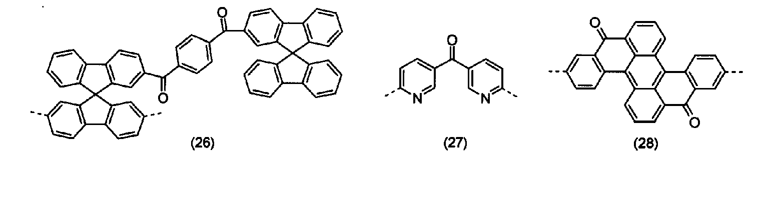 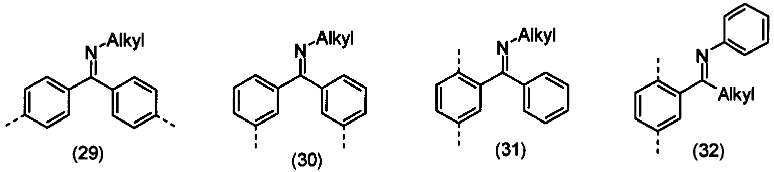 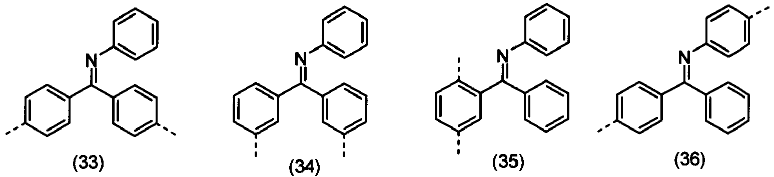 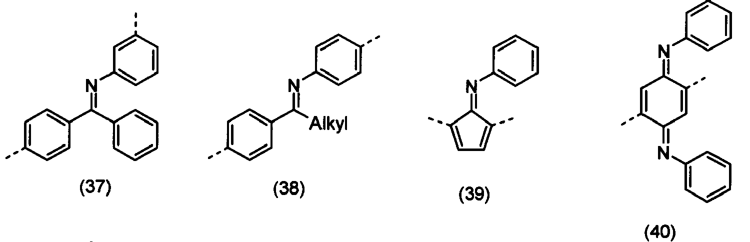 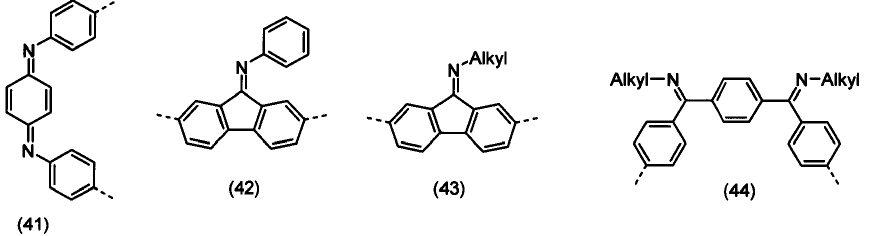 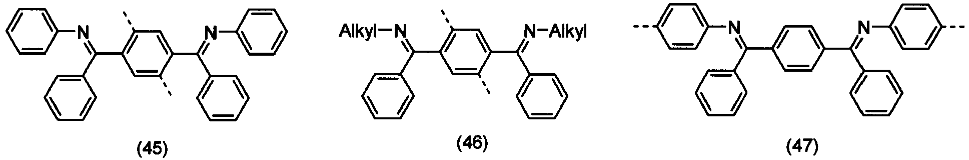 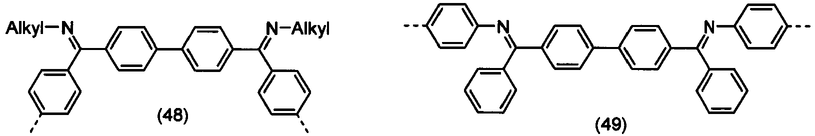 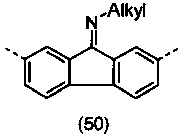 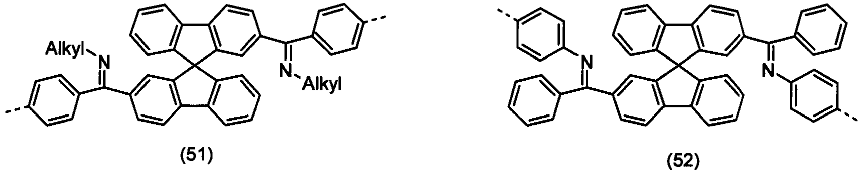 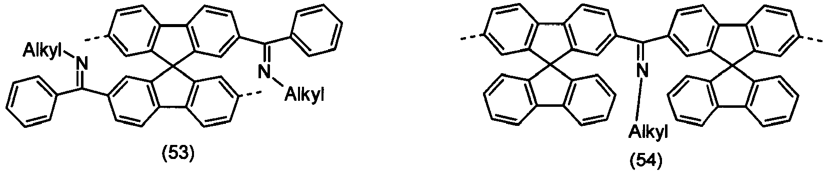 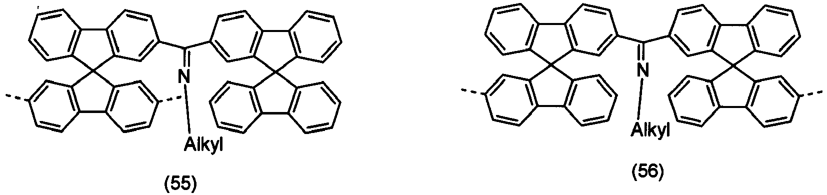 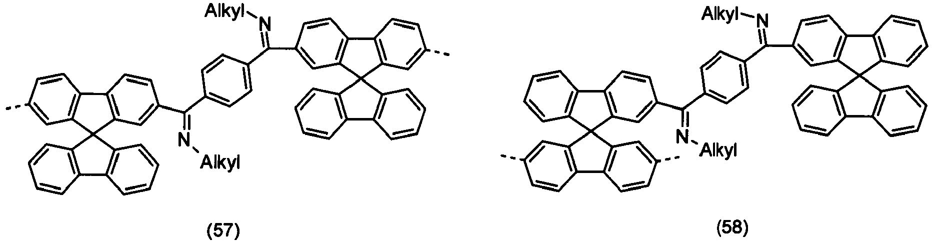 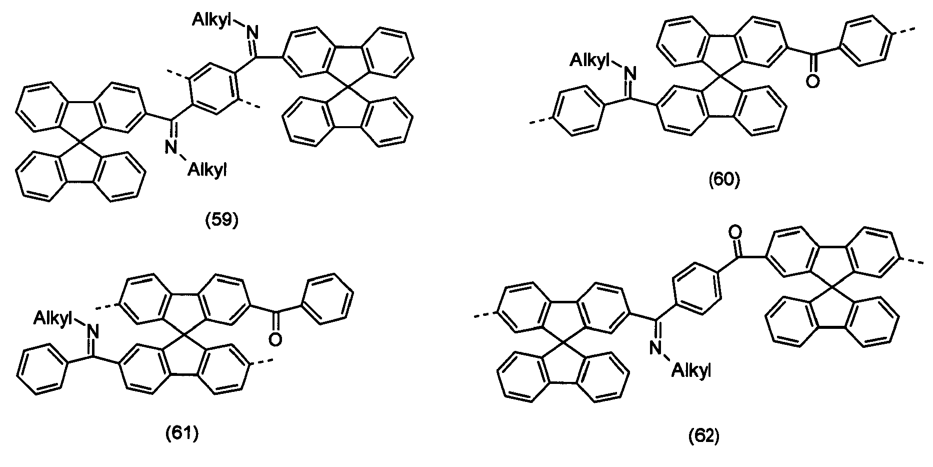 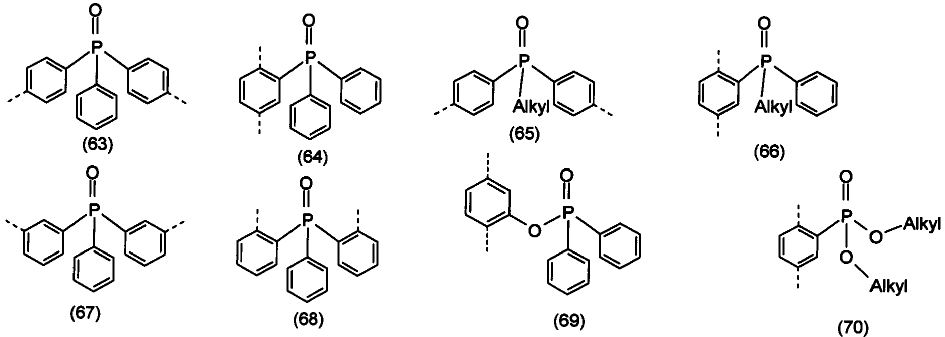 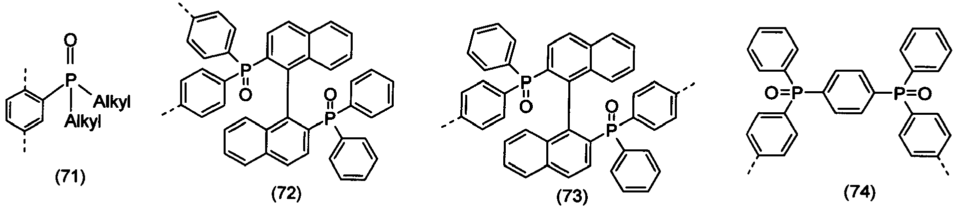 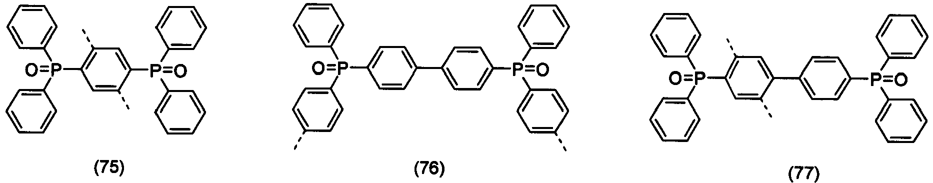 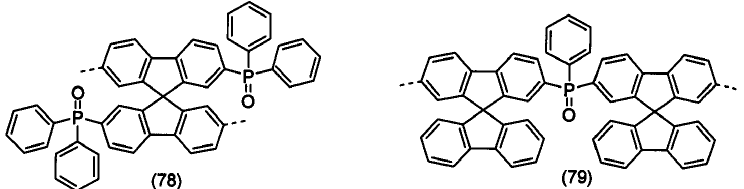 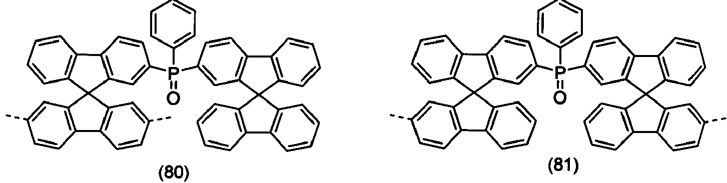 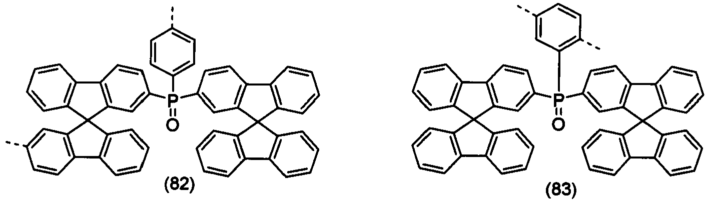 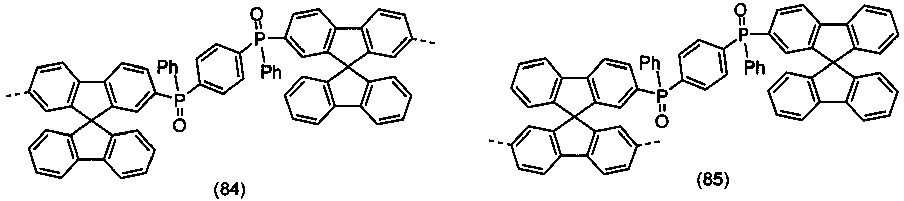 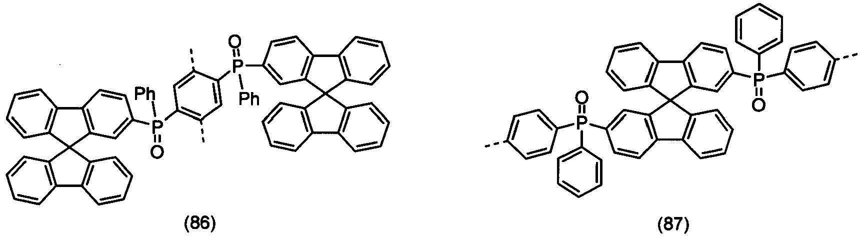 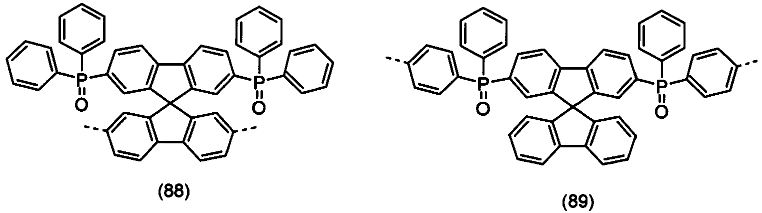 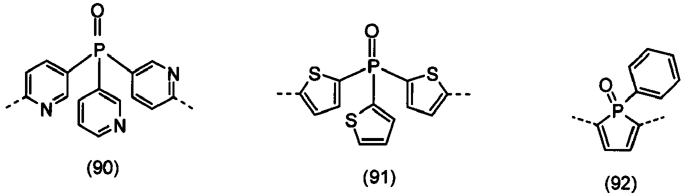 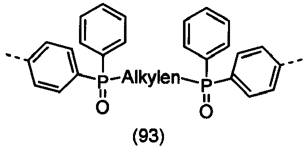 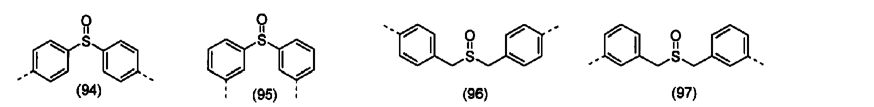 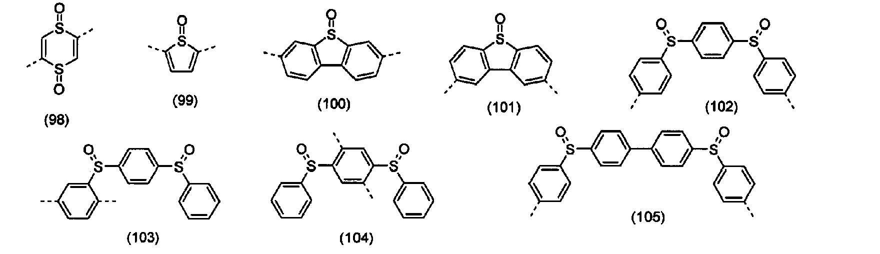 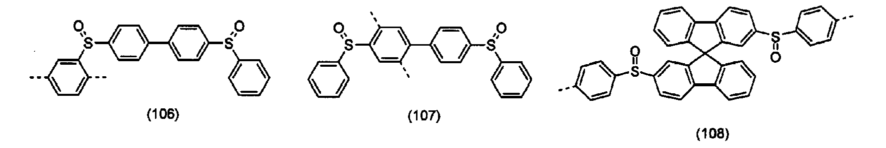 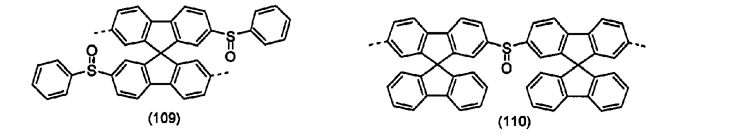 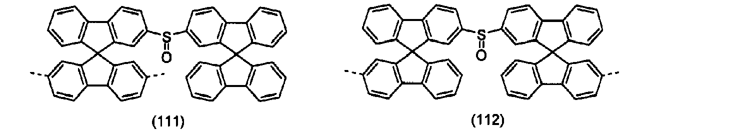 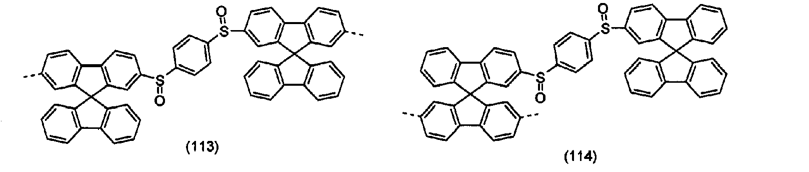 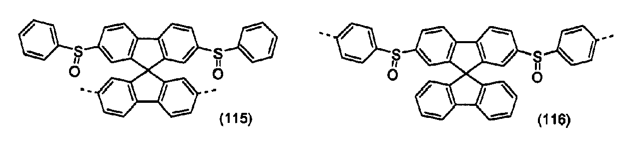 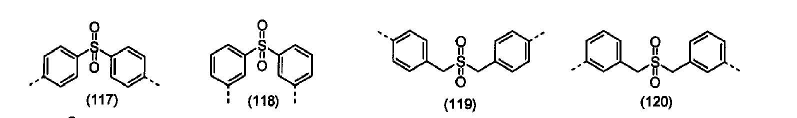 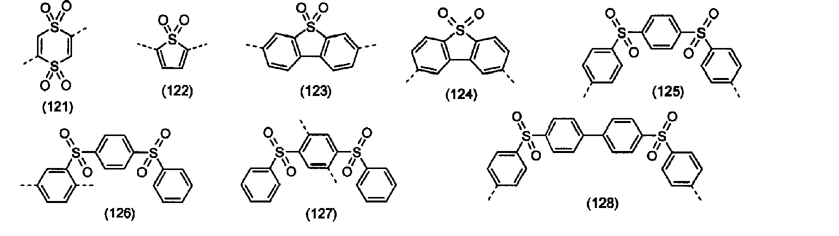 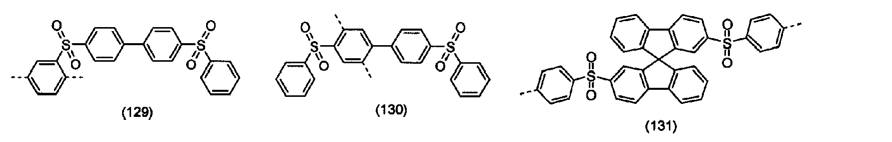 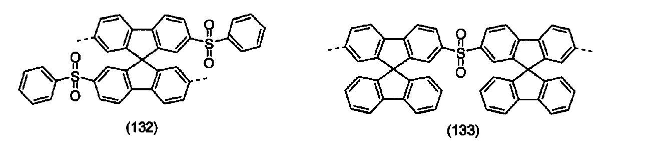 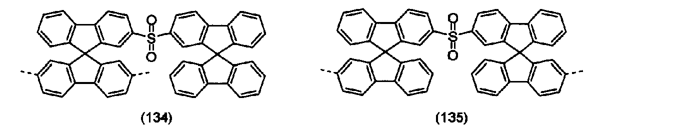 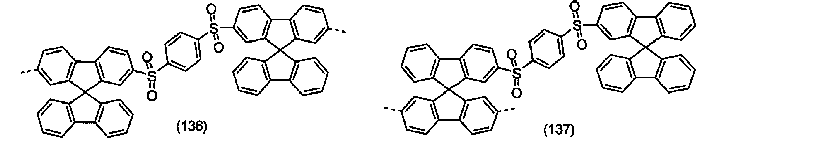 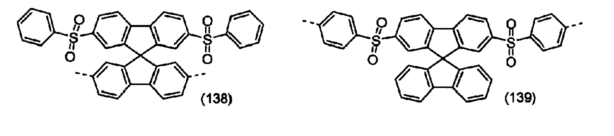 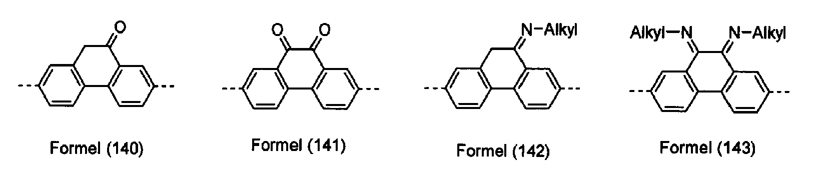 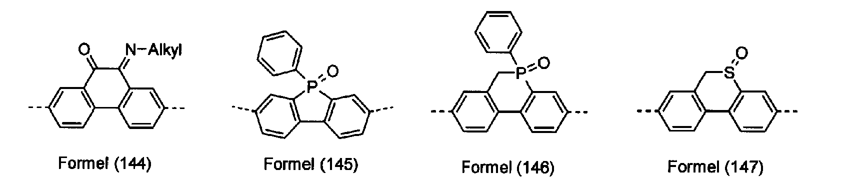 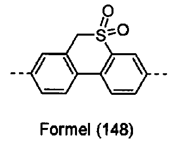 die substituiert oder unsubstituiert sein können.

17. Organische Halbleiter gemäß einem oder mehreren der Ansprüche 1 bis 16, **dadurch gekennzeichnet, dass** den organischen Halbleitern noch weitere Moleküle zugemischt werden, die niedermolekular, oligomer, dendritisch oder polymer sein können.

18. Organische Halbleiter gemäß Anspruch 17, **dadurch gekennzeichnet, dass** der Mischung zusätzlich Verbindungen, die Struktureinheiten L=X, bzw. Struktureinheiten gemäß Formel (1) bis (5) enthalten, zugemischt werden.

19. Organische Halbleiter gemäß einem oder mehreren der Ansprüche 1 bis 18, **dadurch gekennzeichnet, dass** der Gesamtanteil an Struktureinheiten gemäß Formel (1) bis (5) 10 - 50 mol% beträgt.

20. Verwendung eines organischen Halbleiters gemäß einem oder mehreren der Ansprüche 1 bis 19 in organischen Leuchtdioden (PLED), organischen Solarzellen (O-SCs), organischen Laserdioden (O-Laser) oder in der nichtlinearen Optik.

21. Elektronisches Bauteil, welches eine oder mehrere aktive Schichten umfasst, wobei mindestens eine dieser aktiven Schichten einen oder mehrere organische Halbleiter gemäß einem oder mehreren der Ansprüche 1 bis 19 enthält.

22. Elektronisches Bauteil gemäß Anspruch 21, **dadurch gekennzeichnet, dass** es sich um eine organische Leuchtdiode, eine organische Solarzelle oder eine organische Laserdiode handelt.

## Claims

1. Organic semiconductors comprising
(A) at least one conjugated, partially conjugated or cross-conjugated polymer,
(B) at least one structural unit L=X, where the following applies to the symbols used:
L is on each occurrence, identically or differently, (R¹)(R²)C, (R¹)P, (R¹)As, (R¹)Sb, (R¹)Bi, (R¹)(R²)(R³)P, (R¹)(R²)(R³)As, (R¹)(R²)(R³)Sb, (R¹)(R²)(R³)Bi, (R¹)(R²)S, (R¹)(R²)Se, (R¹)(R²)Te, (R¹)(R²)S(=O), (R¹)(R²)Se(=O) or (R¹)(R ²)Te(=O);
X is on each occurrence, identically or differently, O, S, Se or N-R⁴, with the proviso that X is not S or Se if L stands for S, Se or Te;
R¹, R², R³ are on each occurrence, identically or differently, H, F, CN, N(R⁴)₂, a straight-chain, branched or cyclic alkyl, alkoxy or thioalkoxy group having 1 to 40 C atoms, which may be substituted by R⁵ or also unsubstituted, where one or more non-adjacent CH2 groups may be replaced by -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- or -CONR⁶- and where one or more H atoms may be replaced by F, Cl, Br, I, CN or NO₂, or an aromatic or heteroaromatic ring system having 1 to 40 C atoms, which may be substituted by one or more radicals R⁵, where two or more substituents R¹, R² and/or R³ may also with one another form a mono- or polycyclic, aliphatic or aromatic ring system; all substituents R¹ to R³ on one structural unit here must not be H or F; the groups R¹ to R³ may furthermore optionally have bonds to the polymer;
R⁴ is on each occurrence, identically or differently, a straight-chain, branched or cyclic alkyl or alkoxy chain having 1 to 22 C atoms, in which, in addition, one or more non-adjacent C atoms may be replaced by -R⁶C=CR⁶, -C≡C-, Si(R⁶)₂, Ge(R⁶)₂, Sn(R⁶)₂, -NR⁶-, -O-, -S-, -CO-O-, -O-CO-O-, where, in addition, one or more H atoms may be replaced by fluorine, an aryl, heteroaryl or aryloxy group having 1 to 40 C atoms, which may also be substituted by one or more radicals R⁶, or OH or N(R⁵)₂;
R⁵ is on each occurrence, identically or differently, R⁴ or CN, B(R⁶)₂ or Si(R⁶)₃,
R⁶ is on each occurrence, identically or differently, H or an aliphatic or aromatic hydrocarbon radical having 1 to 20 C atoms;
and
(C) at least one triplet emitter which contains an lr metal;
with the proviso that mixtures of two polymers in which the first polymer contains covalently bonded triplet emitters and the other is a copolymer containing TPD units and diphenyl sulfone ether or diphenyl ketone ether units are excluded; and furthermore with the proviso that polymers containing on the one hand covalently bonded triplet emitters and on the other hand units of the formula (a) are excluded from the invention: 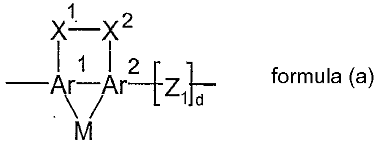
in which Ar¹ and Ar² each independently denote a tetravalent aromatic hydrocarbon group or a tetravalent heterocyclic group;
one of the units X¹ and X² denotes C(=O) or C(R¹)(R²) and the other denotes O, S, C(=O), S(=O), SO₂, Si(R³)(R⁴), N(R⁵), B(R⁶), P(R⁷) or P(=O)(R⁸);
where the radicals R¹, R², R³, R⁴, R⁵, R⁶, R⁷ and R⁸ in the formula (a) each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group,
M denotes a group which is represented by formula (b), formula (c) or formula (d);
-Y¹-Y²- formula (b)
in which Y¹ and Y² each independently denote O, S, C(=O), S(=O), SO₂, C(R⁹)(R¹⁰), Si(R¹¹)(R¹²), N(R¹³), B(R¹⁴), P(R¹⁵) or P(=O)(R¹⁶), where the radicals R⁹, R¹⁰, R¹¹, R¹², R¹³, R¹⁴, R¹⁵ and R¹⁶ in the formula (b) each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group,
where Y¹ and Y² are not identical if Y¹ is not C(R⁹)(R¹⁰) or Si(R¹¹)(R¹²);
-Y³=Y⁴- formula (c)
in which Y³ and Y⁴ each independently denote N, B, P, C(R¹⁷) or Si(R¹⁸);
the radicals R¹⁷ and R¹⁸ in the formula (c) each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;
-Y⁵- formula (d)
in which Y⁵ denotes O, S, C(=O), S(=O), SO₂, C(R¹⁹)(R²⁰), Si(R²¹)(R²²), N(R²³), B(R²⁴), P(R²⁵) or P(=O)(R²⁶);
where the radicals R¹⁹, R²⁰ , R²¹, R²², R²³, R²⁴, R²⁵ and R²⁶ in the formula (d) each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;
Z₁ denotes -CR³⁶=CR³⁷- or -C≡C-; R³⁶ and R³⁷ each independently denote a hydrogen atom, an alkyl group, an aryl group, a monovalent heterocyclic group or a cyano group;
d denotes 0 or 1.

2. Organic semiconductors according to Claim 1, **characterised in that** the structural units L=X are selected from the formulae (1) to (5) 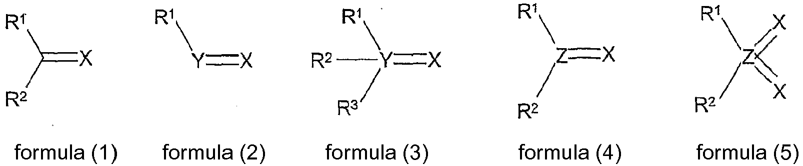 where the symbols used have the following meaning:
X is on each occurrence, identically or differently, O, S, Se or N-R⁴, with the proviso that X cannot be S or Se for formulae (4) and (5);
Y is on each occurrence, identically or differently, P, As, Sb or Bi;
Z is on each occurrence, identically or differently, S, Se or Te;
R¹ to R⁶ have the same meaning as described under Claim 1.

3. Organic semiconductors according to Claim 1 and/or Claim 2, **characterised in that** they comprise at least 0.5% by weight of at least one conjugated, partially conjugated or cross-conjugated polymer, at least 1% by weight of at least one structural unit L=X or a structural unit of the formulae (1) to (5) and at least 0.1% by weight of at least one triplet emitter which contains an lr metal.

4. Mixtures (BLEND1) according to one or more of Claims 1 to 3, comprising
(A) 5 - 99.9% by weight of at least one conjugated, partially conjugated or cross-conjugated polymer (POLY1) which contains 1 - 100 mol% of one or more recurring units (MONO1) containing at least one structural unit L=X or at least one structural unit of the formulae (1) to (5),
and
(B) 0.1 - 95% by weight of one or more triplet emitters which contain an lr metal (TRIP1).

5. Mixtures (BLEND2) according to one or more of Claims 1 to 3, comprising
(A) 0.5 - 99% by weight of at least one conjugated, partially conjugated or cross-conjugated polymer (POLY2) which contains 0.5 - 99.5 mol% of one or more triplet emitters which contain an lr metal (TRIP2), covalently bonded,
and
(B) 1 - 99.5% by weight of at least one compound (COMP1) which contains at least one structural unit L=X or at least one structural unit of the formulae (1) to (5) and is capable of forming glass-like layers at room temperature.

6. Mixtures (BLEND3) according to one or more of Claims 1 to 3, comprising
(A) 0.5 - 98.9% by weight of a conjugated, partially conjugated or cross-conjugated polymer (POLY3),
and
(B) 1 - 99% by weight of at least one compound (COMP1) which contains at least one structural unit L=X or at least one structural unit of the formulae (1) to (5) and is capable of forming glass-like layers at room temperature,
and
(C) 0.1 - 95% by weight of one or more triplet emitters which contain an lr metal (TRIP1).

7. Mixtures (BLEND4) according to one or more of Claims 1 to 3, comprising
(A) 0.5 - 99% by weight of at least one conjugated, partially conjugated or cross-conjugated polymer (POLY3);
and
(B) 1 - 99.5% by weight of a compound (TRIP3) which contains at least one structural unit L=X or at least one structural unit of the formulae (1) to (5) covalently bonded to one or more triplet emitters which contain an lr metal, where the bonding between the triplet emitter and the structural unit L=X can take place in any desired positions of the two units, with the restriction that at least one group X in (TRIP3) must be in free form and not coordinated to a metal atom.

8. Conjugated, partially conjugated or cross-conjugated polymers POLY4 containing
(A) 1 - 99.9 mol% of one or more recurring units MONO1 containing at least one structural unit L=X, where symbols L, X, R¹, R², R³, R⁴, R⁵ and R⁶ have the same meaning as described under Claim 1;
(B) 0.1 - 95 mol% of one or more triplet emitters which contains an lr metal TRIP2.

9. Organic semiconductors according to one or more of Claims 1 to 8, **characterised in that** the polymers POLY1 to POLY4 contain further structural elements.

10. Organic semiconductors according to one or more of Claims 1 to 9, **characterised in that** the following applies to the symbols of the formulae (1) to (5):
X stands for O, S or N-R⁴;
Y stands for P or As;
Z stands for S or Se;
R¹ - R⁶ are defined according to Claim 1 and 2, where at least one of the substituents R¹ to R³ on each structural unit of the formulae (1) to (5) represents an aromatic or heteroaromatic ring system having 1 to 40 C atoms, which may be substituted by one or more substituents R⁴ or unsubstituted.

11. Organic semiconductors according to Claim 10, **characterised in that** the following applies to the symbols of the formulae (1) to (5):
X stands for O or N-R⁴;
Y stands for P;
Z stands for S;
R¹ - R⁶ are defined according to Claim 1 and 2, where all substituents R¹ to R³ on each structural unit of the formulae (1) to (5) represent an aromatic or heteroaromatic ring system having 1 to 40 C atoms, which may be substituted by one or more substituents R⁴ or unsubstituted.

12. Organic semiconductors according to one or more of Claims 1 to 11, **characterised in that** at least one of the radicals R¹ to R³ contains a 9,9'-spirobifluorene.

13. Organic semiconductors according to one or more of Claims 1 to 12, **characterised in that** the recurring units (MONO1) which contain structural elements L=X or structural elements of the formulae (1) to (5) are selected from the formulae (6) to (148), 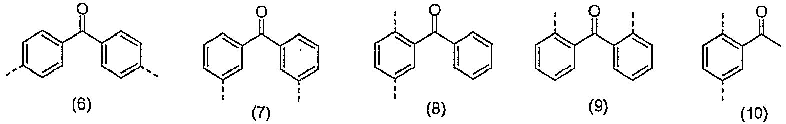 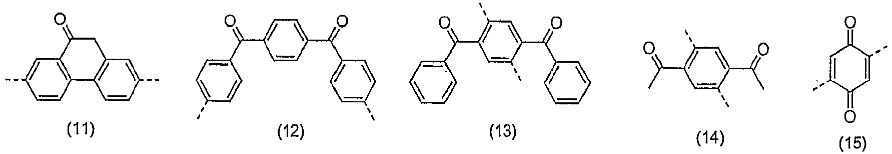 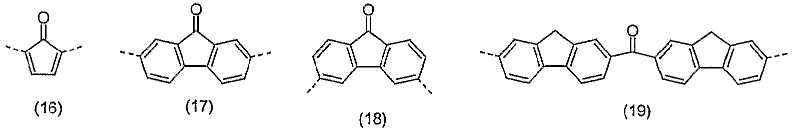 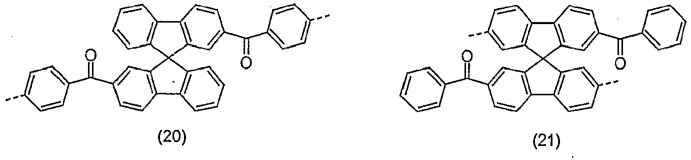 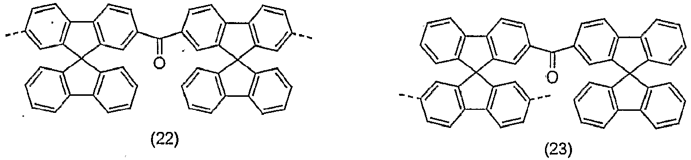 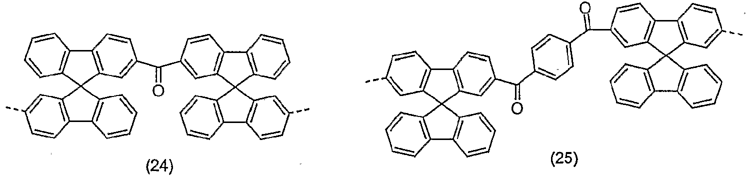 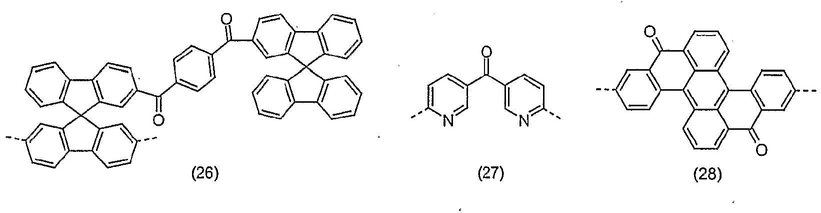 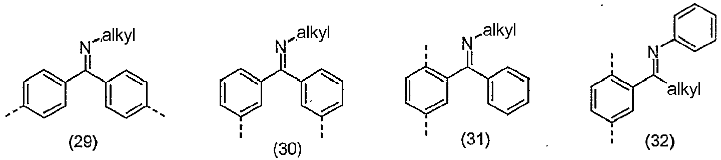 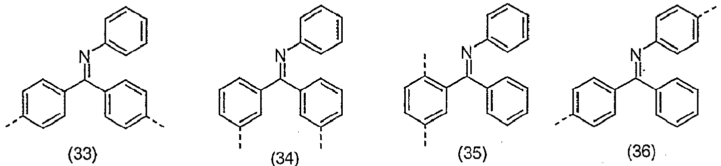 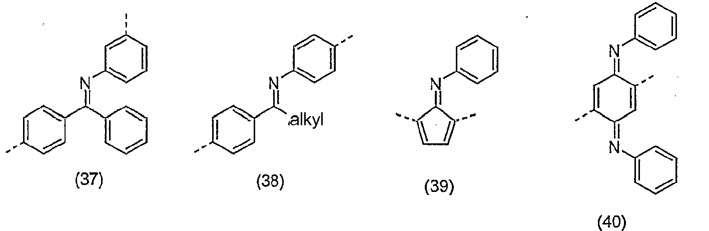 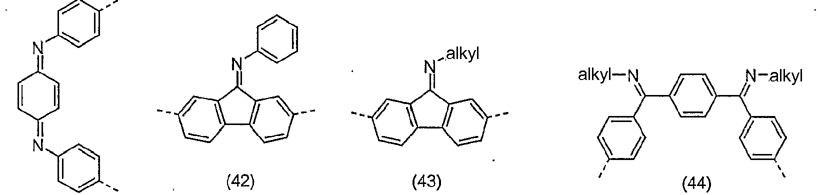 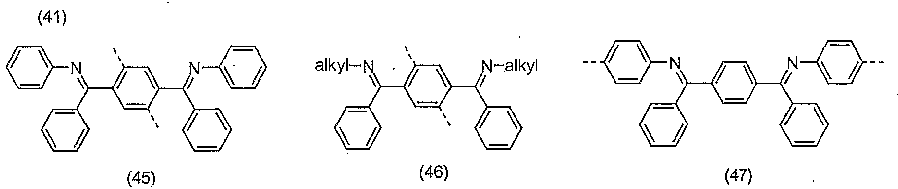 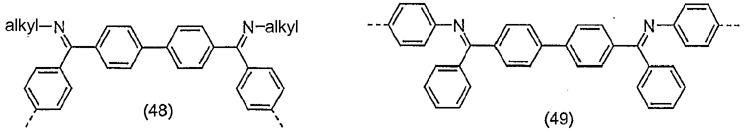 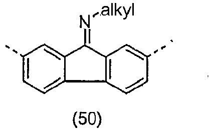 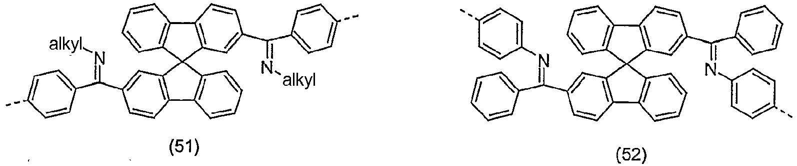 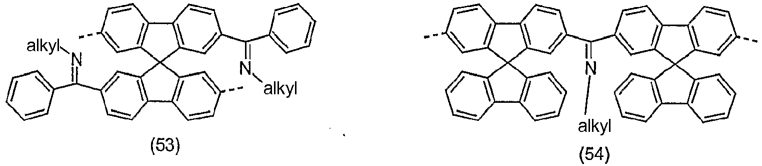 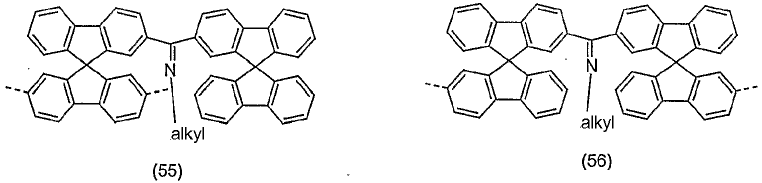 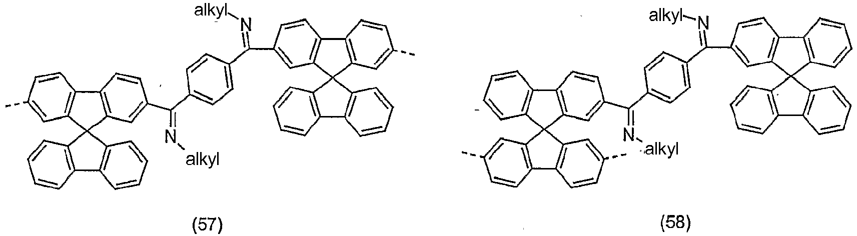 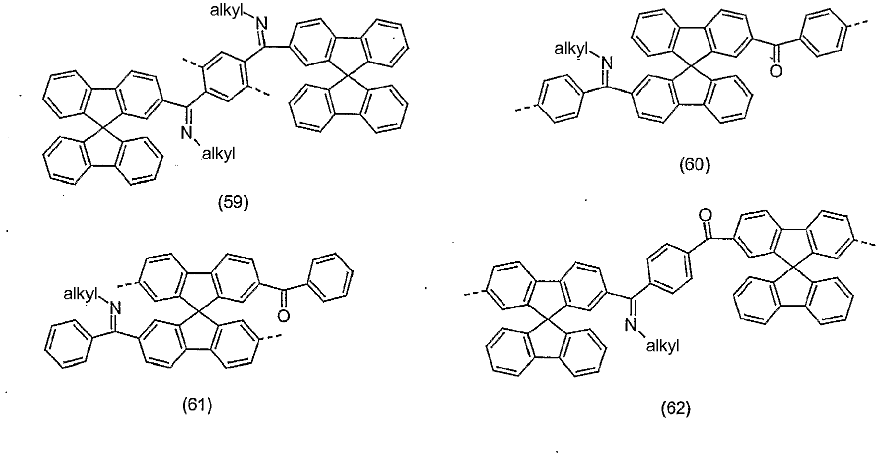 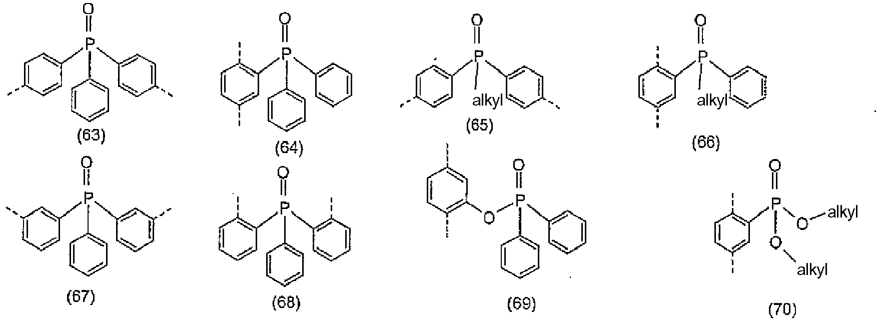 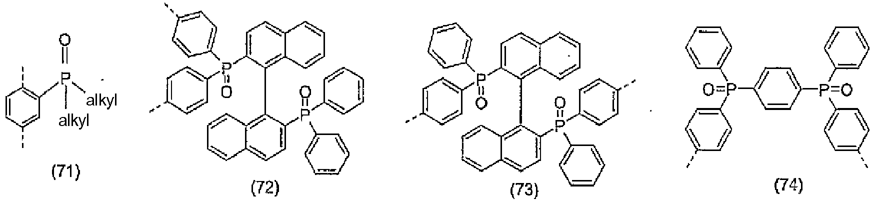 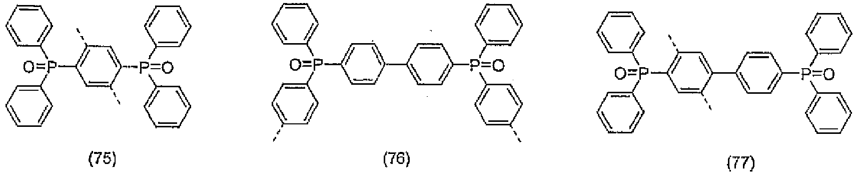 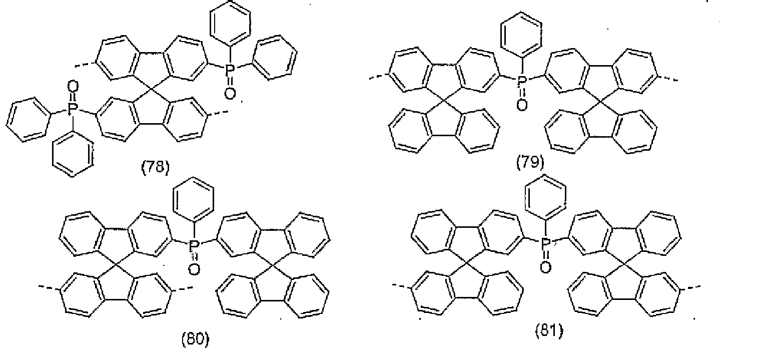 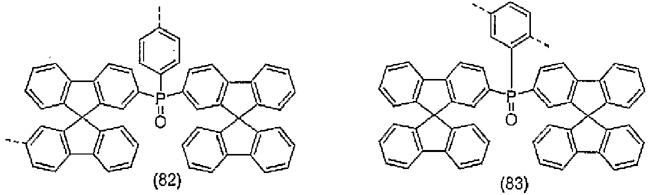 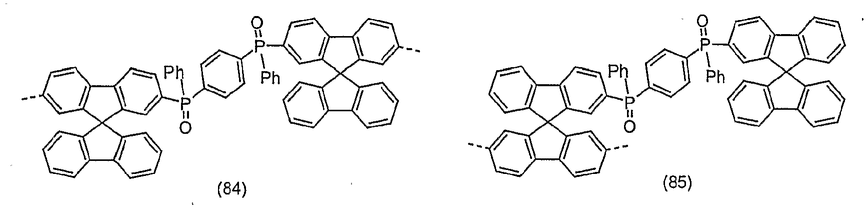 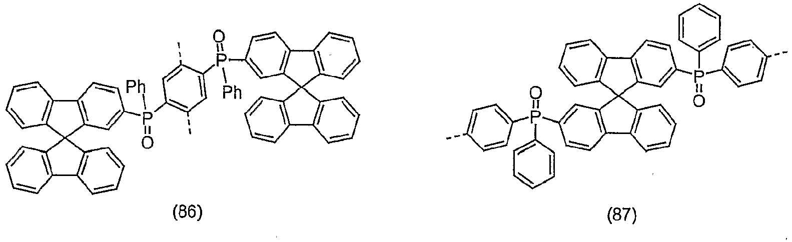 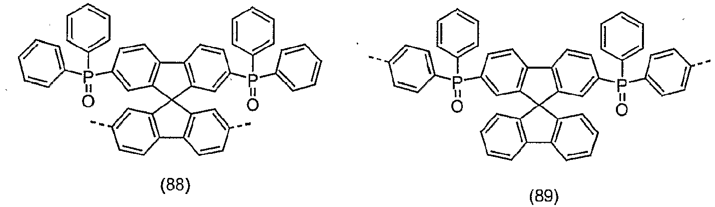 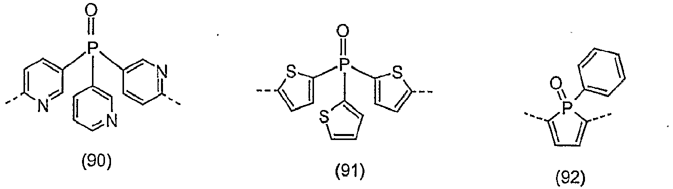 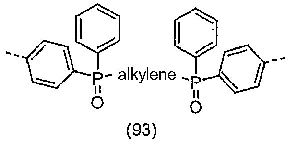 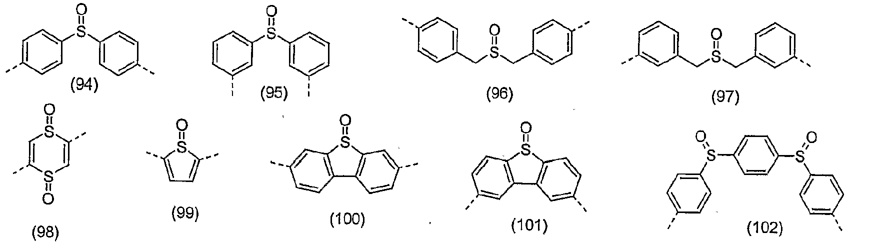 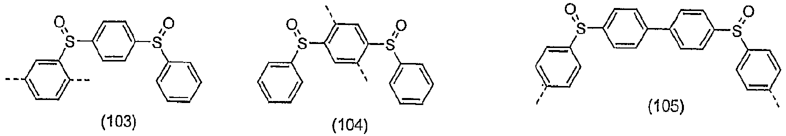 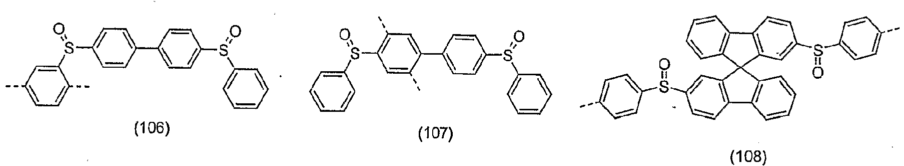 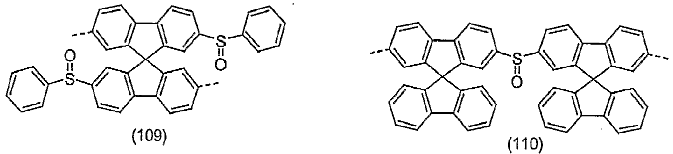 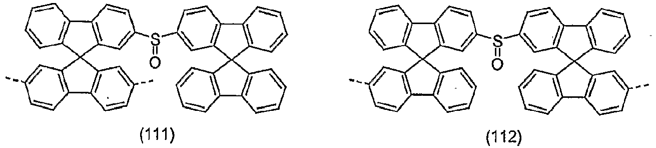 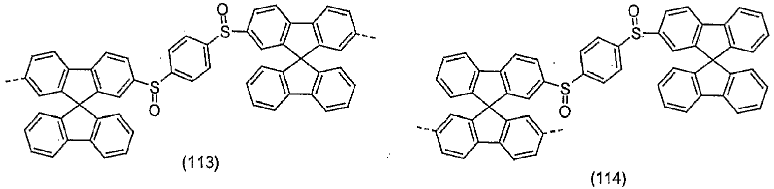 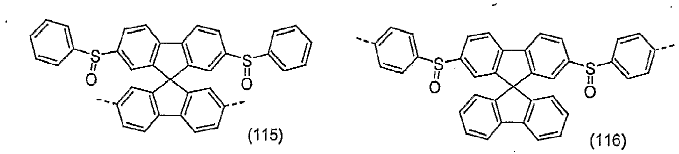 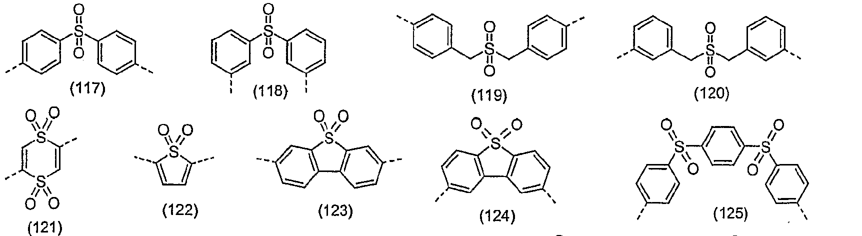 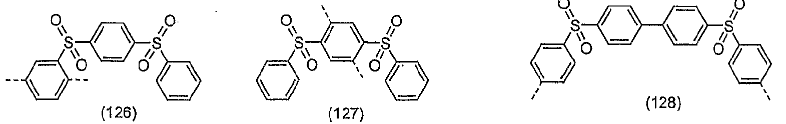 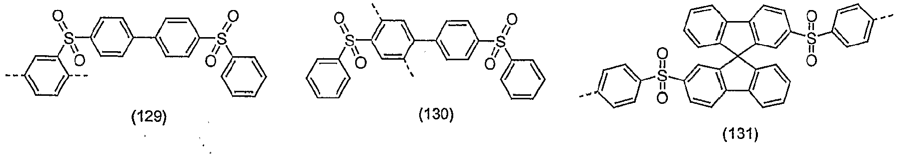 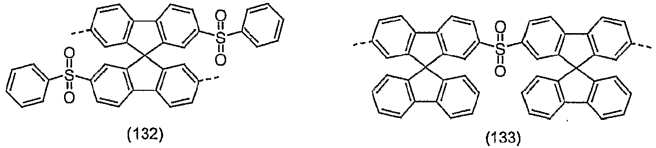 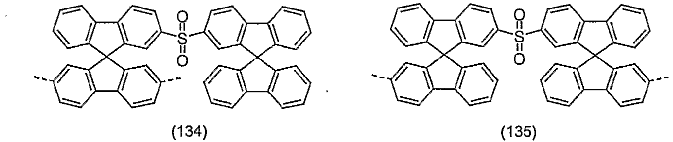 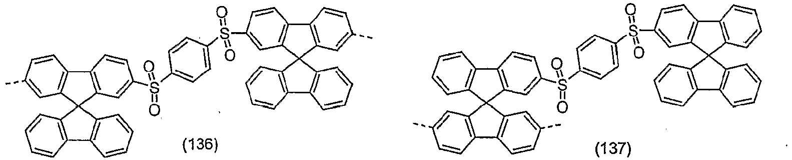 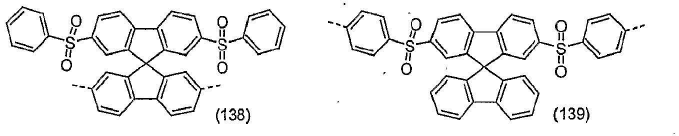 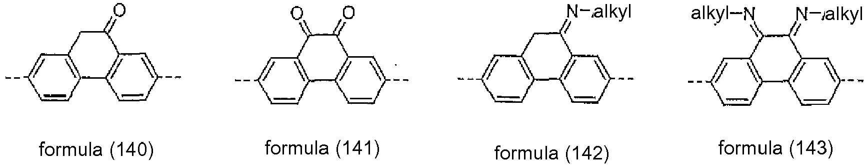 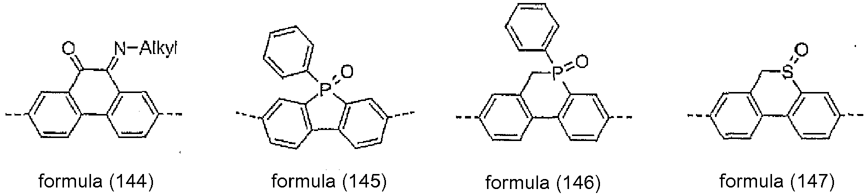 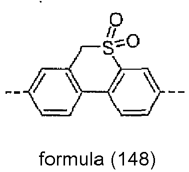 which may be substituted or unsubstituted.

14. Organic semiconductors according to one or more of Claims 1 to 13, **characterised in that** the polymers are selected from the classes of the aromatic polyketones, aromatic polyphosphine oxides or aromatic polysulfones, each of which may also be substituted for better solubility, the polycarboxylic acid derivatives, main-chain polyesters, side-chain polyesters, poly(glycolic acids), poly(lactic acids), poly(ε-caprolactones), polyacrylates, poly(hydroxybenzoic acids), poly-(alkylene terephthalates), polycarboxylic anhydrides, polyamides, poly(ε-caprolactams), polypeptides, polyaramids, polybenzamides, polyimides, poly(amide-imides), poly(ester-imides), poly(ether-imides), polycarbonates, poly(ester-co-carbonates), poly(isocyanurates), polyurethanes, polyester-polyurethanes, poly(terephthalates), poly(acrylates), poly(phenyl acrylates), poly(cyanoacrylates), poly(vinyl esters), poly(vinyl acetates), side-chain polyphosphine oxides, polyether ketones (PEK), polyether sulfones, polysulfonamides, polysulfonimides, poly(vinyl ketones), aromatic polyvinyl ketones, substituted or unsubstituted poly(vinylbenzophenones), polystyrene-analogous ketones, polycarbazenes, polynitriles, polyisonitriles, polystyrene, PVK (polyvinylcarbazole) or derivatives thereof.

15. Organic semiconductors according to one or more of Claims 1 to 12, **characterised in that** the compound (COMP1) which contains structural elements L=X or structural elements of the formulae (1) to (5) is selected from the formulae (6) to (148), 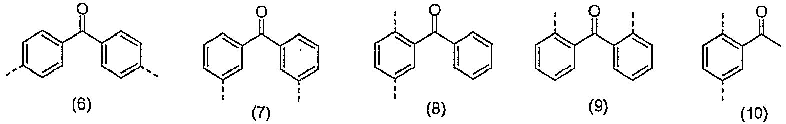 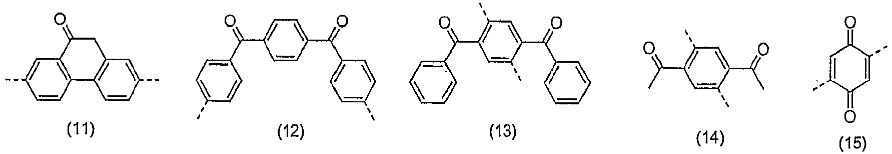 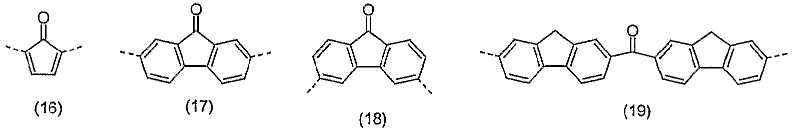 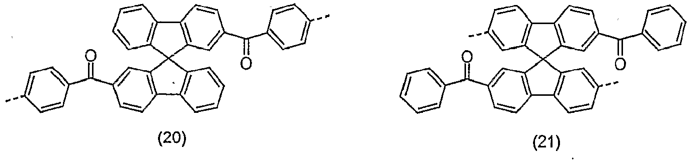 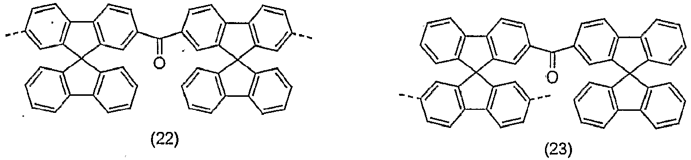 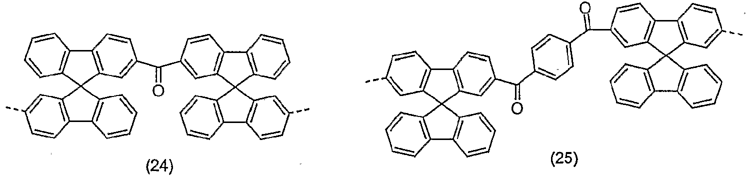 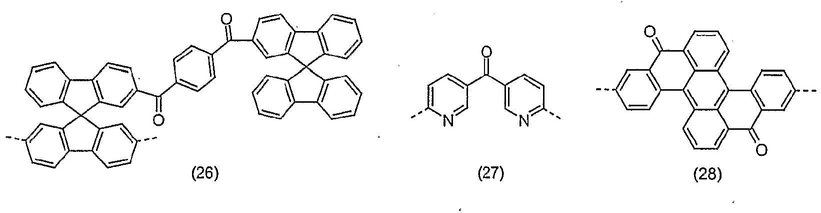 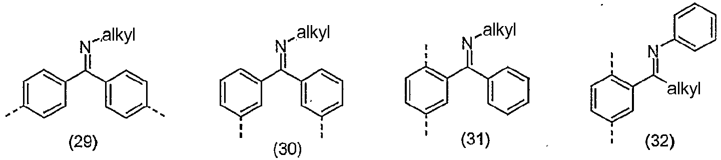 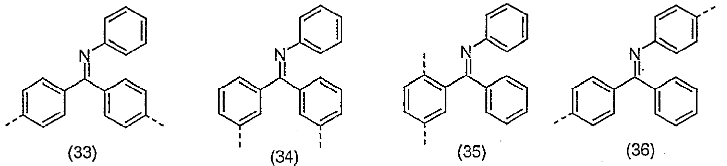 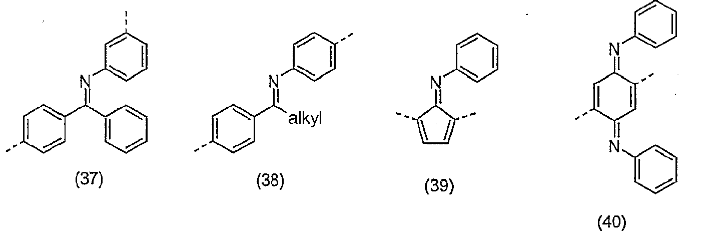 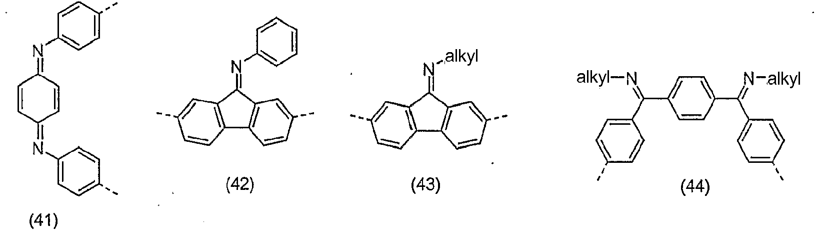 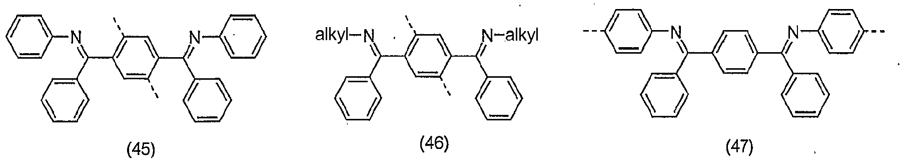 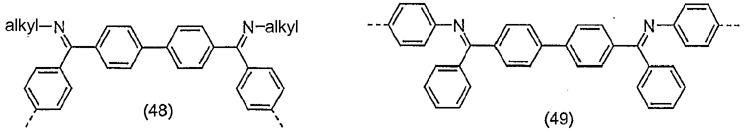 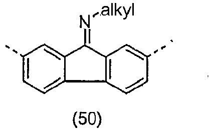 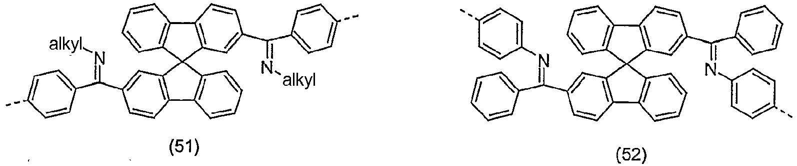 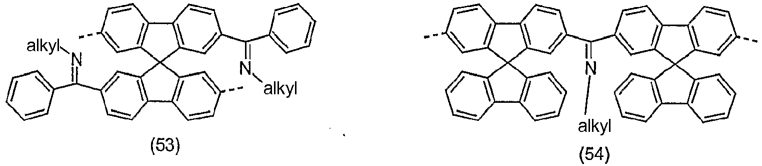 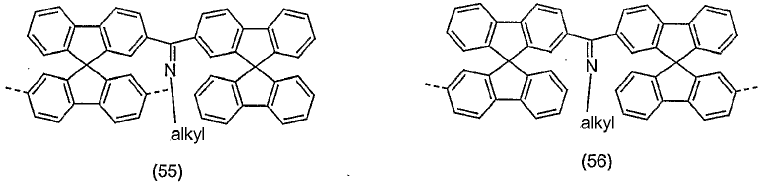 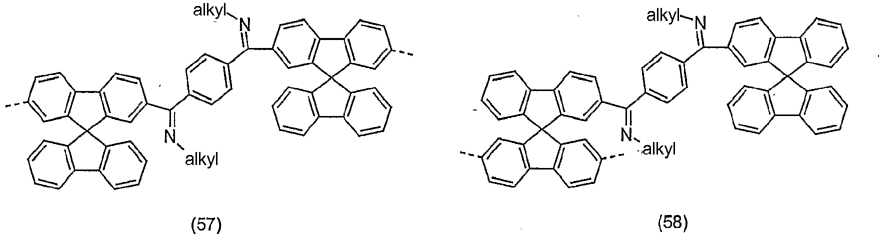 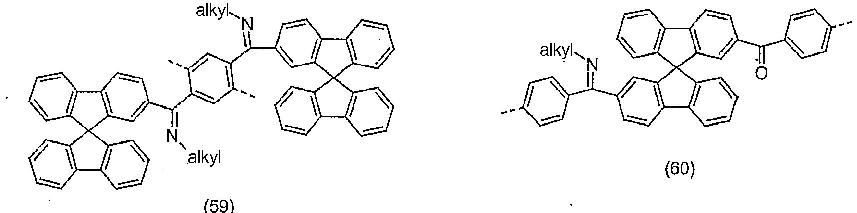 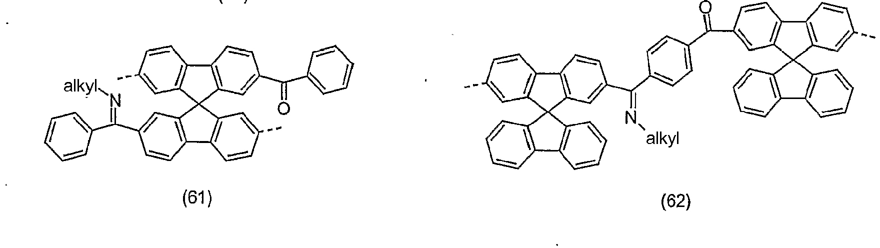 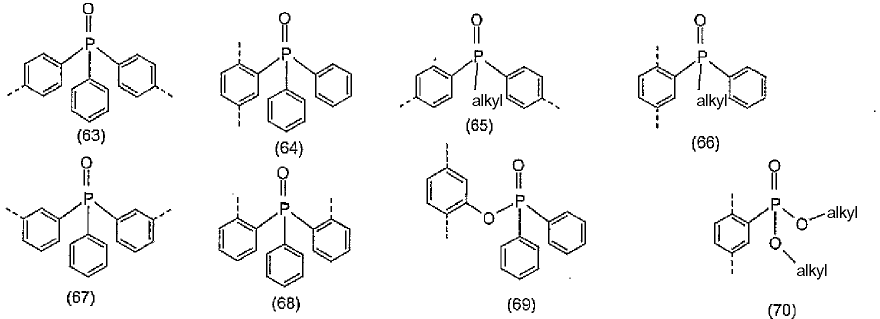 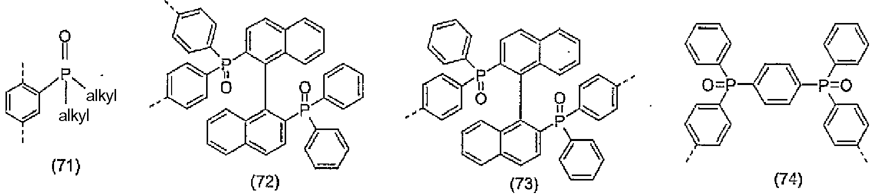 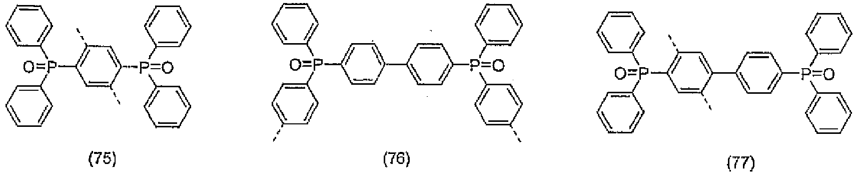 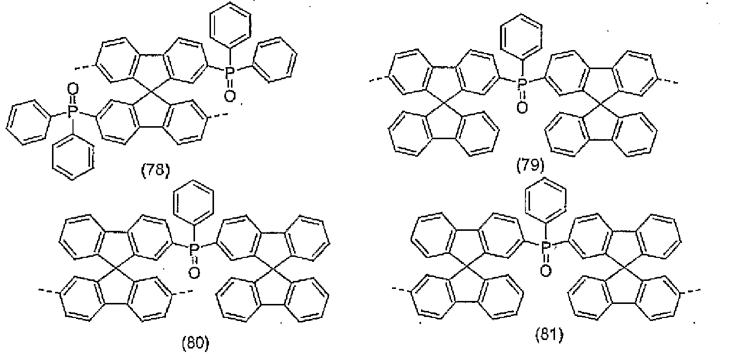 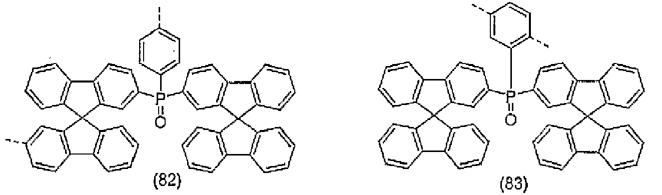 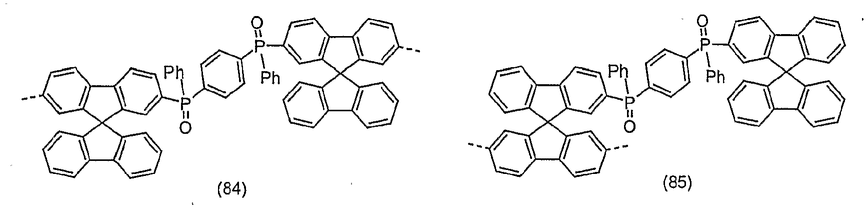 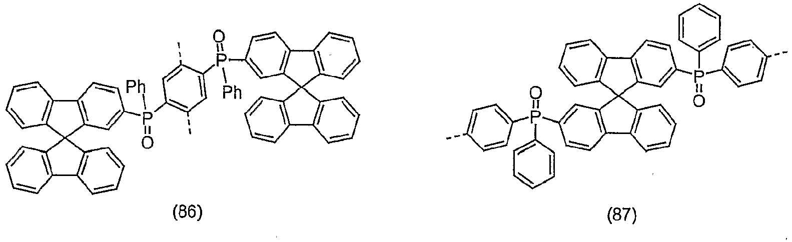 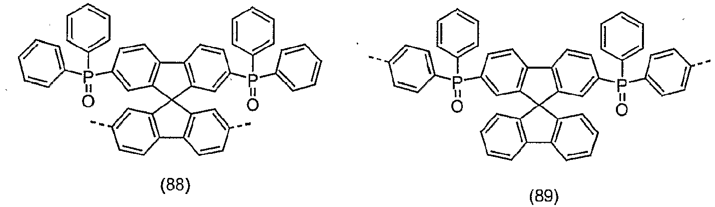 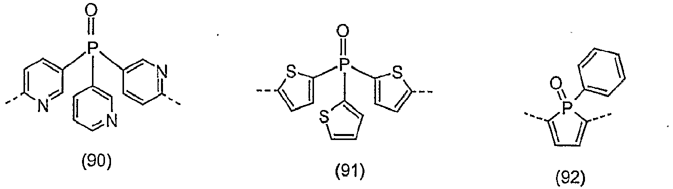 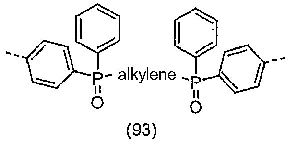 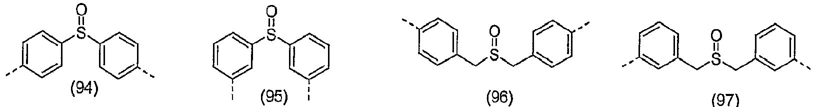 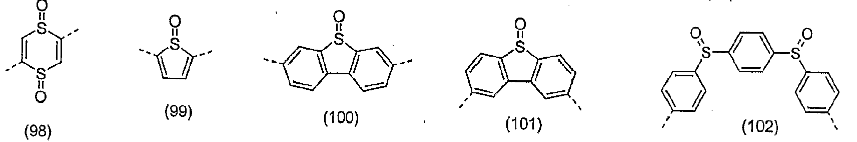 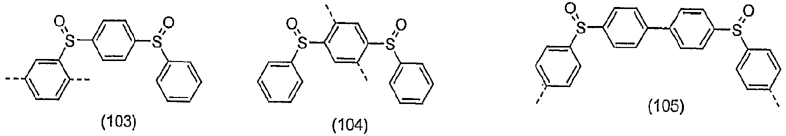 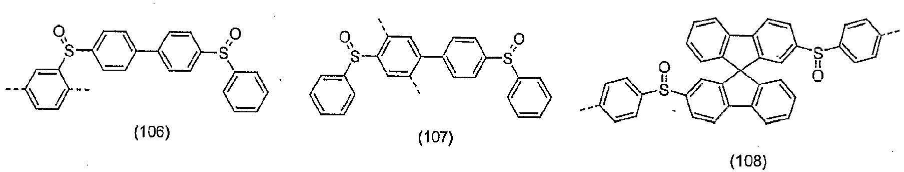 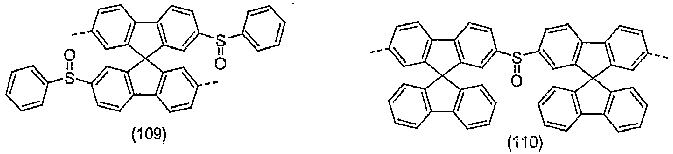 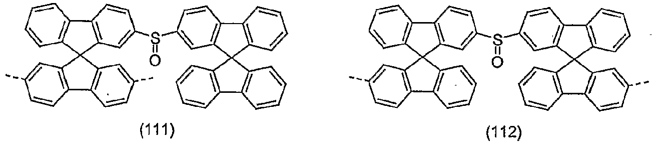 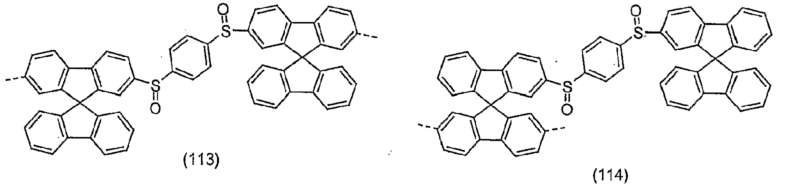 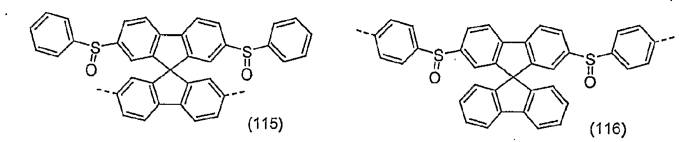 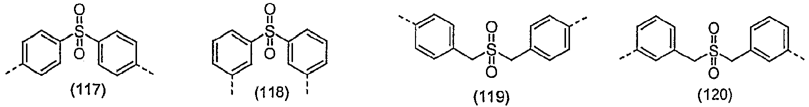 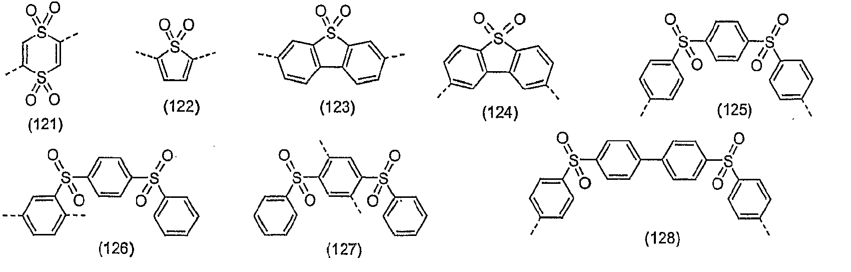 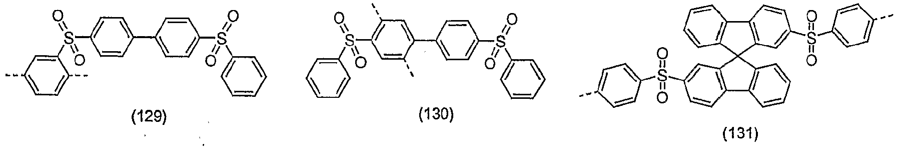 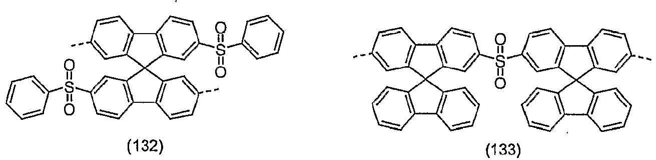 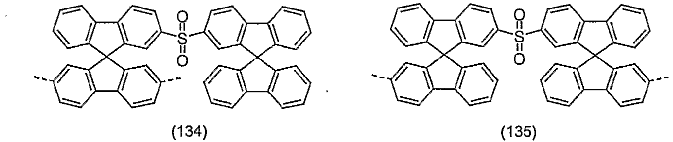 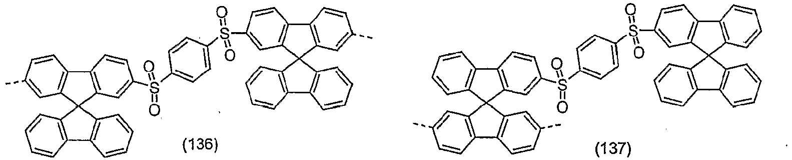 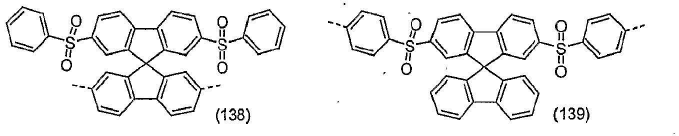 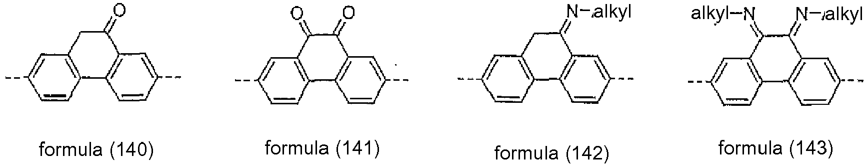 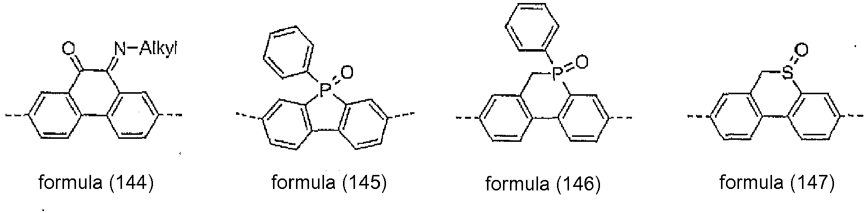 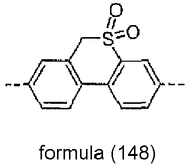 which may be substituted or unsubstituted.

16. Organic semiconductors according to one or more of Claims 1 to 12, **characterised in that** the compound (TRIP3) contains structural elements which are selected from the formulae (6) to (148), 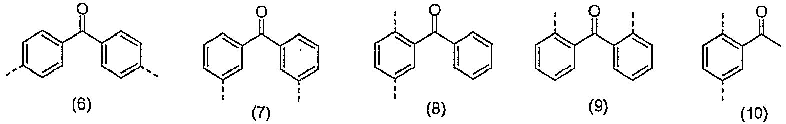 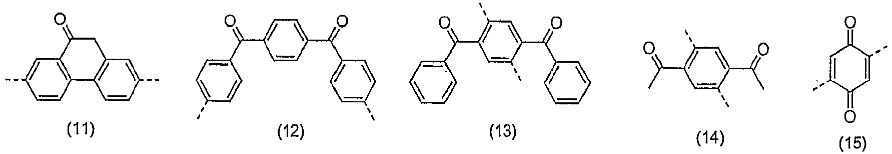 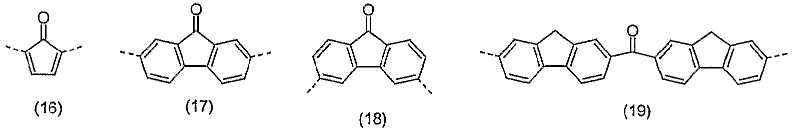 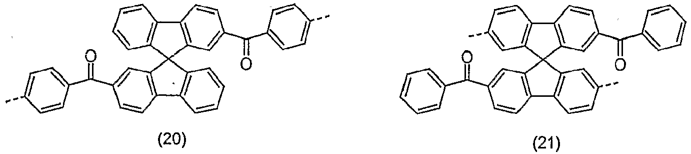 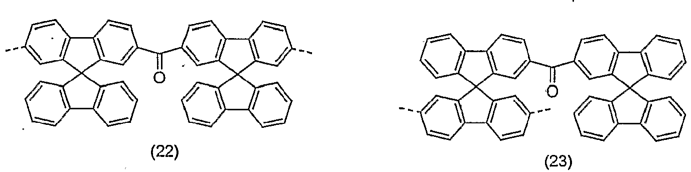 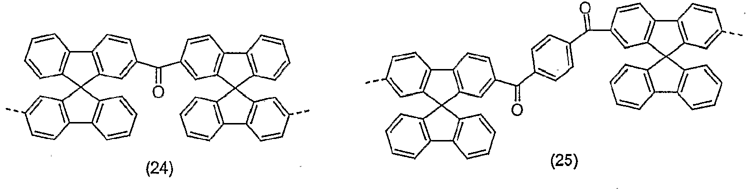 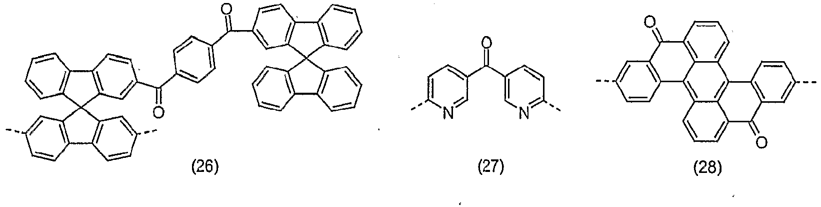 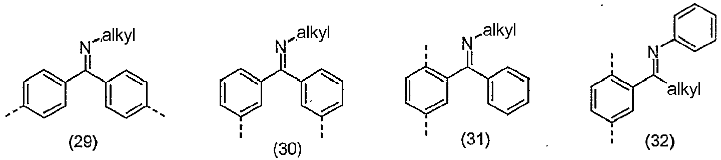 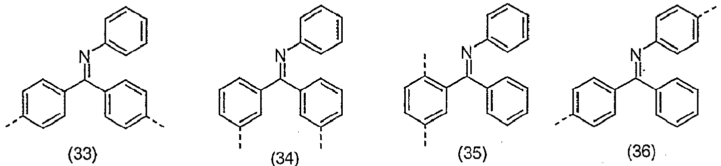 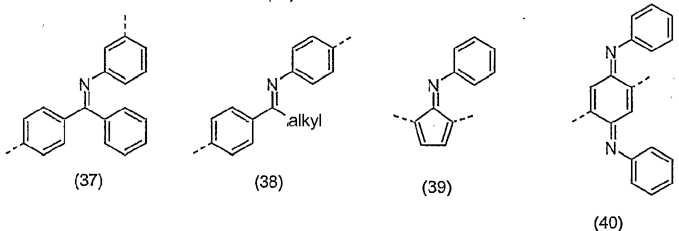 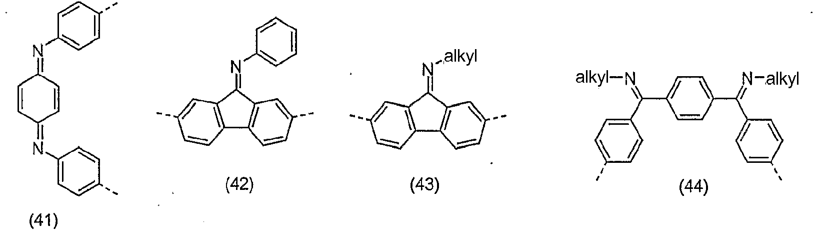 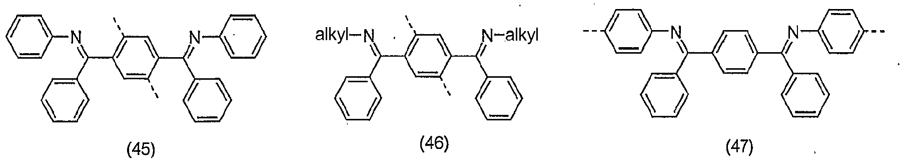 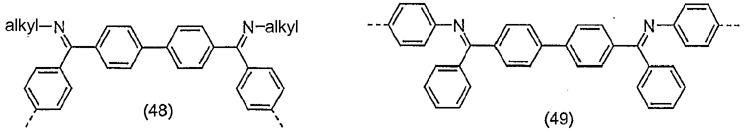 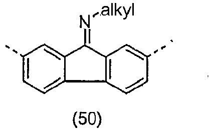 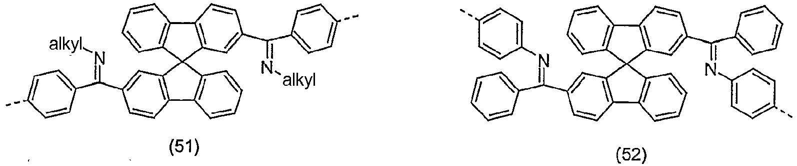 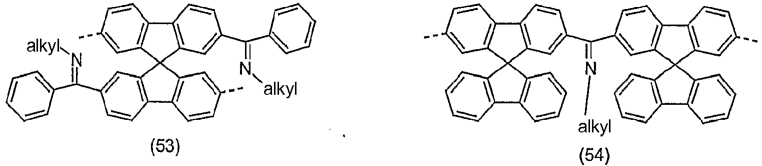 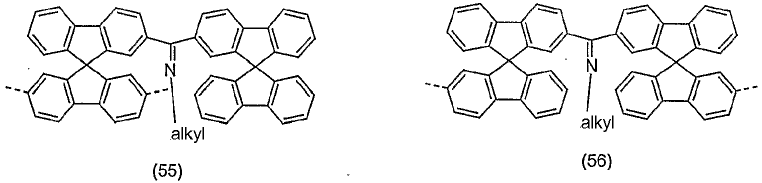 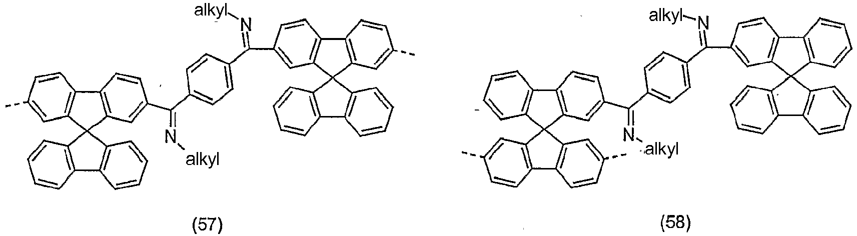 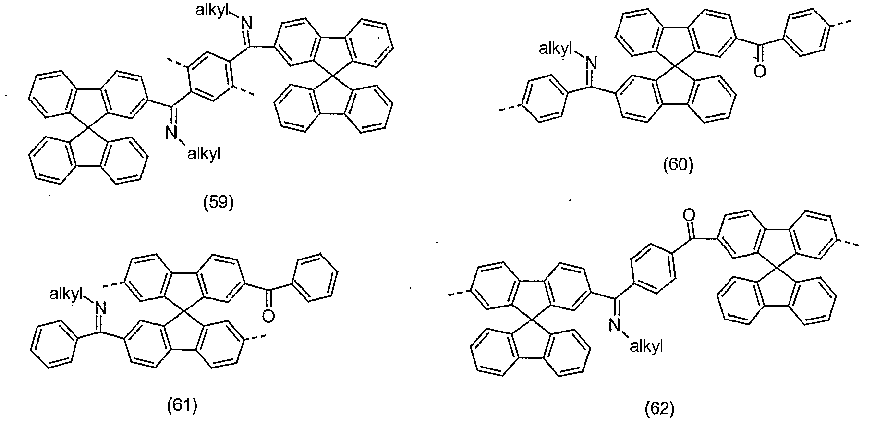 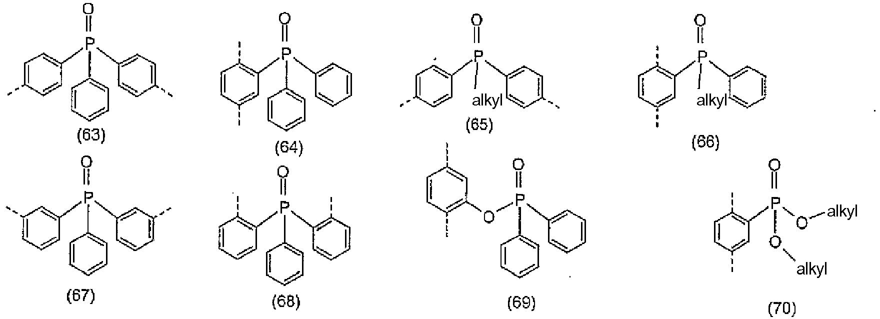 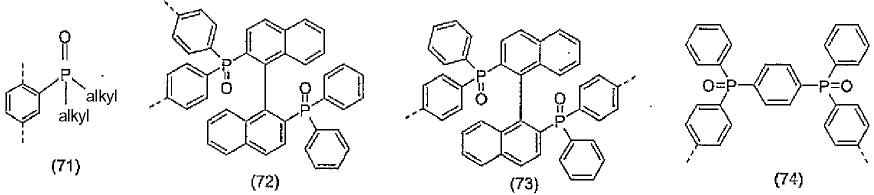 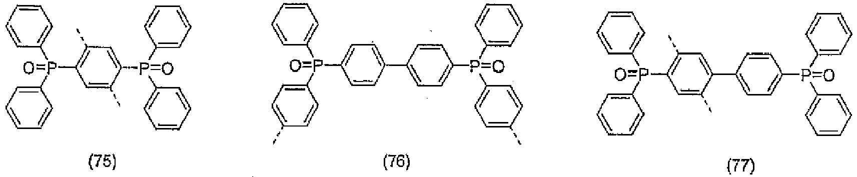 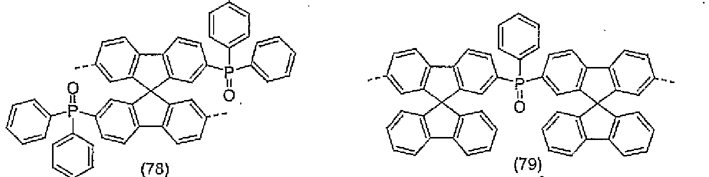 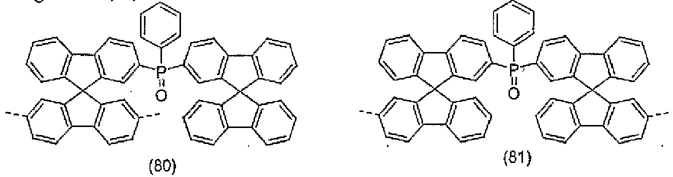 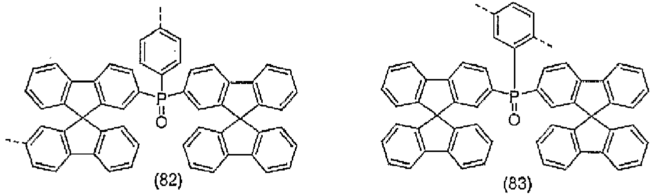 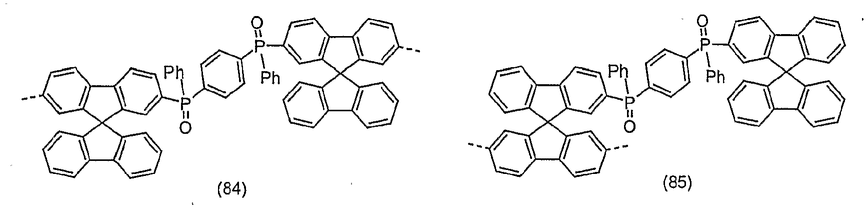 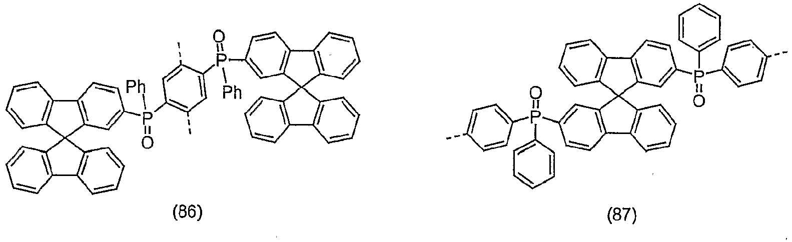 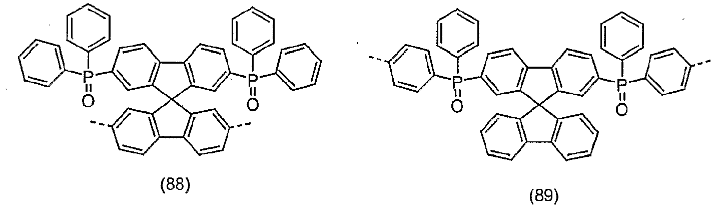 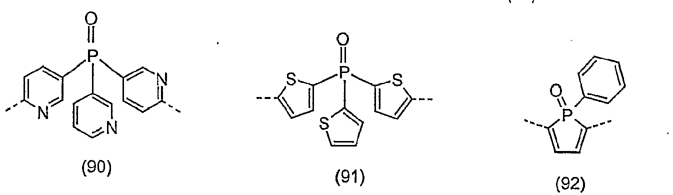 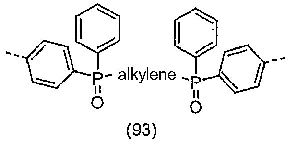 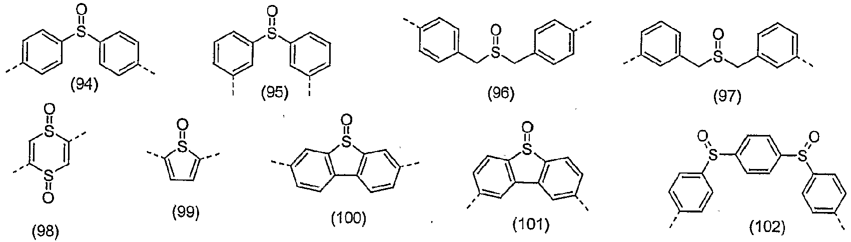 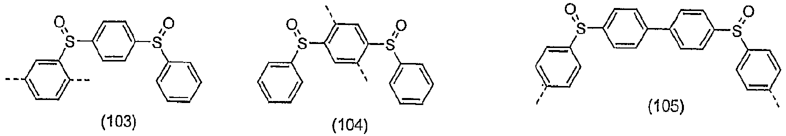 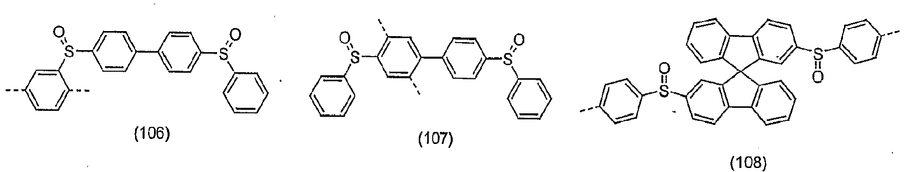 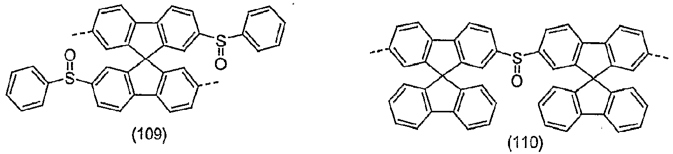 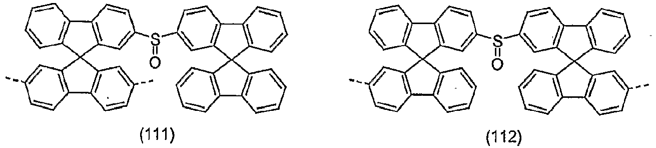 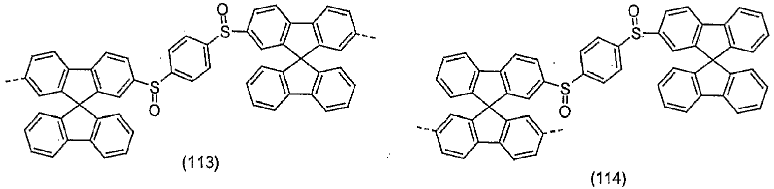 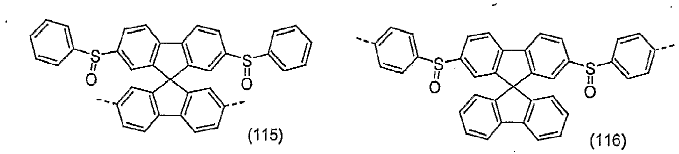 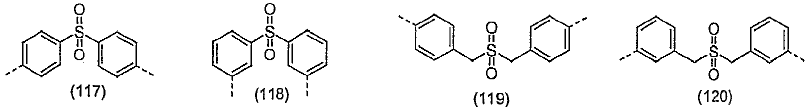 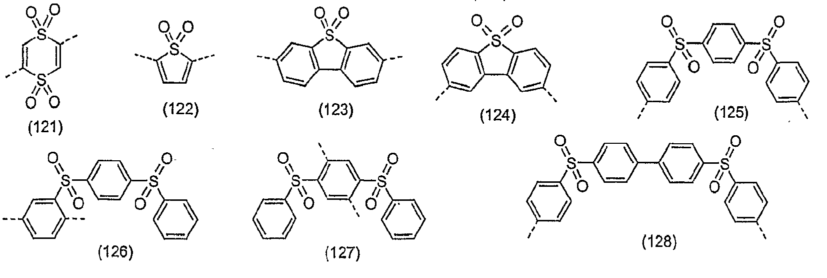 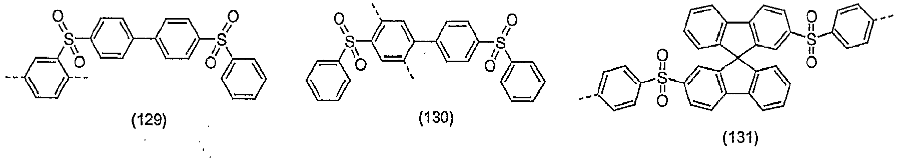 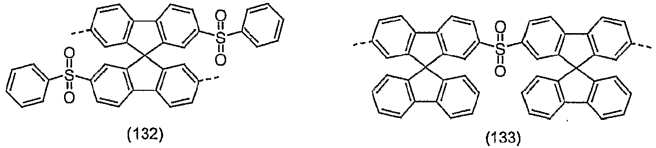 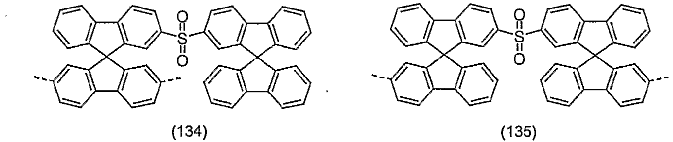 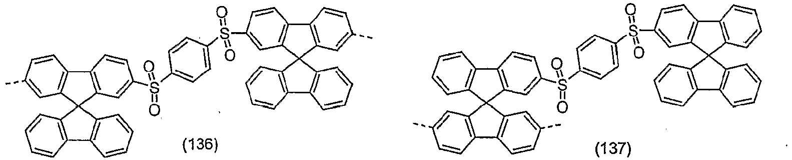 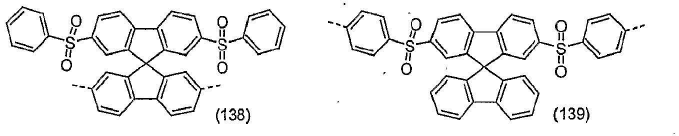 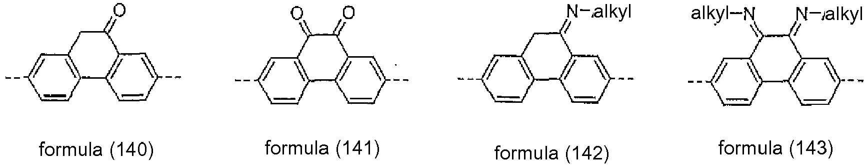 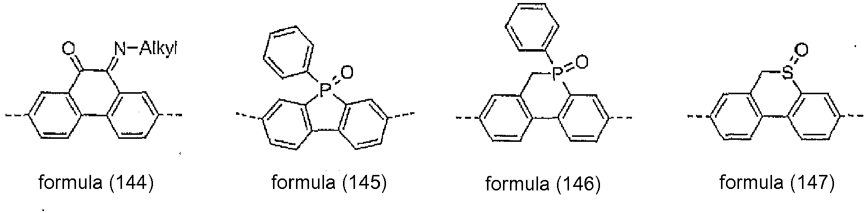 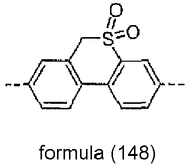 which may be substituted or unsubstituted.

17. Organic semiconductors according to one or more of Claims 1 to 16, **characterised in that** further molecules, which may be of low molecular weight, oligomeric, dendritic or polymeric, are also admixed with the organic semiconductors.

18. Organic semiconductors according to Claim 17, **characterised in that** compounds containing structural units L=X or structural units of the formulae (1) to (5) are additionally admixed with the mixture.

19. Organic semiconductors according to one or more of Claims 1 to 18, **characterised in that** the total proportion of structural units of the formulae (1) to (5) is 10 - 50 mol%.

20. Use of an organic semiconductor according to one or more of Claims 1 to 19 in organic light-emitting diodes (PLEDs), organic solar cells (O-SCs), organic laser diodes (O-lasers) or in non-linear optics.

21. Electronic component which comprises one or more active layers, where at least one of these active layers comprises one or more organic semiconductors according to one or more of Claims 1 to 19.

22. Electronic component according to Claim 21, **characterised in that** it is an organic light-emitting diode, an organic solar cell or an organic laser diode.

## Revendications

1. Semiconducteurs organiques comprenant :
(A) au moins un polymère conjugué, partiellement conjugué ou inter-conjugué ;
(B) au moins une unité structurelle L=X, où ce qui suit s'applique aux symboles qui sont utilisés :
L est pour chaque occurrence, de manière identique ou différente, (R¹)(R²)C, (R¹)P, (R¹)As, (R¹)Sb, (R¹)Bi, (R¹)(R²)(R³)P, (R¹)(R²)(R³)As, (R¹)(R²)(R³)Sb, (R¹)(R²)(R³)Bi, (R¹)(R²)S, (R¹)(R²)Se, (R¹)(R²)Te, (R¹)(R²)S(=O), (R¹)(R²)Se(=O) ou (R¹)(R²)Te(=O) ;
X est pour chaque occurrence, de manière identique ou différente, O, S, Se ou N-R⁴, étant entendu que X n'est ni S, ni Se si L représente S, Se ou Te ;
R¹, R², R³ sont pour chaque occurrence, de manière identique ou différente, H, F, CN, N(R⁴)₂, un groupe alkyle, alcoxy ou thioalcoxy en chaîne droite, ramifié ou cyclique qui comporte de 1 à 40 atome(s) de C, lequel peut être substitué par R⁵ ou également non substitué, où un ou plusieurs groupe(s) CH2 non adjacents peut/peuvent être remplacé(s) par -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- ou -CONR⁶- et où un ou plusieurs atome(s) de H peut/peuvent être remplacé(s) par F, Cl, Br, I, CN ou NO₂, ou un système de cycle aromatique ou hétéroaromatique qui comporte de 1 à 40 atome(s) de C, lequel peut être substitué par un radical ou par plusieurs radicaux R⁵, où deux substituants R¹, R² et/ou R³ ou plus peuvent également, l'un avec l'autre ou les uns avec les autres, former un système de cycle aliphatique ou aromatique mono- ou polycyclique ; tous les substituants R¹ à R³ sur chaque unité structurelle ne doivent pas ici être H ou F ; les groupes R¹ à R³ peuvent en outre, en option, comporter des liaisons sur le polymère ;
R⁴ est pour chaque occurrence, de manière identique ou différente, une chaîne alkyle ou alcoxy en chaîne droite, ramifiée ou cyclique qui comporte de 1 à 22 atome(s) de C, où, en outre, un ou plusieurs atome(s) de C non adjacents peut/peuvent être remplacé(s) par -R⁶C=CR⁶, -C≡C-, Si(R⁶)₂, Ge(R⁶)₂, Sn(R⁶)₂, -NR⁶-, -O-, -S-, -CO-O-, -O-CO-O-, où, en outre, un ou plusieurs atome(s) de H peut/peuvent être remplacé(s) par fluor, un groupe aryle, hétéroaryle ou aryloxy qui comporte de 1 à 40 atome(s) de C, lequel peut également être substitué par un radical ou par plusieurs radicaux R⁶, ou OH ou N(R⁵)₂;
R⁵ est pour chaque occurrence, de manière identique ou différente, R⁴ ou CN, B(R⁶)₂ ou Si(R⁶)₃ ;
R⁶ est pour chaque occurrence, de manière identique ou différente, H ou un radical hydrocarbone aliphatique ou aromatique qui comporte de 1 à 20 atome(s) de C ;
et
(C) au moins un émetteur de triplets, lequel contient un métal Ir ;
étant entendu que des mélanges de deux polymères au niveau desquels le premier polymère contient des émetteurs de triplets liés de façon covalente et l'autre polymère est un copolymère qui contient des unités TPD et des unités d'éther de diphénylsulfone ou d'éther de diphénylcétone sont exclus ; et en outre, étant entendu que des polymères qui contiennent d'une part des émetteurs de triplets liés de façon covalente et d'autre part des unités de la formule (a) sont exclus de l'invention : 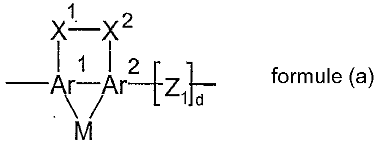
dans laquelle Ar¹ et Ar², chacun de manière indépendante, représentent un groupe hydrocarbone aromatique tétravalent ou un groupe hétérocyclique tétravalent ;
l'une des unités X¹ et X² représente C(=O) ou C(R¹)(R²) et l'autre unité représente O, S, C(=O), S(=O), SO₂, Si(R³)(R⁴), N(R⁵), B(R⁶), P(R⁷) ou P(=O)(R⁸) ;
où les radicaux R¹, R², R³, R⁴, R⁵, R⁶, R⁷ et R⁸ dans la formule (a) représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano,
M représente un groupe qui est représenté par la formule (b), la formule (c) ou la formule (d) :
-Y¹-Y²- formule (b)
dans laquelle Y¹ et Y² représentent, chacun de manière indépendante, O, S, C(=O), S(=O), SO₂, C(R⁹)(R¹⁰), Si(R¹¹)(R¹²), N(R¹³), B(R¹⁴), P(R¹⁵) ou P(=O)(R¹⁶) ;
où les radicaux R⁹, R¹⁰, R¹¹, R¹², R¹³, R¹⁴, R¹⁵ et R¹⁶ dans la formule (b) représentent, chacun de manière indépendante, un atome d'hydrogène, un atome d'halogène, groupe alkyle, un groupe alcoxy, un groupe alkylthio group, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe, silylamino substitué, un groupe hétérocyclique monovalent, un groupe arylalkényle, un groupe aryléthynyle ou un groupe cyano,
où Y¹ et Y² ne sont pas identiques si Y¹ n'est ni C(R⁹)(R¹⁰), ni Si(R¹¹)(R¹²);
-Y³=Y⁴- formule (c)
dans laquelle Y³ et Y⁴ représentent, chacun de manière indépendante, N, B, P, C(R¹⁷) ou Si(R¹⁸) ;
les radicaux R¹⁷ et R¹⁸ dans la formule (c) représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;
-Y⁵- formule (d)
dans laquelle Y⁵ représente O, S, C(=O), S(=O), SO₂, C(R¹⁹)(R²⁰), Si(R²¹)(R²²), N(R²³), B(R²⁴), P(R²⁵) ou P(=O)(R²⁶);
où les radicaux R¹⁹, R²⁰, R²¹, R²², R²³, R²⁴, R²⁵ et R²⁶ dans la formule (d) représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;
Z₁ représente -CR³⁶=CR³⁷- ou -C≡C-; R³⁶ et R³⁷ représentent, chacun de manière indépendante, un atome d'hydrogène, un groupe alkyle, un groupe aryle, un groupe hétérocyclique monovalent ou un groupe cyano ;
d représente 0 ou 1.

2. Semiconducteurs organiques selon la revendication 1, **caractérisés en ce que** les unités structurelles L=X sont sélectionnées parmi les formules (1) à (5) : 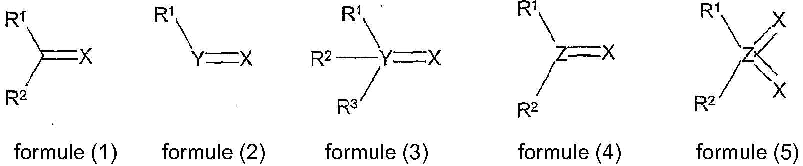 dans lesquelles les symboles qui sont utilisés présentent la signification qui suit :
X est pour chaque occurrence, de manière identique ou différente, O, S, Se ou N-R⁴, étant entendu que X ne peut être ni S, ni Se pour les formules (4) et (5) ;
Y est pour chaque occurrence, de manière identique ou différente, P, As, Sb ou Bi ;
Z est pour chaque occurrence, de manière identique ou différente, S, Se ou Te ;
R¹ à R⁶ présentent la même signification que celle qui a été décrite sous la revendication 1.

3. Semiconducteurs organiques selon la revendication 1 et/ou la revendication 2, **caractérisés en ce qu'**ils comprennent au moins 0,5 % en poids d'au moins un polymère conjugué, partiellement conjugué ou trans-conjugué, au moins 1 % en poids d'au moins une unité structurelle L=X ou d'une unité structurelle des formules (1) à (5) et au moins 0,1 % en poids d'au moins un émetteur de triplets qui contient un métal Ir.

4. Mélanges (BLEND1) selon une ou plusieurs des revendications 1 à 3, comprenant :
(A) 5 - 99,9 % en poids d'au moins un polymère conjugué, partiellement conjugué ou trans-conjugué (POLY1) qui contient 1 - 100 % (pourcentage molaire) d'une ou de plusieurs unité(s) récurrente(s) (MONO1) qui contient/contiennent au moins une unité structurelle L=X ou au moins une unité structurelle des formules (1) à (5) ;
et
(B) 0,1 - 95 % en poids d'un ou de plusieurs émetteur(s) de triplets qui contient/contiennent un métal Ir (TRIP1).

5. Mélanges (BLEND2) selon une ou plusieurs des revendications 1 à 3, comprenant :
(A) 0 ,5 - 99 % en poids d'au moins un polymère conjugué, partiellement conjugué ou trans-conjugué (POLY2) qui contient 0,5 - 99,5 % (pourcentage molaire) d'un ou de plusieurs émetteur(s) de triplets qui contient/contiennent un métal Ir (TRIP2), lié(s) de façon covalente ;
et
(B) 1 - 99,5 % en poids d'au moins un composé (COMP1) qui contient au moins une unité structurelle L=X ou au moins une unité structurelle des formules (1) à (5) et qui dispose de la capacité de former des couches similaires à du verre à température ambiante.

6. Mélanges (BLEND3) selon une ou plusieurs des revendications 1 à 3, comprenant :
(A) 0,5 - 98,9 % en poids d'un polymère conjugué, partiellement conjugué ou trans-conjugué (POLY3) ;
et
(B) 1 - 99 % en poids d'au moins un composé (COMP1) qui contient au moins une unité structurelle L=X ou au moins une unité structurelle des formules (1) à (5) et qui dispose de la capacité de former des couches similaires à du verre à température ambiante ;
et
(C) 0,1 - 95 % en poids d'un ou de plusieurs émetteur(s) de triplets qui contient/contiennent un métal Ir (TRIP1).

7. Mélanges (BLEND4) selon une ou plusieurs des revendications 1 à 3, comprenant :
(A) 0,5 - 99 % en poids d'au moins un polymère conjugué, partiellement conjugué ou trans-conjugué (POLY3) ;
et
(B) 1 - 99,5 % en poids d'un composé (TRIP3) qui contient au moins une unité structurelle L=X ou au moins une unité structurelle des formules (1) à (5), liée de façon covalente sur un ou plusieurs émetteur(s) de triplets qui contient/contiennent un métal Ir, où la liaison entre l'émetteur de triplets et l'unité structurelle L=X peut être réalisée au niveau de n'importe quelles positions souhaitées des deux unités, moyennant la restriction consistant en ce qu'au moins un groupe X dans (TRIP3) doit être selon une forme libre et ne doit pas être coordonné à un atome de métal.

8. Polymères conjugués, partiellement conjugués ou trans-conjugués POLY4 qui contiennent :
(A) 1 - 99,9 % (pourcentage molaire) d'une ou de plusieurs unité(s) récurrente(s) MONO1 qui contient/contiennent au moins une unité structurelle L=X, où les symboles L, X, R¹, R², R³, R⁴, R⁵ et R⁶ présentent la même signification que celle qui a été décrite sous la revendication 1 ;
(B) 0,1 - 95 % (pourcentage molaire) d'un ou de plusieurs émetteur(s) de triplets qui contient/contiennent un métal Ir TRIP2.

9. Semiconducteurs organiques selon une ou plusieurs des revendications 1 à 8, **caractérisés en ce que** les polymères POLY1 à POLY4 contiennent d'autres éléments structurels.

10. Semiconducteurs organiques selon une ou plusieurs des revendications 1 à 9, **caractérisés en ce que** ce qui suit s'applique aux symboles des formules (1) à (5) :
X représente O, S ou N-R⁴ ;
Y représente P ou As ;
Z représente S ou Se ;
R¹ - R⁶ sont définis selon les revendications 1 et 2, où au moins l'un des substituants R¹ à R³ sur chaque unité structurelle des formules (1) à (5) représente un système de cycle aromatique ou hétéroaromatique qui comporte de 1 à 40 atome(s) de C, lequel peut être substitué par un substituant ou par plusieurs substituants R⁴ ou peut être non substitué.

11. Semiconducteurs organiques selon la revendication 10, **caractérisés en ce que** ce qui suit s'applique aux symboles des formules (1) à (5) :
X représente O ou N-R⁴ ;
Y représente P ;
Z représente S ;
R¹ - R⁶ sont définis selon les revendications 1 et 2, où tous les substituants R¹ à R³ sur chaque unité structurelle des formules (1) à (5) représentent un système de cycle aromatique ou hétéroaromatique qui comporte de 1 à 40 atome(s) de C, lequel peut être substitué par un substituant ou par plusieurs substituant R⁴ ou peut être non substitué.

12. Semiconducteurs organiques selon une ou plusieurs des revendications 1 à 11, **caractérisés en ce qu'**au moins l'un des radicaux R¹ à R³ contient un 9,9'-spirobifluorène.

13. Semiconducteurs organiques selon une ou plusieurs des revendications 1 à 12, **caractérisés en ce que** les unités récurrentes (MONO1) qui contiennent des éléments structurels L=X ou des éléments structurels des formules (1) à (5) sont sélectionnées parmi les formules (6) à (148) : 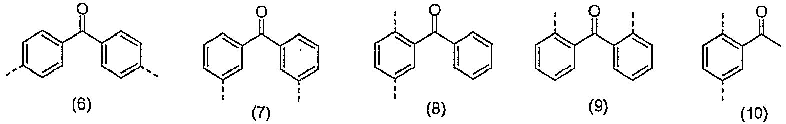 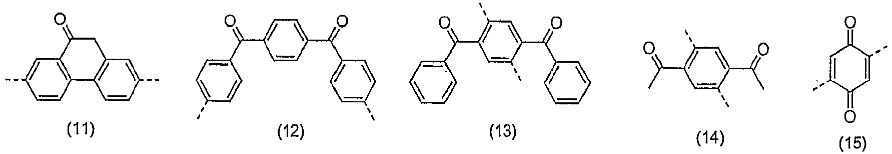 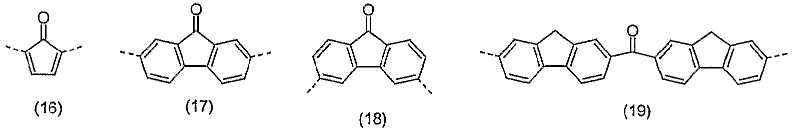 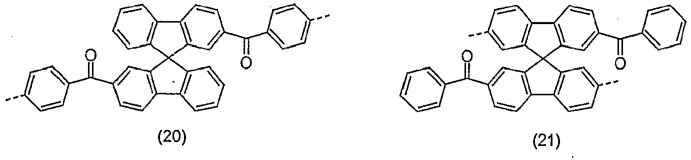 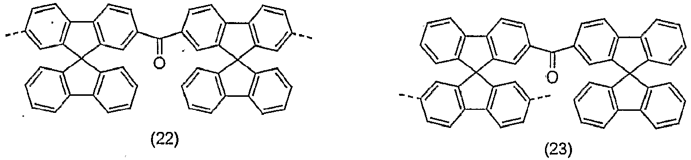 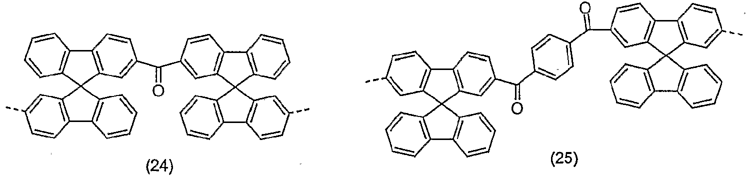 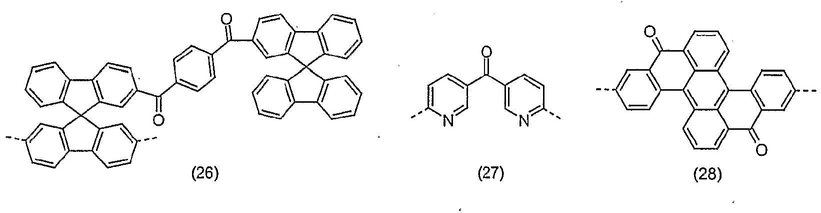 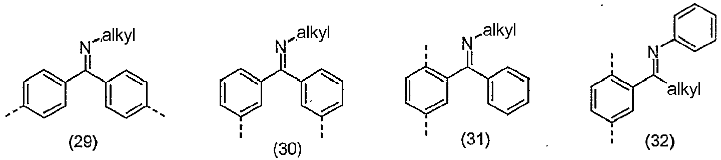 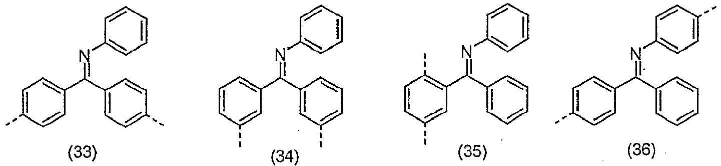 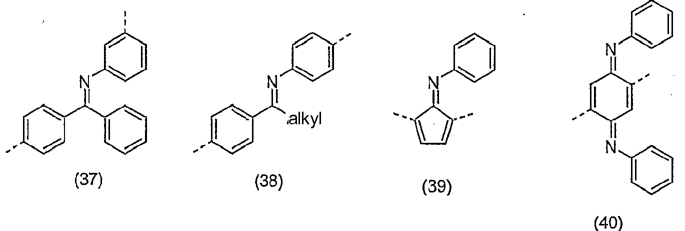 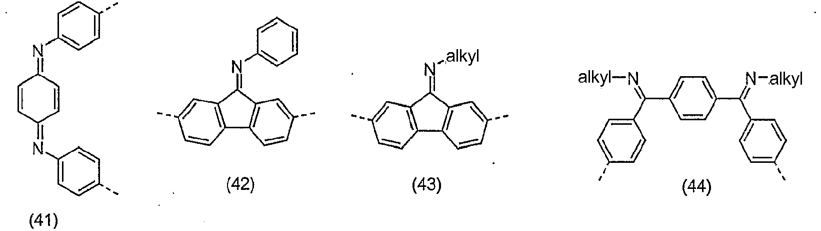 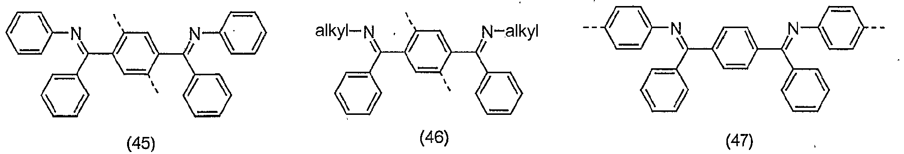 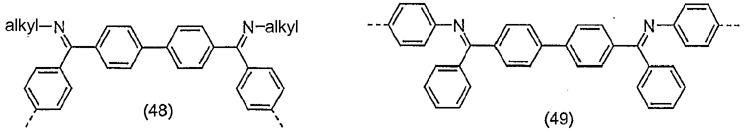 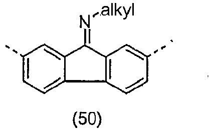 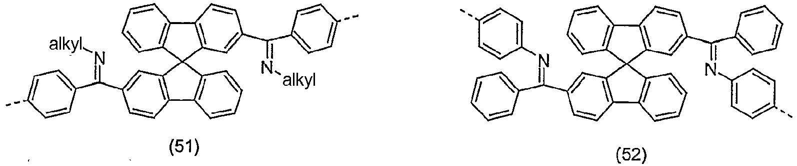 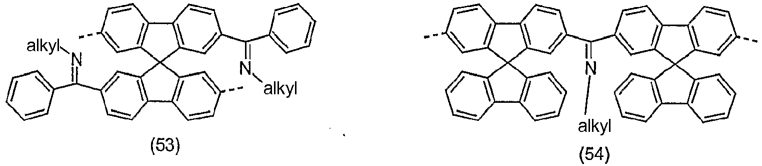 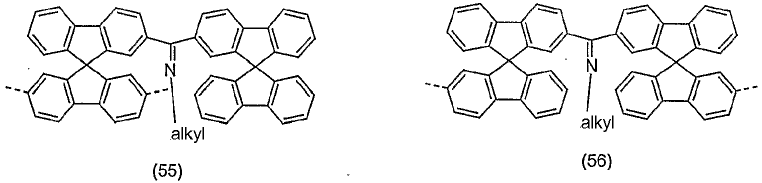 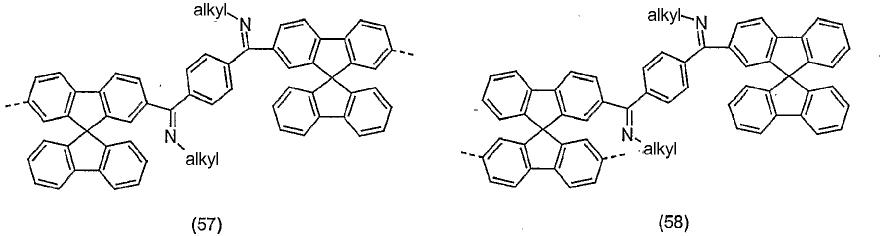 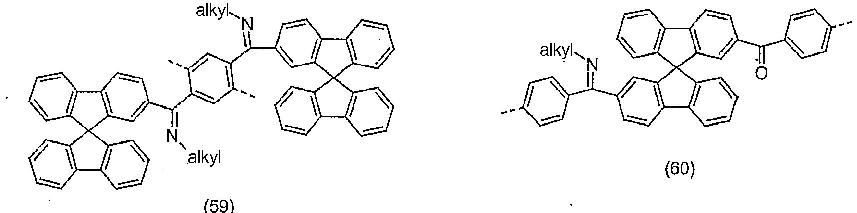 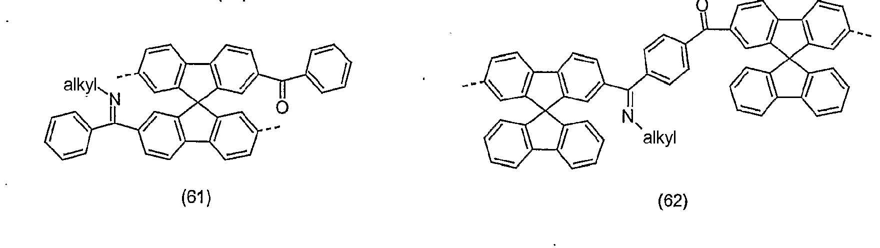 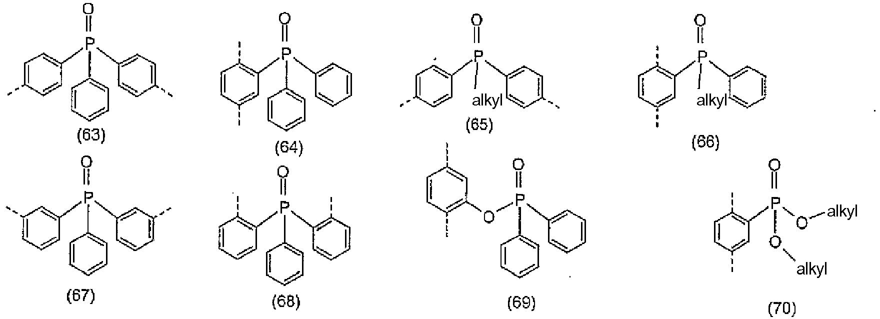 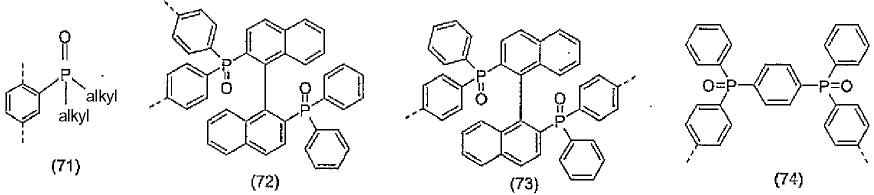 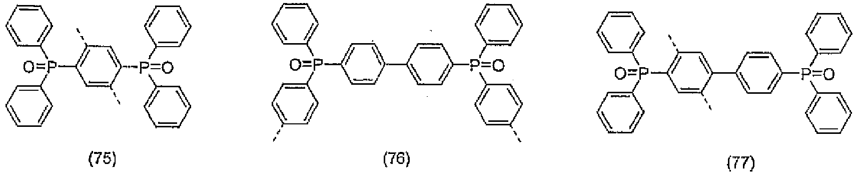 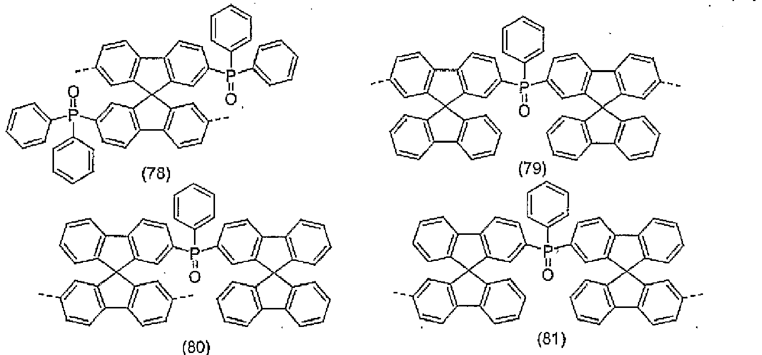 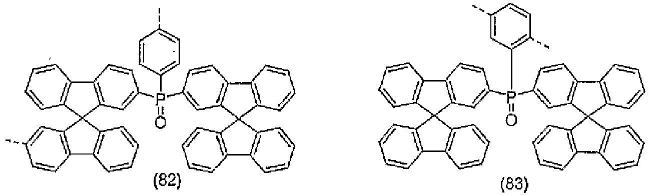 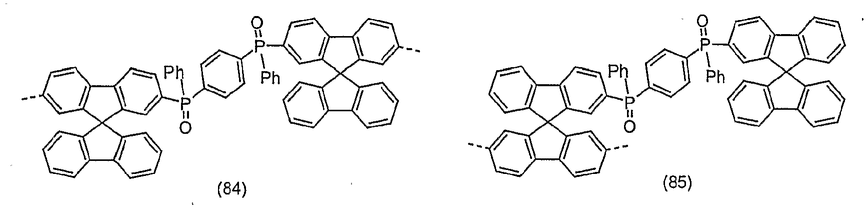 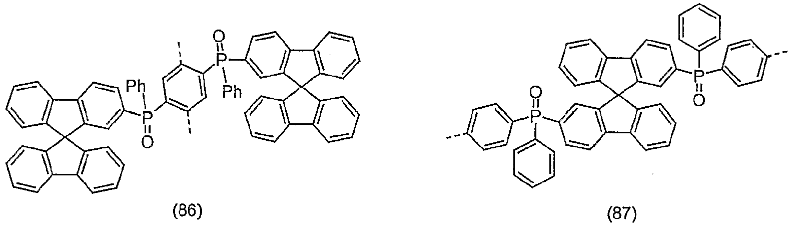 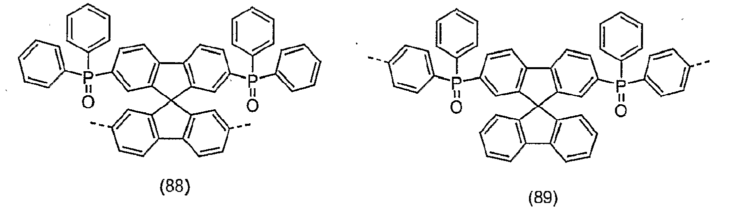 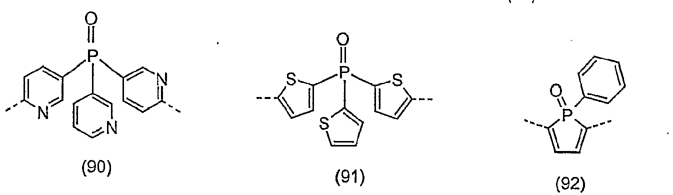 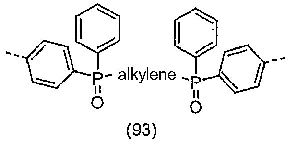 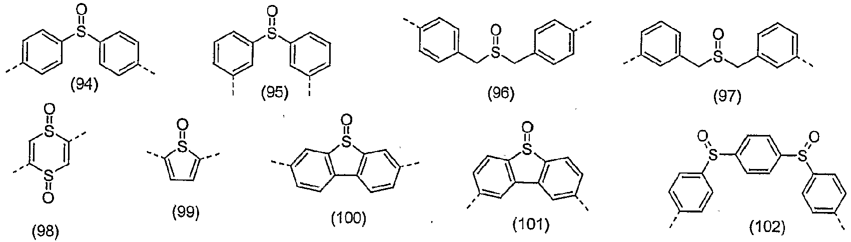 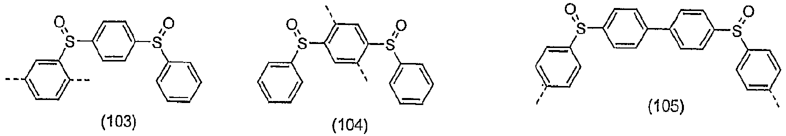 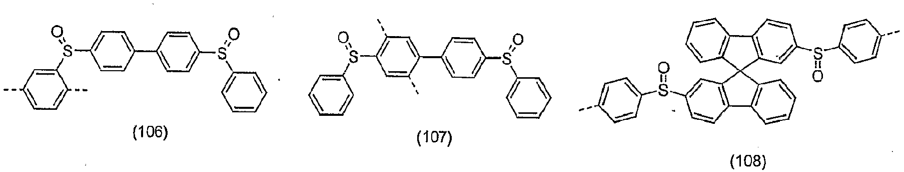 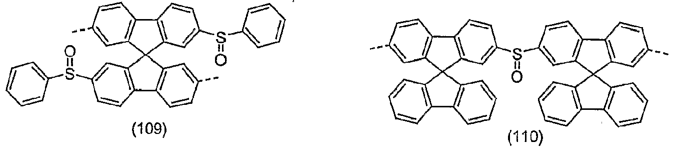 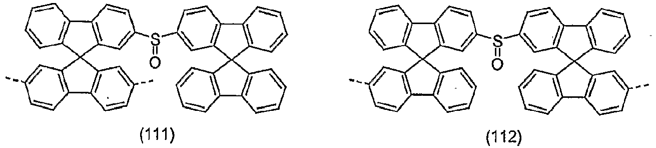 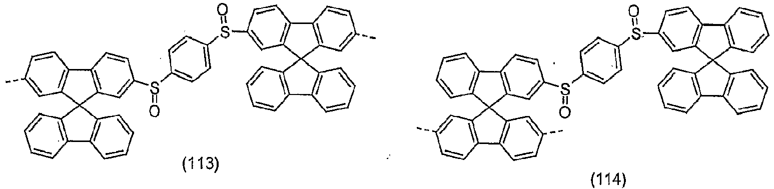 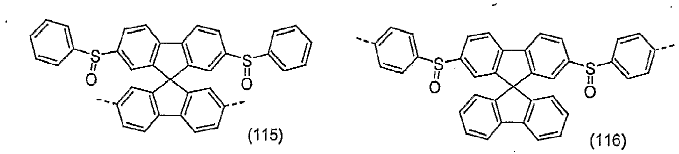 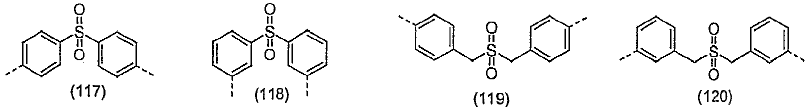 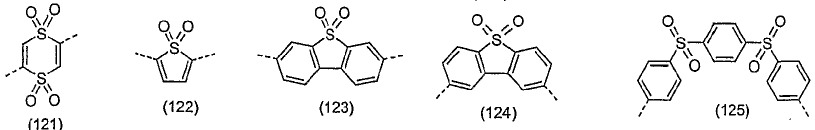 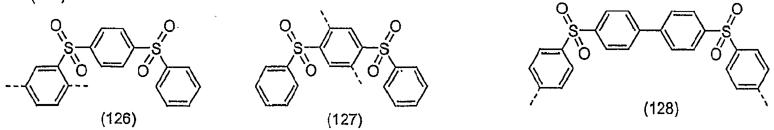 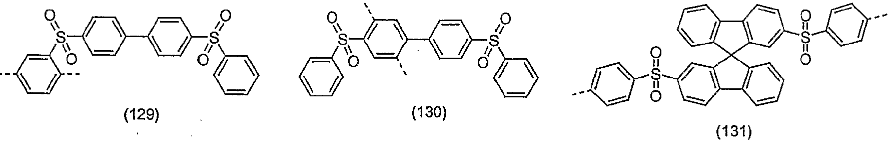 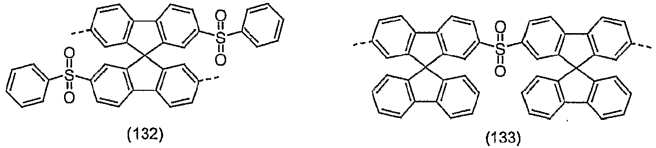 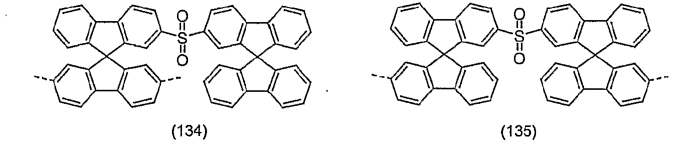 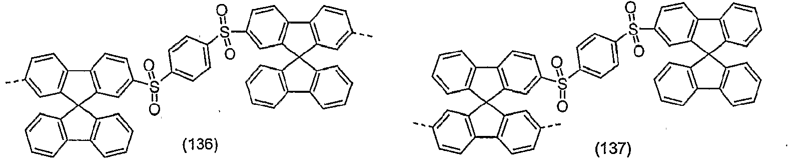 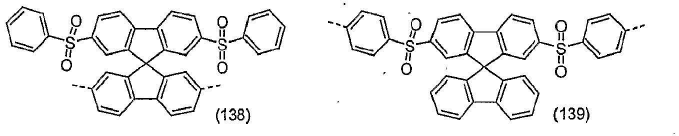 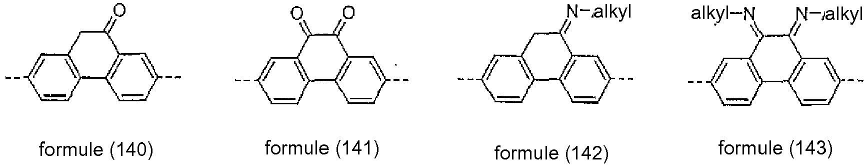 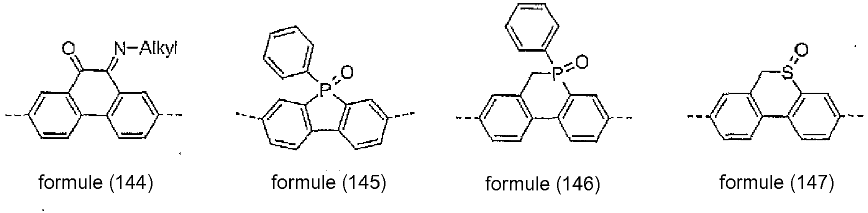 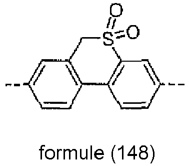 lesquels peuvent être substitués ou non substitués.

14. Semiconducteurs organiques selon une ou plusieurs des revendications 1 à 13, **caractérisés en ce que** les polymères sont sélectionnés parmi les classes qui sont constituées par les polycétones aromatiques, les oxydes de polyphosphine aromatiques ou les polysulfones aromatiques, dont chacun peut également être substitué de manière à assurer une meilleure solubilité, les dérivés d'acide polycarboxylique, les polyesters en chaîne principale, les polyesters en chaîne latérale, les poly(acides glycoliques), les poly(acides lactiques), les poly(ε-caprolactones), les polyacrylates, les poly(acides hydroxybenzoïques), les poly(téréphtalates d'alkylène), les anhydrides polycarboxyliques, les polyamides, les poly(ε-caprolactames), les polypeptides, les polyaramides, les polybenzamides, les polyimides, les poly(amide-imides), les poly(ester-imides), les poly(éther-imides), les polycarbonates, les poly(ester-co-carbonates), les poly(isocyanurates), les polyuréthanes, les polyester-polyuréthanes, les poly(téréphtalates), les poly(acrylates), les poly(acrylates de phényle), les poly(cyanoacrylates), les poly(esters de vinyle), les poly(acétates de vinyle), les oxydes de polyphosphine en chaîne latérale, les polyéthercétones (PEK), les polyéthersulfones, les polysulfonamides, les polysulfonimides, les poly(cétones de vinyle), les polyvinylcétones ou polycétones de vinyle aromatiques, les poly(vinylbenzophénones) substitués ou non substitués, les cétones analogues au polystyrène, les polycarbazènes, les polynitriles, les polyisonitriles, le polystyrène, le PVK (polyvinylcarbazole) ou leurs dérivés.

15. Semiconducteurs organiques selon une ou plusieurs des revendications 1 à 12, **caractérisés en ce que** le composé (COMP1) qui contient des éléments structurels L=X ou des éléments structurels des formules (1) à (5) est sélectionné parmi les formules (6) à (148) : 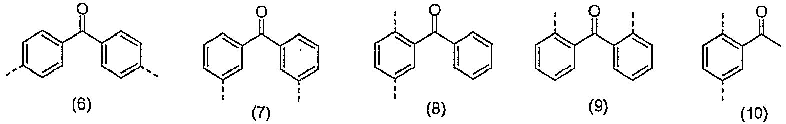 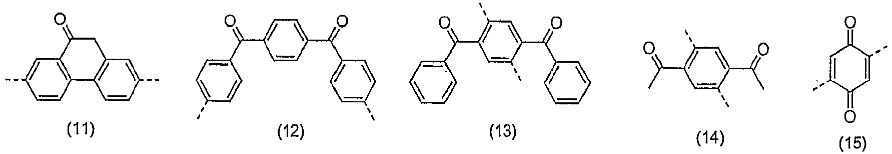 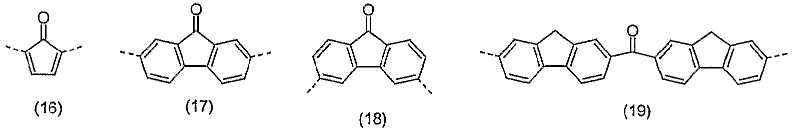 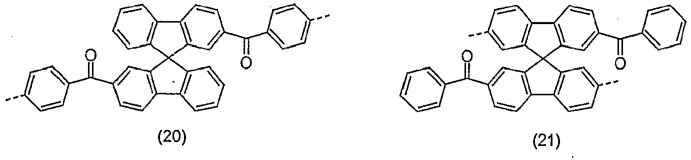 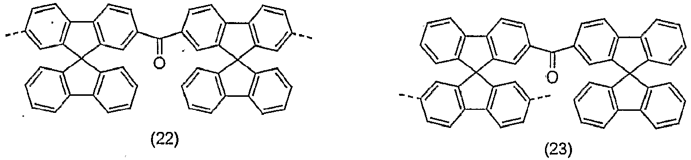 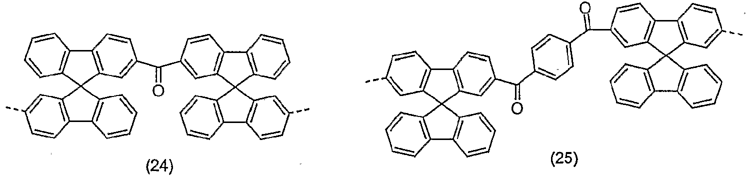 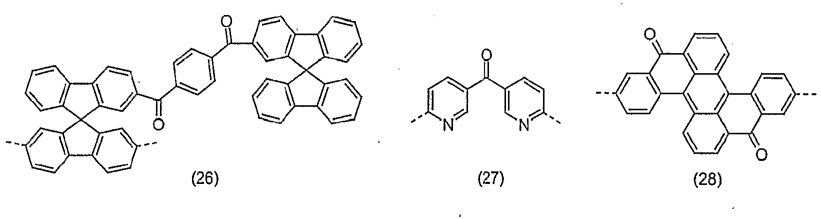 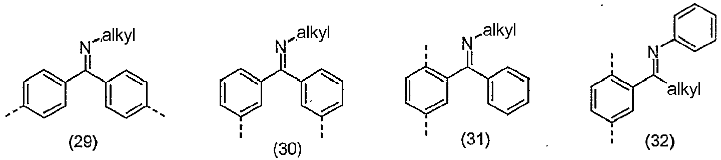 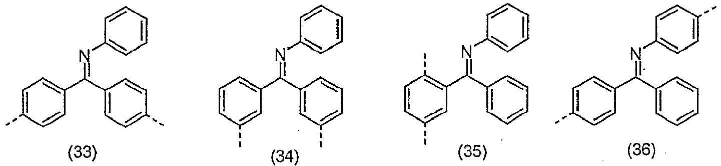 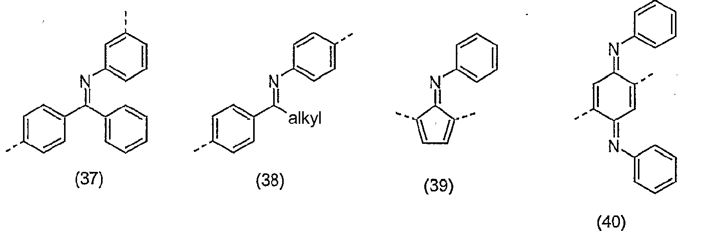 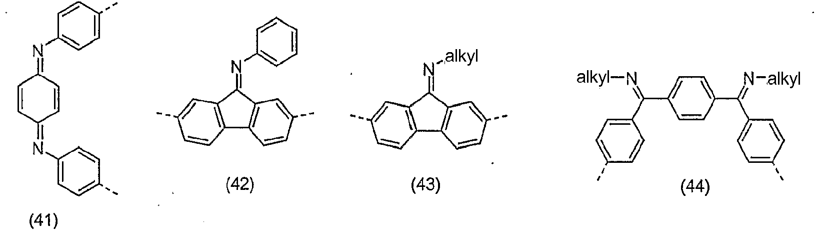 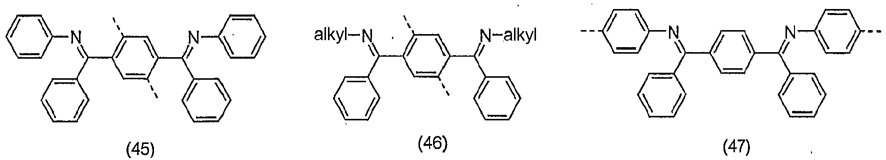 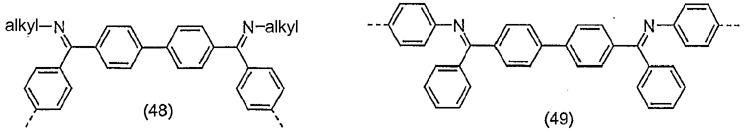 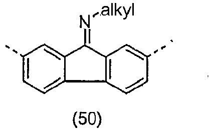 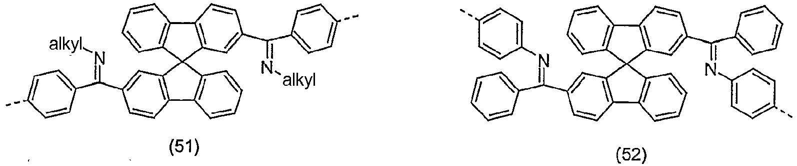 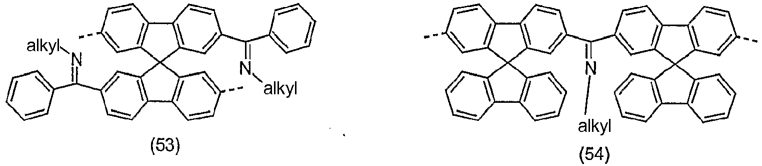 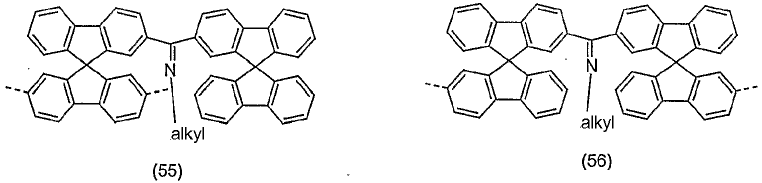 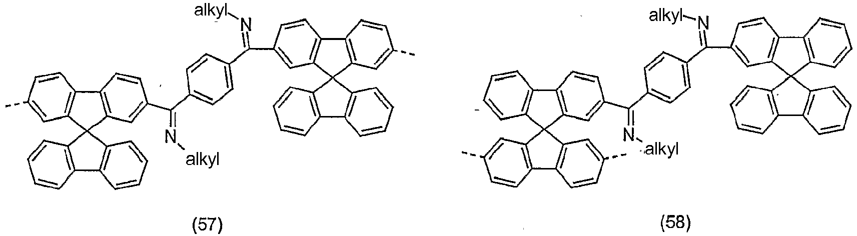 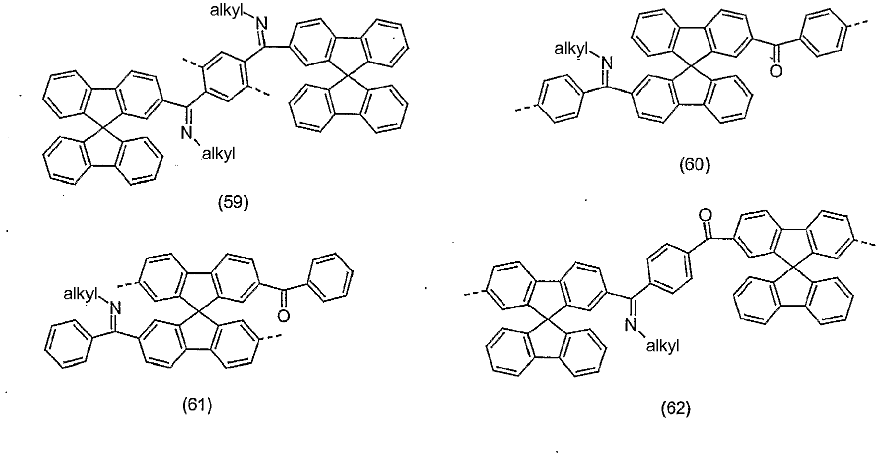 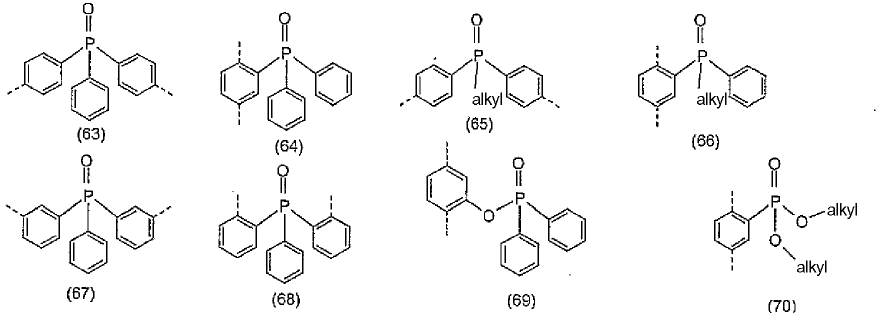 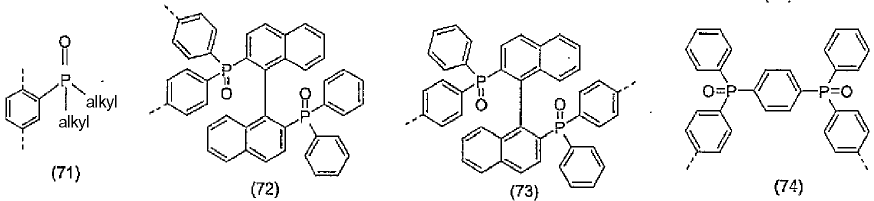 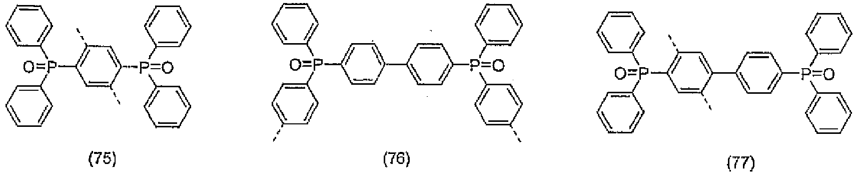 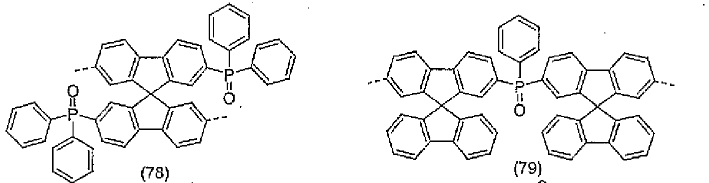 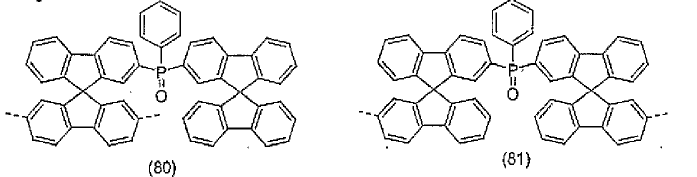 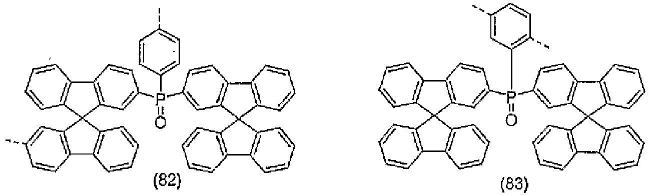 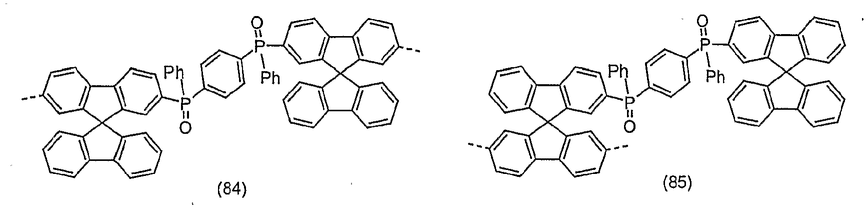 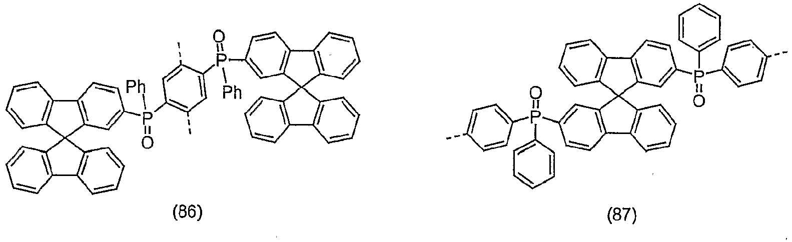 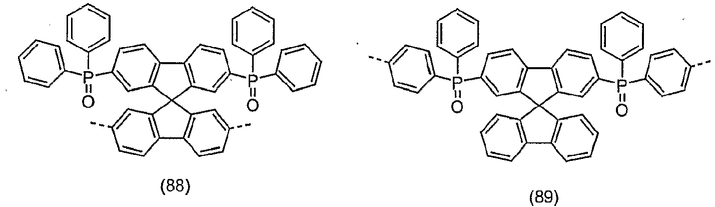 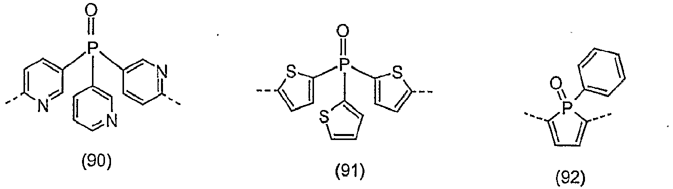 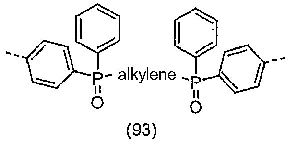 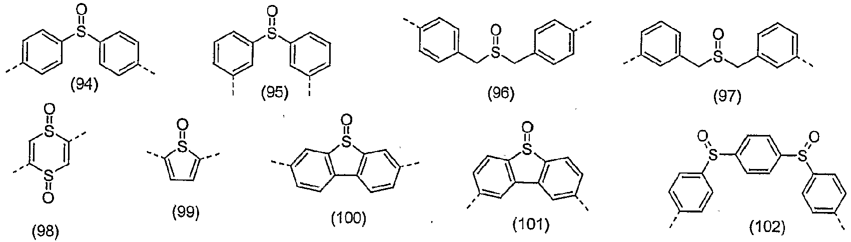 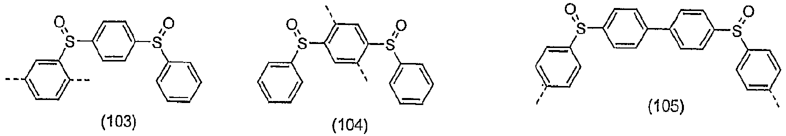 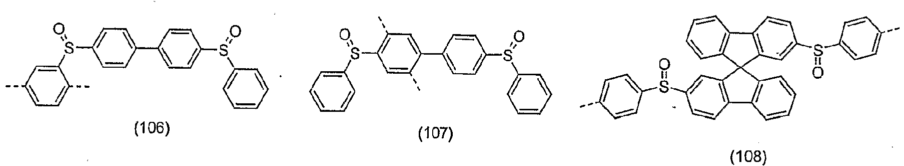 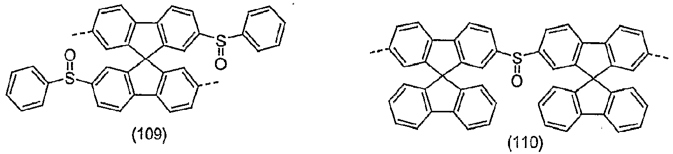 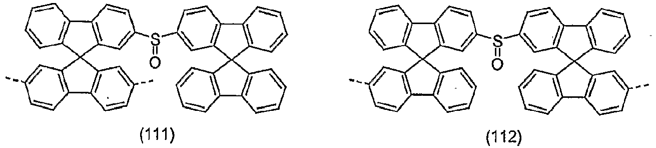 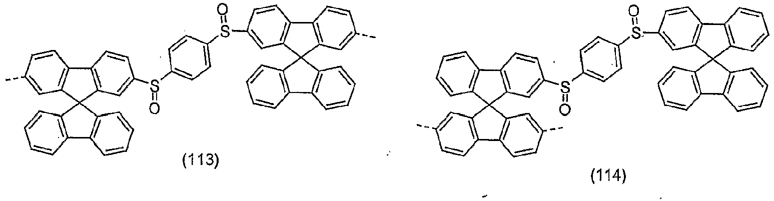 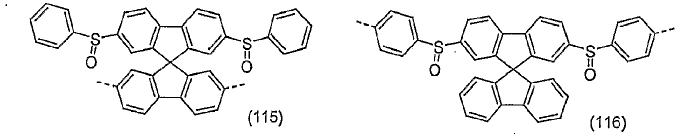 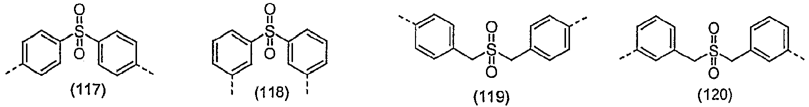 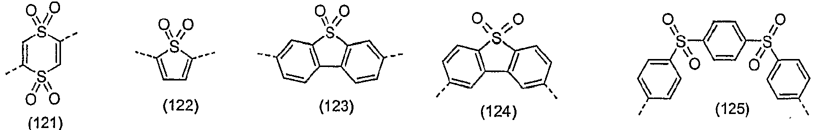 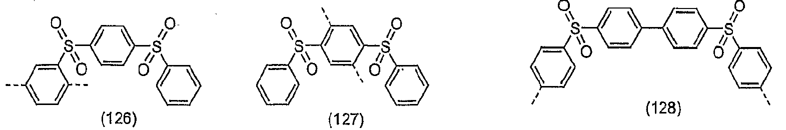 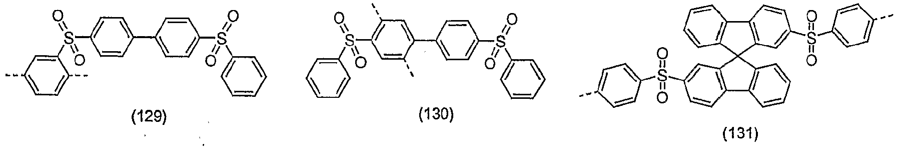 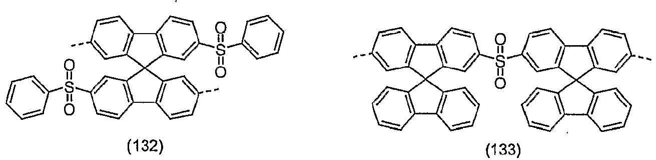 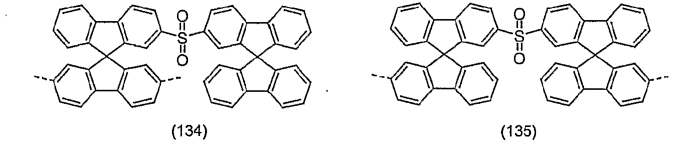 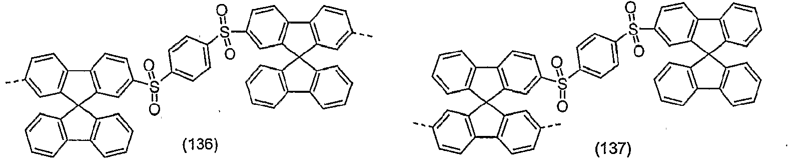 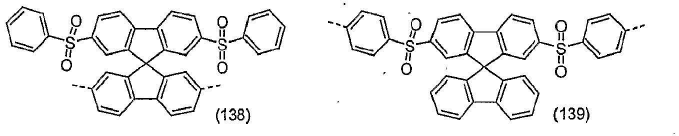 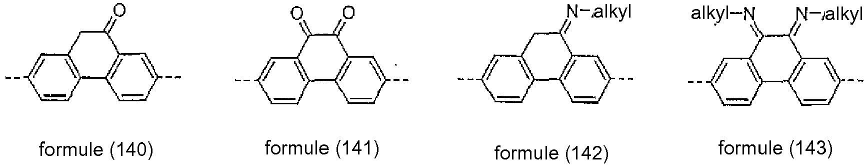 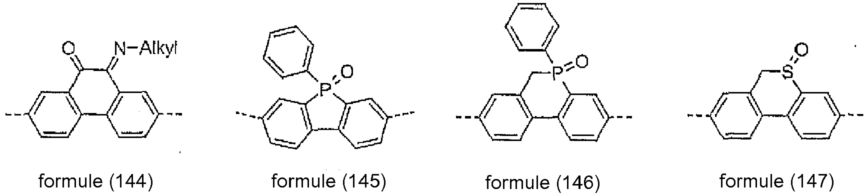 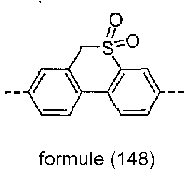 lesquels peuvent être substitués ou non substitués.

16. Semiconducteurs organiques selon une ou plusieurs des revendications 1 à 12, **caractérisés en ce que** le composé (TRIP3) contient des éléments structurels qui sont sélectionnés parmi les formules (6) à (148) : 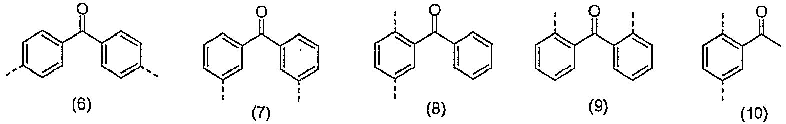 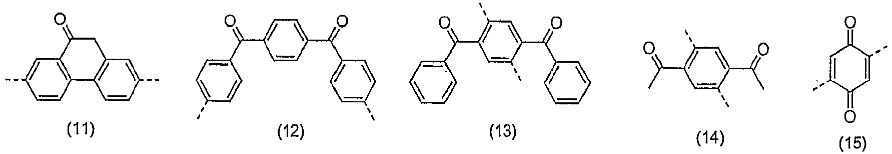 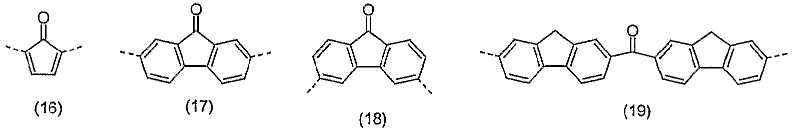 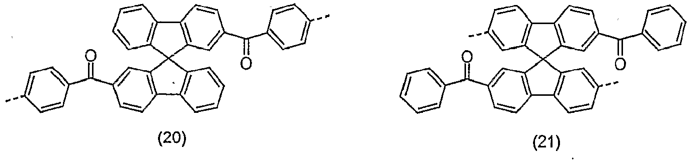 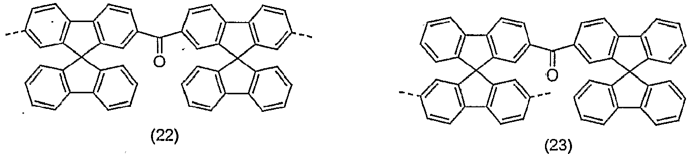 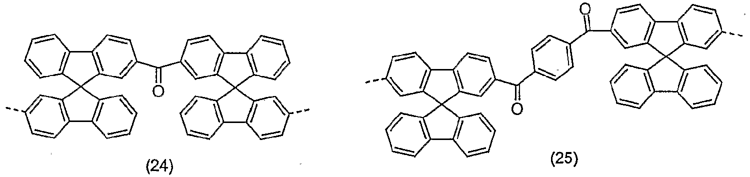 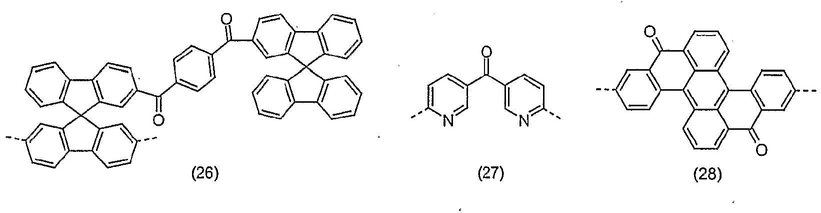 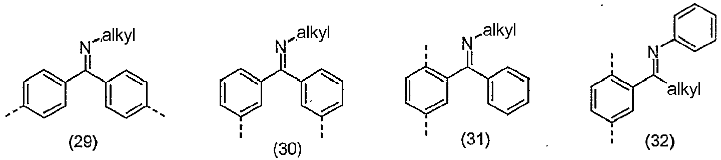 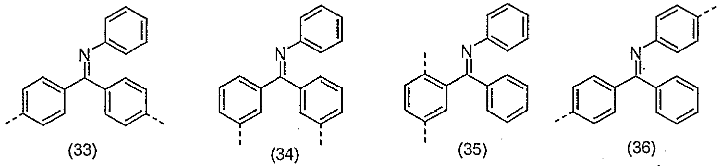 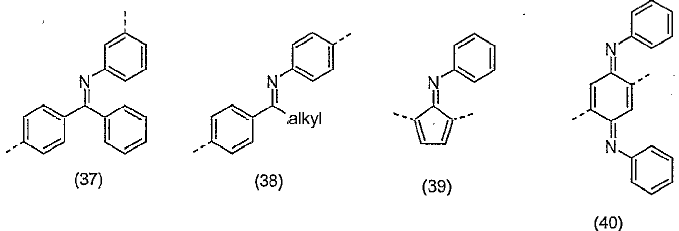 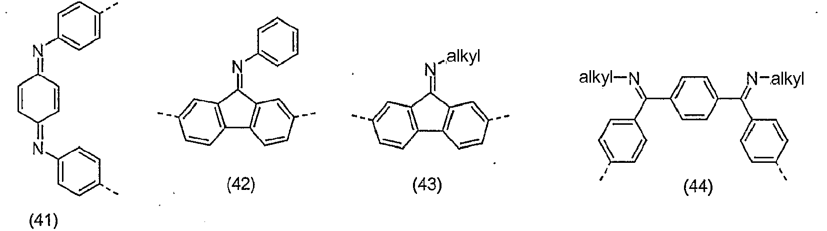 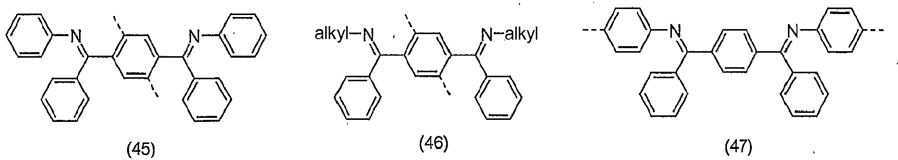 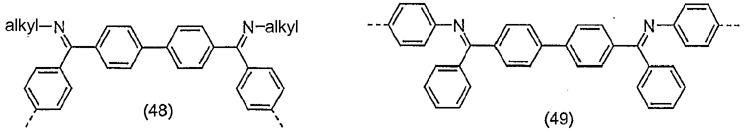 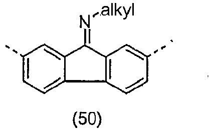 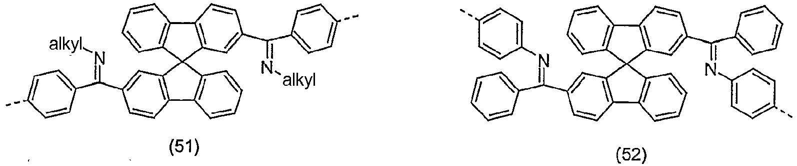 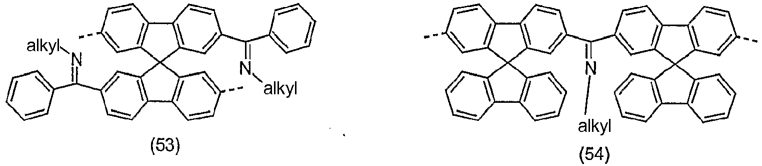 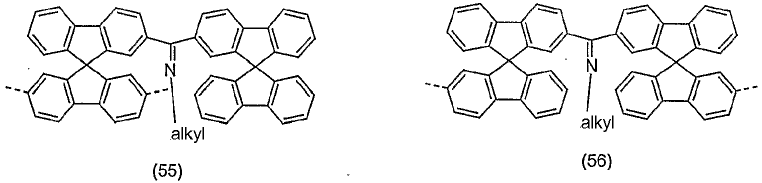 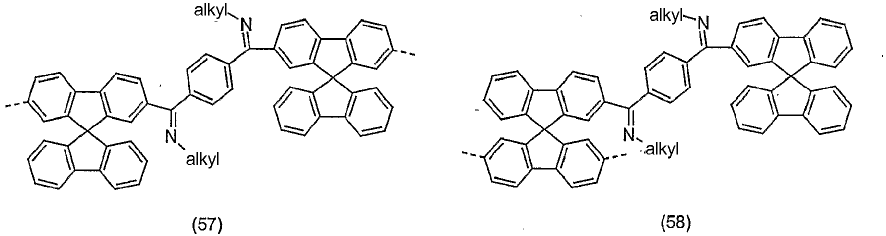 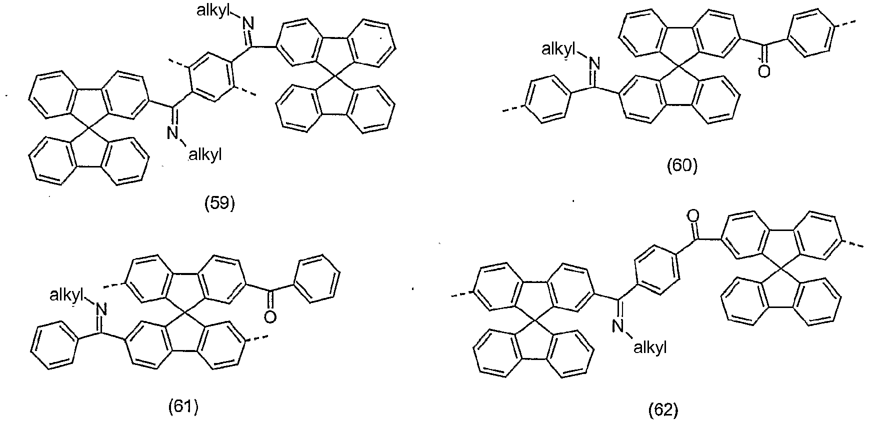 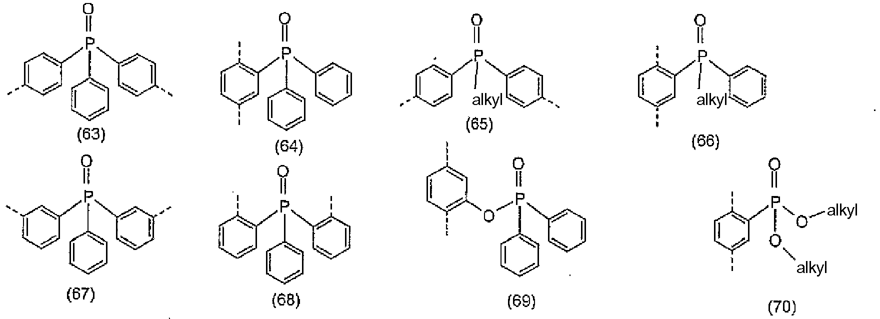 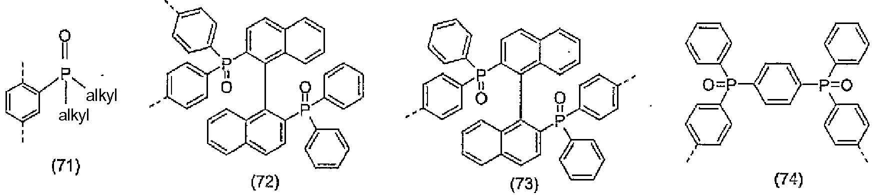 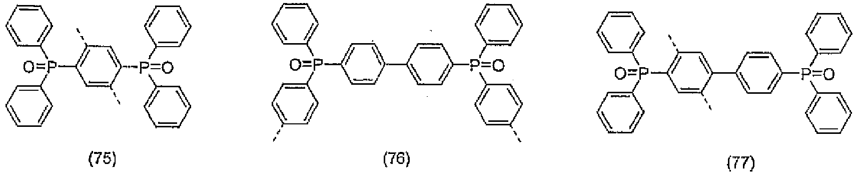 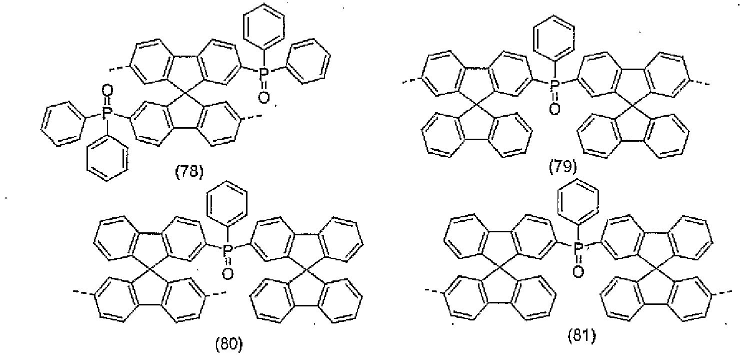 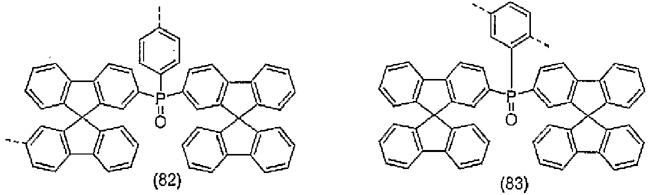 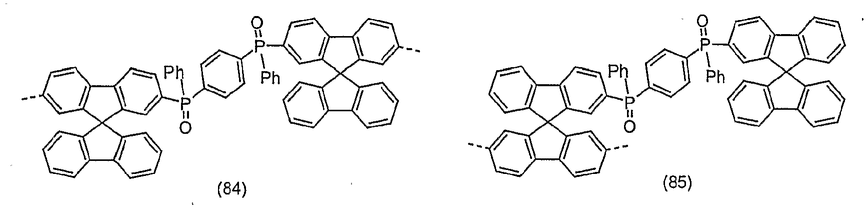 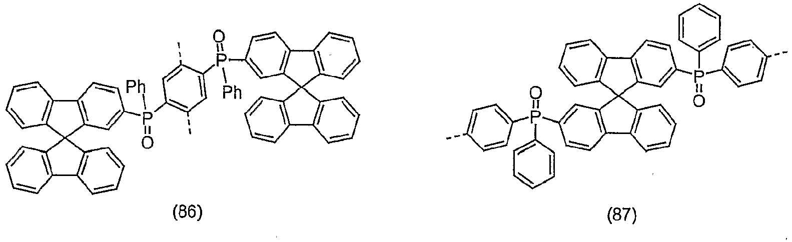 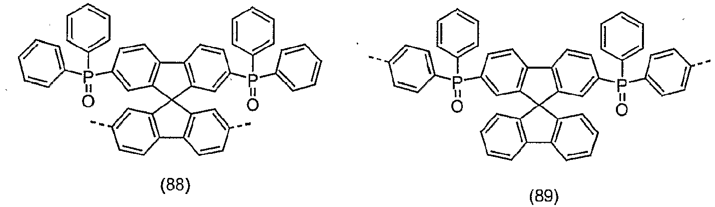 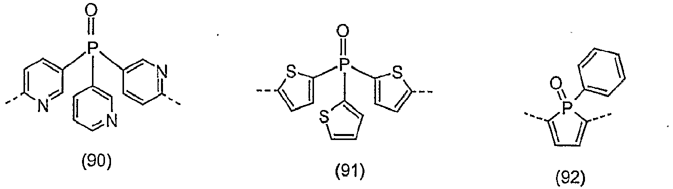 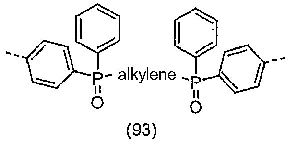 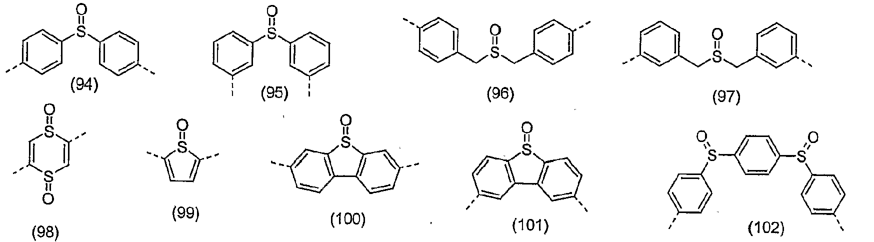 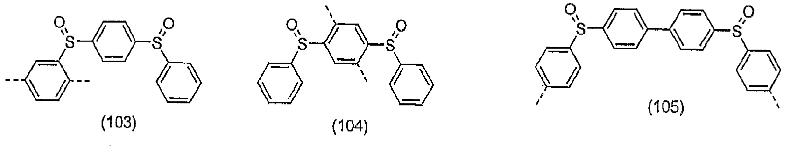 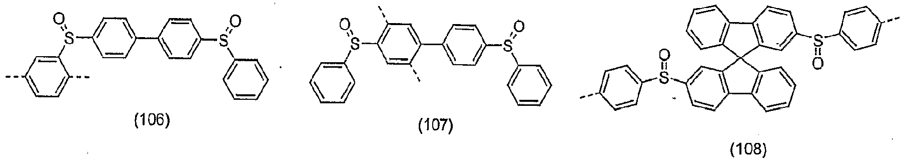 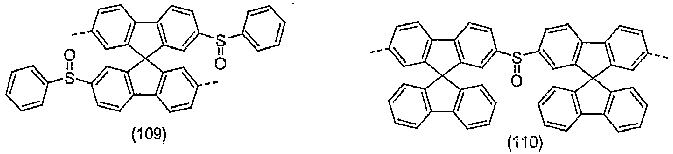 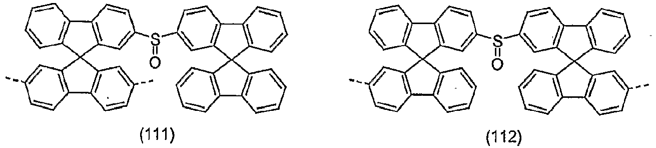 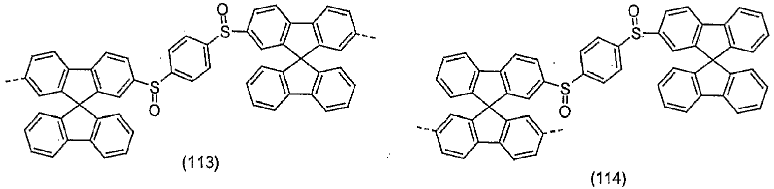 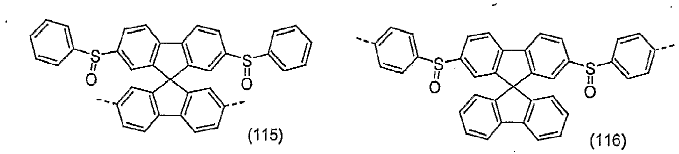 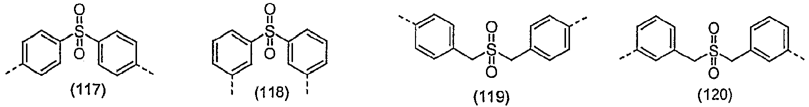 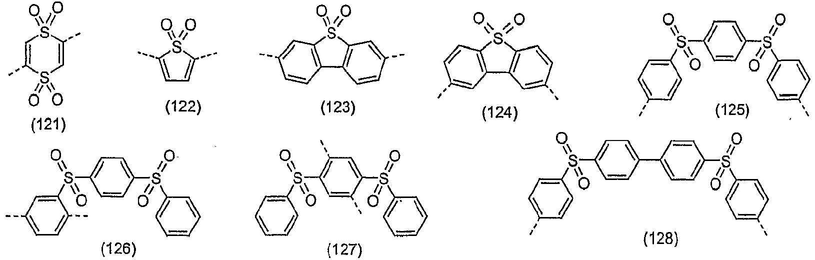 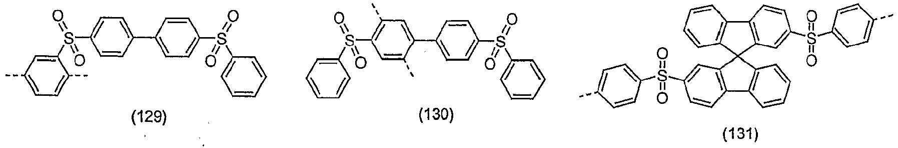 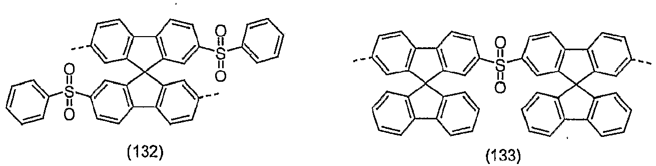 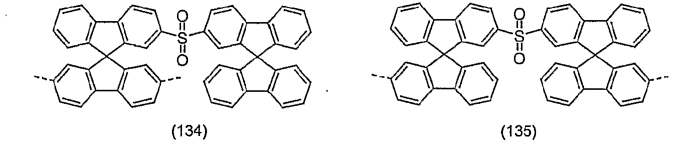 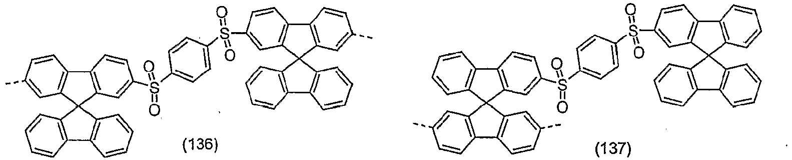 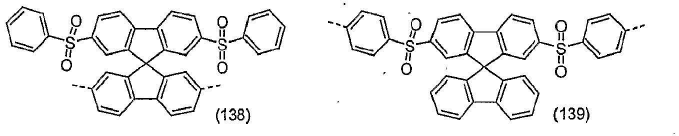 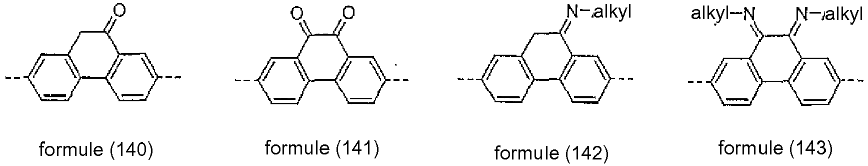 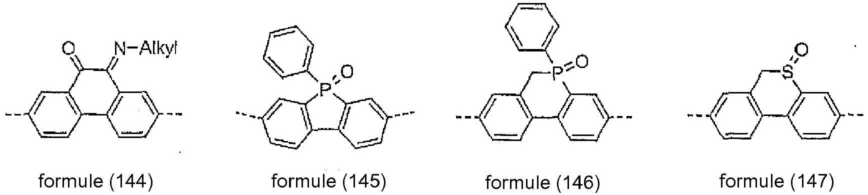 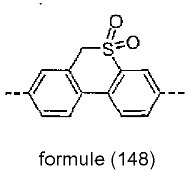 lesquels peuvent être substitués ou non substitués.

17. Semiconducteurs organiques selon une ou plusieurs des revendications 1 à 16, **caractérisés en ce que** d'autres molécules, qui peuvent être de poids moléculaire faible, oligomériques, dendritiques ou polymériques, sont également ajoutées aux semiconducteurs organiques.

18. Semiconducteurs organiques selon la revendication 17, **caractérisés en ce que** des composés qui contiennent des unités structurelles L=X ou des unités structurelles des formules (1) à (5) sont ajoutés de façon additionnelle au mélange.

19. Semiconducteurs organiques selon une ou plusieurs des revendications 1 à 18, **caractérisés en ce que** la proportion totale d'unités structurelles des formules (1) à (5) est de 10 - 50 % (pourcentage molaire).

20. Utilisation d'un semiconducteur organique selon une ou plusieurs des revendications 1 à 19 dans des diodes à émission de lumière/ électroluminescentes organiques (PLED), des cellules solaires organiques (O-SC), des diodes laser organiques (O-laser) ou dans des optiques non linéaires.

21. Composant électronique qui comprend une ou plusieurs couche(s) active(s), dans lequel au moins l'une de ces couches actives comprend un ou plusieurs semiconducteur(s) organique(s) selon une ou plusieurs des revendications 1 à 19.

22. Composant électronique selon la revendication 21, **caractérisé en ce qu'**il s'agit d'une diode à émission de lumière/électroluminescente organique, d'une cellule solaire organique ou d'une diode laser organique.
